(19) Europäisches Patentamt
European Patent Office
Office européen des brevets

(11) **EP 3 954 072 B1**

(12) **EUROPEAN PATENT SPECIFICATION**

(45) Date of publication and mention
of the grant of the patent:
**22.05.2024 Bulletin 2024/21**

(21) Application number: **20805517.8**

(22) Date of filing: **11.05.2020**

(51) International Patent Classification (IPC):
*H04L 1/00* (2006.01)      *H04L 1/18* (2023.01)

(52) Cooperative Patent Classification (CPC):
**H04B 7/024; H03M 13/116; H03M 13/1188;**
**H03M 13/618; H03M 13/6393; H04L 1/0003;**
**H04L 1/0041; H04L 1/0069; H04L 1/1822;**
**H04L 1/189;** H04L 5/0035; H04L 5/0091;
H04L 27/26025

(86) International application number:
**PCT/KR2020/006164**

(87) International publication number:
**WO 2020/231124 (19.11.2020 Gazette 2020/47)**

(54) **METHOD AND APPARATUS FOR DATA TRANSMISSION IN WIRELESS COMMUNICATION SYSTEM**

VERFAHREN UND VORRICHTUNGEN ZUR DATENÜBERTRAGUNG IN EINEM DRAHTLOSKOMMUNIKATIONSSYSTEM

PROCÉDÉ ET APPAREIL DE TRANSMISSION DE DONNÉES DANS UN SYSTÈME DE COMMUNICATION SANS FIL

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **10.05.2019 KR 20190055247**
**26.09.2019 KR 20190119033**
**08.11.2019 KR 20190142641**

(43) Date of publication of application:
**16.02.2022 Bulletin 2022/07**

(73) Proprietor: **Samsung Electronics Co., Ltd.**
**Suwon-si, Gyeonggi-do 16677 (KR)**

(72) Inventors:
• **PARK, Jinhyun**
**Suwon-si, Gyeonggi-do 16677 (KR)**
• **NOH, Hoondong**
**Suwon-si, Gyeonggi-do 16677 (KR)**
• **MYUNG, Seho**
**Suwon-si, Gyeonggi-do 16677 (KR)**

(74) Representative: **Nederlandsch Octrooibureau**
**P.O. Box 29720**
**2502 LS The Hague (NL)**

(56) References cited:
WO-A1-2018/062660     WO-A1-2019/029309
WO-A1-2020/068956     US-A1- 2019 013 901

• **HUAWEI ET AL: "Enhancements on Multi-TRP/panel transmission", 3GPP DRAFT; R1-1905523 ENHANCEMENTS ON MULTI-TRPPANEL TRANSMISSION_FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX , vol. RAN WG1, no. Xi'an, China; 20190408 - 20190412 3 April 2019 (2019-04-03), XP051707587, Retrieved from the Internet: URL:http://www.3gpp.org/ftp/tsg%5Fran/WG1% 5FRL1/TSGR1%5F96b/Docs/R1%2D1905523%2 Ezip [retrieved on 2019-04-03]**

- MEDIATEK INC: "Multi-TRP and Multi-panel transmission", 3GPP DRAFT; R1-1707837 MULTI-TRP FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Hangzhou, China; 20170515 - 20170519 14 May 2017 (2017-05-14), XP051273038, Retrieved from the Internet: URL:http://www.3gpp.org/ftp/Meetings_3GPP_SYNC/RAN1/Docs/ [retrieved on 2017-05-14]
- QUALCOMM INCORPORATED: "Multi-TRP Enhancements", 3GPP DRAFT; R1-1903043 MULTI-TRP ENHANCEMENTS, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Athens, Greece; 20190225 - 20190301 16 February 2019 (2019-02-16), XP051600739, Retrieved from the Internet: URL:http://www.3gpp.org/ftp/tsg%5Fran/WG1%5FRL1/TSGR1%5F96/Docs/R1%2D1903043%2Ezip [retrieved on 2019-02-16]
- Huawei, HiSilicon: "Enhancements on Multi-TRP/panel transmission", 3GPP Draft; R1-1905523 Enhancements on multi-TRPpanel transmission_final, 3rd Generation Partnership Project (3GPP), Mobile Competence Centre ; 650, route des Lucioles ; F-06921 Sophia-Antipolis Cedex ; France, vol. RAN WG1, no. Xi an, China; 20190408 - 20190412, R1-19055, 3 April 2019 (2019-04-03), XP051707587, Mobile Competence Centre ; 650, route des Lucioles ; F-06921 Sophia-Antipolis Cedex ; France
- Hamidi-Sepehr Fatemeh; Nimbalker Ajit; Ermolaev Gregory: "Analysis of 5G LDPC Codes Rate-Matching Design", 2018 IEEE 87th Vehicular Technology Conference (VTC Spring), IEEE, 3 June 2018 (2018-06-03), pages 1-5, XP033377323, DOI: 10.1109/VTCSpring.2018.8417496

## Description

### Technical Field

The present disclosure relates to a wireless communication system, and more particularly, to a method and apparatus for improving data reception performance in a wireless communication system.

### Background Art

To meet the demand for wireless data traffic having increased since deployment of 4G communication systems, efforts have been made to develop an improved 5G or pre-5G communication system. Therefore, the 5G or pre-5G communication system is also called a "Beyond 4G Network" or a "Post LTE System". The 5G communication system is considered to be implemented in higher frequency (mmWave) bands, e.g., 60GHz bands, so as to accomplish higher data rates. To decrease propagation loss of the radio waves and increase the transmission distance, the beamforming, massive multiple-input multiple-output (MIMO), full dimensional MIMO (FD-MIMO), array antenna, an analog beam forming, large scale antenna techniques are discussed in 5G communication systems. In addition, in 5G communication systems, development for system network improvement is under way based on advanced small cells, cloud radio access networks (RANs), ultra-dense networks, device-to-device (D2D) communication, wireless backhaul, moving network, cooperative communication, coordinated multi-points (CoMP), reception-end interference cancellation and the like. In the 5G system, hybrid FSK and QAM modulation (FQAM) and sliding window superposition coding (SWSC) as an advanced coding modulation (ACM), and filter bank multi carrier (FBMC), non-orthogonal multiple access (NOMA), and sparse code multiple access (SCMA) as an advanced access technology have also been developed.

The Internet, which is a human-centered connectivity network where humans generate and consume information, is now evolving to the Internet of things (IoT), where distributed entities, such as things, exchange and process information without human intervention. The Internet of everything (IoE), which is a combination of the IoT technology and the big data processing technology through connection with a cloud server, has emerged. As technology elements, such as "sensing technology", "wired/wireless communication and network infrastructure", "service interface technology", and "security technology" have been demanded for IoT implementation, a sensor network, a machine-to-machine (M2M) communication, machine type communication (MTC), and so forth have been recently researched. Such an IoT environment may provide intelligent Internet technology services that create a new value to human life by collecting and analyzing data generated among connected things. IoT may be applied to a variety of fields including smart home, smart building, smart city, smart car or connected cars, smart grid, health care, smart appliances and advanced medical services through convergence and combination between existing information technology (IT) and various industrial applications.

In line with this, various attempts have been made to apply 5G communication systems to IoT networks. For example, technologies such as a sensor network, machine type communication (MTC), and machine-to-machine (M2M) communication may be implemented by beamforming, MIMO, and array antennas. Application of a cloud radio access network (RAN) as the above-described big data processing technology may also be considered an example of convergence of the 5G technology with the IoT technology.

The above information is presented as background information only to assist with an understanding of the disclosure. No determination has been made, and no assertion is made, as to whether any of the above might be applicable as prior art with regard to the disclosure.

### Disclosure of Invention

### Technical Problem

Certain embodiments according to this disclosure provide a method and apparatus for repeatedly transmitting the same data in order to improve reception performance in a wireless communication system. Further, certain embodiments according to this disclosure provide, in the situation in which the same data is repeatedly transmitted in a wireless communication system, a method and apparatus for improving reception performance by combining signals corresponding to the same data in a receiver.

Certain embodiments according to this disclosure comprise a method and apparatus for repeatedly transmitting the same data between multiple transmitting nodes and terminals in a wireless communication system. Further, certain embodiments according to this disclosure comprise, in the case where the same data is repeatedly transmitted between multiple transmitting nodes and terminals in a wireless communication system, a method and apparatus for improving reception performance by combining signals corresponding to the same data in a receiver.

**Solution to Problem**

The invention is defined by a transmission method performed by a first transmission and reception point (TRP), a reception method performed by a terminal, a first TRP , and a terminal, in a communication system supporting multiple TRPs according to independent claim 1, 5, 9 and 12. Further embodiments are defined by the dependent claims.

**Advantageous Effects of Invention**

According to certain embodiments of this disclosure, the reliability of reception of data and/or control signals by a terminal in a wireless communication system can be improved.

Before undertaking the DETAILED DESCRIPTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely.

Moreover, various functions described below can be implemented or supported by one or more computer programs, each of which is formed from computer readable program code and embodied in a computer readable medium. The terms "application" and "program" refer to one or more computer programs, software components, sets of instructions, procedures, functions, objects, classes, instances, related data, or a portion thereof adapted for implementation in a suitable computer readable program code. The phrase "computer readable program code" includes any type of computer code, including source code, object code, and executable code. The phrase "computer readable medium" includes any type of medium capable of being accessed by a computer, such as read only memory (ROM), random access memory (RAM), a hard disk drive, a compact disc (CD), a digital video disc (DVD), or any other type of memory. A "non-transitory" computer readable medium excludes wired, wireless, optical, or other communication links that transport transitory electrical or other signals. A non-transitory computer readable medium includes media where data can be permanently stored and media where data can be stored and later overwritten, such as a rewritable optical disc or an erasable memory device.

Definitions for certain words and phrases are provided throughout this patent document, those of ordinary skill in the art should understand that in many, if not most instances, such definitions apply to prior, as well as future uses of such defined words and phrases.

**Brief Description of Drawings**

For a more complete understanding of the present disclosure and its advantages, reference is now made to the following description taken in conjunction with the accompanying drawings, in which like reference numerals represent like parts:

FIG. 1 illustrates an examples of a transmission structure in the time-frequency domain of a long-term evolution (LTE), evolved universal terrestrial radio access (E-UTRA), LTE-Advanced (LTE-A), NR, or a wireless communication system similar thereto;

FIG. 2 illustrates an example of a structure of a frame, a subframe, and a slot in a 5th generation (5G) system;

FIG. 3 illustrates an example of a configuration example of a bandwidth part (BWP) in a wireless communication system according to some embodiments;

FIG. 4 illustrates an example of indication and switching of a bandwidth part in a wireless communication system according to certain embodiments of this disclosure;

FIG. 5 illustrates an example of a configuration of a control area of a downlink control channel in a wireless communication system according to certain embodiments of this disclosure;

FIG. 6 illustrates an example of PDSCH frequency domain resource assignment in a wireless communication system according to certain embodiments of this disclosure;

FIG. 7 illustrates an example of physical downlink shared channel (PDSCH) time domain resource assignment in a wireless communication system according to certain embodiments of this disclosure;

FIG. 8 illustrates an example of PDSCH time domain resource assignment according to a subcarrier interval of a data channel and a control channel in a wireless communication system according to certain embodiments of this disclosure;

FIG. 9 illustrates an example of an LDPC coding method according to certain embodiments of this disclosure;

FIG. 10 illustrates an example of an LDPC decoding method according to certain embodiments of this disclosure;

FIG. 11 illustrates an example of a parity-check matrix structure of an LDPC code according to certain embodiments of this disclosure;

FIG. 12 illustrates an example of a rate matching scheme based on a circular buffer in an LDPC coding process according to certain embodiments of this disclosure;

FIG. 13 illustrates an example of a redundancy version (RV) value used in an LDPC coding or retransmission process according to certain embodiments of this disclosure;

FIG. 14 illustrates an example of slot-specific repetitive transmission (slot aggregation) a in a wireless communication system according to certain embodiments of this disclosure;

FIG. 15 illustrates an example of a protocol stack of a base station and a UE at the time of performing single-cell connection, carrier aggregation, and dual connectivity according to some embodiments of the present disclosure;

FIG. 16 illustrates an example of antenna port configuration and resource assignment for cooperative communication in a wireless communication system according to certain embodiments of this disclosure;

FIG. 17 illustrates an example of a configuration of downlink control information (DCI) for cooperative communication in a wireless communication system according to certain embodiments of this disclosure;

FIG. 18 illustrates an example of repetitive transmission in multiple transmission and reception points (TRPs) in which multiple resource assignment methods are employed in a wireless communication system according to certain embodiments of this disclosure;

FIG. 19 illustrates an example of a structure of a UE in a wireless communication system according to certain embodiments of this disclosure;

FIG. 20 illustrates an example of a structure of a base station in a wireless communication system according to an embodiment;

FIG. 21 illustrates, in block diagram format, an example of a transmission device according to certain embodiments of this disclosure;

FIG. 22 illustrates, in block diagram format, an example of a reception device according to certain embodiments of this disclosure;

FIGS. 23A and 23B illustrate examples of a message-passing operation performed at arbitrary check and variable nodes in order to perform LDPC decoding according to certain embodiments of this disclosure;

FIG. 24 illustrates an example of structures of an LDPC decoder according to certain embodiments; and

FIG. 25 illustrates an example of a decoding process in an LDPC decoder according to certain embodiments of this disclosure.

## Mode for the Invention

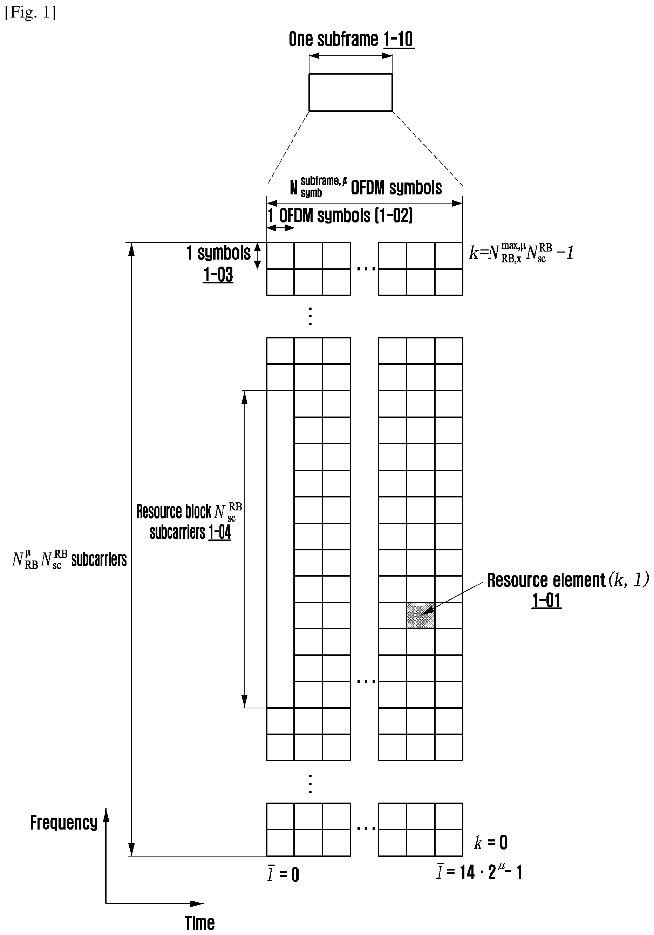

FIGS. 1 through 25, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged system or device.

Hereinafter, embodiments of the disclosure will be described in detail with reference to the accompanying drawings.

In describing embodiments of the disclosure, descriptions related to technical contents well-known in the art and not associated directly with the disclosure will be omitted. Such an omission of unnecessary descriptions is intended to prevent obscuring of the main idea of the disclosure and more clearly transfer the main idea.

For the same reason, in the accompanying drawings, some elements may be exaggerated, omitted, or schematically illustrated. Further, the size of each element does not completely reflect the actual size. In the drawings, identical or corresponding elements are provided with identical reference numerals.

The advantages and features of the disclosure and ways to achieve them will be apparent by making reference to embodiments as described below in detail in conjunction with the accompanying drawings. However, the disclosure is not limited to the embodiments set forth below, but may be implemented in various different forms. The following embodiments are provided only to completely disclose the disclosure and inform those skilled in the art of the scope of the disclosure, and the disclosure is defined only by the scope of the appended claims. Throughout the specification, the same or like reference numerals designate the same or like elements.

Here, it will be understood that each block of the flowchart illustrations, and combinations of blocks in the flowchart illustrations, can be implemented by computer program instructions. These computer program instructions can be provided to a processor of a general purpose computer, special purpose computer, or other programmable data processing apparatus to produce a machine, such that the instructions, which execute via the processor of the computer or other programmable data processing apparatus, create means for implementing the functions specified in the flowchart block or blocks. These computer program instructions may also be stored in a computer usable or computer-readable memory that can direct a computer or other programmable data processing apparatus to function in a particular manner, such that the instructions stored in the computer usable or computer-readable memory produce an article of manufacture including instruction means that implement the function specified in the flowchart block or blocks. The computer program instructions may also be loaded onto a computer or other programmable data processing apparatus to cause a series of operational steps to be performed on the computer or other programmable apparatus to produce a computer implemented process such that the instructions that execute on the computer or other programmable apparatus provide steps for implementing the functions specified in the flowchart block or blocks.

Further, each block of the flowchart illustrations may represent a module, segment, or portion of code, which includes one or more executable instructions for implementing the specified logical function(s). It should also be noted that in some alternative implementations, the functions noted in the blocks may occur out of the order. For example, two blocks shown in succession may in fact be executed substantially concurrently or the blocks may sometimes be executed in the reverse order, depending upon the functionality involved.

As used herein, the "unit" refers to a software element or a hardware element, such as a Field Programmable Gate Array (FPGA) or an Application Specific Integrated Circuit (ASIC), which performs a predetermined function. However, the "unit" does not always have a meaning limited to software or hardware. The "unit" may be constructed either to be stored in an addressable storage medium or to execute one or more processors. Therefore, the "unit" includes, for example, software elements, object-oriented software elements, class elements or task elements, processes, functions, properties, procedures, sub-routines, segments of a program code, drivers, firmware, micro-codes, circuits, data, database, data structures, tables, arrays, and parameters. The elements and functions provided by the "unit" may be either combined into a smaller number of elements, or a "unit", or divided into a larger number of elements, or a "unit". Moreover, the elements and "units" or may be implemented to reproduce one or more CPUs within a device or a security multimedia card. Further, the "unit" in the embodiments may include one or more processors.

Hereinafter, embodiments of the disclosure will be described in detail in conjunction with the accompanying drawings. In the following description of the disclosure, a detailed description of known functions or configurations incorporated herein will be omitted when it may make the subject matter of the disclosure rather unclear. The terms which will be described below are terms defined in consideration of the functions in the disclosure, and may be different according to users, intentions of the users, or customs. Therefore, the definitions of the terms should be made based on the contents throughout the specification. In the following description, a base station is a subject that performs resource allocation for a terminal, and may be at least one of a gNode B, an eNode B, a Node B, a base station (BS), a radio access unit, a base station controller, or a node on a network. The terminal may include a user equipment (UE), a mobile station (MS), a cellular phone, a smartphone, a computer, or a multimedia system capable of performing a communication function. Of course, the disclosure is not limited to the above examples.

Hereinafter, the disclosure describes a technology for receiving broadcast information from a base station by a UE in a wireless communication system. The disclosure relates to a communication technology for converging a 5G communication system for supporting a higher data transfer rate beyond that of a 4G system with IoT technology, and a system therefor. The disclosure may be applied to intelligent services (for example, smart homes, smart buildings, smart cities, smart cars or connected cars, health care, digital educations, retail business, security and safety-related services, etc.) based on a 5G communication technology and IoT-related technology.

Hereinafter, terms referring to broadcast information, terms referring to control information, terms relating to communication coverage, terms referring to a state change (e.g., an event), terms referring to network entities, terms referring to messages, terms referring to elements of devices, etc., which are used in the following description, are used by way of example for convenience of explanation. Therefore, the disclosure is not limited to the terms described below, and other terms having equivalent technical meanings thereto may be used.

Hereinafter, for convenience of description below, some terms and names defined in the 3rd-generation partnership project long-term evolution (3GPP LTE) standard may be used. However, the disclosure is not limited by the terms and names, and may be equally applied to systems conforming to other standards.

The wireless communication system, which has provided voice-oriented services in early stages, has evolved into a broadband wireless communication system that provides high-speed and high-quality packet data services according to communication standards such as high-speed packet access (HSPA) of 3GPP, LTE (or evolved universal terrestrial radio access (E-UTRA)), LTE-advanced (LTE-A), LTE-Pro, high-rate packet data (HRPD) of 3GPP2, ultra-mobile broadband (UMB), and IEEE 802.16e.

In an LTE system, which is a representative example of a broadband wireless communication system, downlink (DL) adopts an orthogonal frequency-division multiplexing (OFDM) scheme, and uplink (UL) adopts a single-carrier frequency-division multiple access (SC-FDMA) scheme. The uplink refers to a radio link through which a UE or mobile station (MS) transmits data or a control signal to a base station, and the downlink refers to a radio link through which a base station transmits data or a control signal to a UE. In the multiple access scheme described above, data of respective users and control information are distinguished from each other by performing allocation and operations such that time-frequency resources for carrying the data or control information for each UE do not overlap each other, that is, such that orthogonality is established.

As a future communication system after LTE, that is, a 5G communication system needs to freely reflect the various requirements of a user, a service provider, and the like, and thus services satisfying the various requirements need to be supported. Services being considered for the 5G communication system include enhanced mobile broadband (eMBB) communication, massive machine-type communication (mMTC), ultra-reliable low-latency communication (URLLC), and the like.

According to certain embodiments of this disclosure, the eMBB aims to provide a further improved data transfer rate compared to the data rate supported by the legacy LTE, LTE-A or LTE-Pro. For example, in the 5G communication system, the eMBB needs to support, from the viewpoint of one base station, a peak data rate of 20 Gbps in the downlink and a peak data rate of 10 Gbps in the uplink. At the same time, the 5G communication system needs to provide a perceived increase in a data rate from the perspective of a user equipment. In order to satisfy these requirements, the 5G communication system requires enhanced transmission or reception technology including enhanced multi-input multi-output (MIMO) transmission technology. Further, LTE uses a 2 GHz band, whereas the 5G communication system uses a wider frequency bandwidth than 20 MHz in a frequency band of 3 to 6 GHz or a frequency band higher than 6 GHz, and thus may satisfy the required data rate.

mMTC is being considered for implementation in 5G communication systems in order to support application services such as those related to the Internet of Things (IoT). In order to efficiently support the Internet of Things, mMTC needs to satisfy requirements such as massive UE connection support in a cell, UE coverage improvement, increased battery lifetime, and UE cost reduction. Since the Internet of Things involves connection to multiple sensors and various devices to provide communication functions, the Internet of Things needs to support a large number of UEs (e.g., 1,000,000 UEs/km$^2$) in a cell. Further, a UE supporting mMTC is highly likely to be located in a shaded area that cannot be covered by a cell, such as a basement of a building, due to the service characteristics, and thus may require wider coverage than other services provided in the 5G communication system. The UE supporting mMTC needs to be configured as a low-cost UE, and requires a very long battery lifetime since it is difficult to frequently replace a battery of the UE.

Finally, the URLLC is a cellular-based wireless communication service used for a specific (mission-critical) purpose, and the service may be used for remote control of robots or machinery, industrial automation, unmanned aerial vehicles, remote health care, emergency alerts, and the like, thereby providing communication with very low latency and very high reliability. For example, a service supporting the URLLC needs to satisfy a wireless access latency time (air interface latency) that is less than 0.5 ms, and at the same time requires a packet error rate of 10$^{-5}$ or less. Accordingly, for service supporting the URLLC, the 5G system needs to provide a transmission time interval (TTI) that is smaller than that of other services, and must also satisfy design requirements for allocating wide frequency band resources. However, the mMTC, URLLC, and eMBB described above are only examples of different service types, and the service types to which the disclosure is applied are not limited to the above-described examples.

The services considered in the 5G communication system described above need to be provided in the state of being converged with each other based on a single framework. That is, for efficient resource management and control, it is preferable that respective services be integrated and controlled as one system and transmitted rather than being operated independently.

In addition, hereinafter, an embodiment will be described as an example of the LTE, LTE-A, LTE Pro, or NR system, but the embodiment may be applied to other communication systems having similar technical backgrounds or channel types. In addition, the embodiments may be applied to other communication systems through some modifications within a range that does not significantly depart from the scope of the disclosure, based on a determination by a person skilled in the art.

The disclosure relates to a method and apparatus for repeatedly transmitting data and control signals between multiple transmission nodes and UEs that perform cooperative communication in order to improve communication reliability.

According to the disclosure, in the case where cooperative network communication is used in a wireless communication system, the reliability of reception of data and/or control signals by a UE can be improved.

Hereinafter, the frame structure of the 5G system will be described in more detail with reference to the drawings. FIG. 1 illustrates an example of a transmission structure in a time-frequency domain of LTE, LTE-A, NR or a wireless communication system similar thereto.

FIG. 1 illustrates an example of the basic structure of a time-frequency domain, which is a radio resource domain in which data or control channels are transmitted in a 5G system.

Referring to the illustrative example of FIG. 1, the horizontal axis indicates a time domain, and the vertical axis indicates a frequency domain. The basic unit of the time-frequency domain is a resource element (RE) 1-01, and the RE may be defined by 1 orthogonal frequency division multiplexing (OFDM) symbol 1-02 on the time axis and 1 subcarrier 1-03 on the frequency axis. In the frequency domain, $N_{sc}^{RB}$ (e.g., 12) consecutive REs may configure one resource block (RB) 1-04.

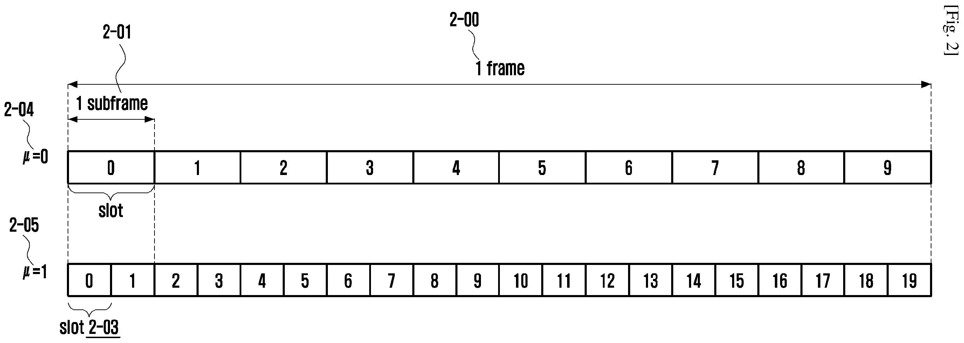

FIG. 2 illustrates an example of the structure of a frame, a subframe, and a slot in a 5G system.

Referring to the illustrative example of FIG. 2, an example of a frame 2-00, a subframe 2-01, and a slot 2-02 is illustrated. 1 frame 2-00 may be defined as 10 ms. 1 subframe 2-01 may be defined as 1 ms, and thus 1 frame 2-00 may be configured by a total of 10 subframes 2-01. 1 slot (indicated by reference numerals 2-02 and 2-03) may be defined by 14 OFDM symbols (i.e., the number of symbols ($N_{symb}^{slot}$) per slot = 14). 1 subframe 2-01 may be configured by one or multiple slots 2-02 and 2-03, and the number of slots 2-02 and 2-03 per subframe 2-01 may be different depending on the configuration value $\mu$ (indicated by reference numerals 2-04 and 2-05) for the subcarrier interval.

In the example of FIG. 2, the case where $\mu = 0$ (indicated by reference numeral 2-04) and the case where $\mu = 1$ (indicated by reference numeral 2-05) are shown as subcarrier interval configuration values. In the case where $\mu = 0$ (indicated by reference numeral 2-04), 1 subframe 2-01 may be configured by 1 slot 2-02, and in the case where $\mu = 1$ (indicated by reference numeral 2-05), 1 subframe 2-01 may be configured by two slots (indicated by reference numeral 2-03). That is, the number of slots ($N_{slot}^{subframe,\mu}$) per subframe may differ according to the configuration value $\mu$ for the subcarrier interval, and thus the number of slots ($N_{slot}^{frame,\mu}$) per frame may differ. $N_{slot}^{subframe,\mu}$ and $N_{slot}^{frame,\mu}$ according to each subcarrier spacing configuration $\mu$ may be defined as in

<Table 1> below.

Table 1

| $\mu$ | $N_{symb}^{slot}$ | $N_{slot}^{frame,\mu}$ | $N_{slot}^{subframe,\mu}$ |
|---|---|---|---|
| 0 | 14 | 10 | 1 |
| 1 | 14 | 20 | 2 |
| 2 | 14 | 40 | 4 |
| 3 | 14 | 80 | 8 |
| 4 | 14 | 160 | 16 |
| 5 | 14 | 320 | 32 |

In NR, one component carrier (CC) or serving cell may be configured by up to 250 RBs or more. Therefore, in the case where the UE always receives the entire serving cell bandwidth, such as in LTE, the amount of power consumed by the UE may be extreme, and in order to solve the problem of high power consumption, the base station configures one or more bandwidth parts (BWPs) for the UE. Therefore, the base station may support changing of a reception area in a cell by the UE. In NR, the base station may configure "initial BWP", which is the bandwidth of CORESET #0 (or common search space, CSS) for the UE through MIB. Thereafter, the base station may configure initial BWP (first BWP) for the UE via RRC signaling and provide notification of one or more pieces of BWP configuration information that may be indicated using downlink control information (DCI) in the future. Thereafter, the base station may indicate which band the UE will use by providing notification of the BWP ID using DCI. If the UE does not receive DCI from the currently allocated BWP for a specific time or longer, the UE returns to "default BWP" and attempts to receive the DCI.

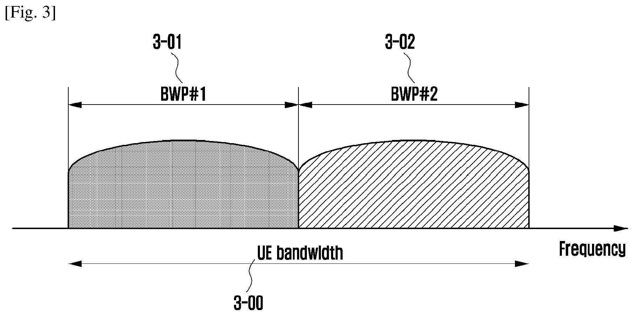

FIG. 3 illustrates an example of a configuration of a bandwidth part in a wireless communication system according to certain embodiments of this disclosure.

Referring to the non-limiting example of FIG. 3, FIG. 3 shows an example in which a UE bandwidth 3-00 is configured as two bandwidth parts, namely, bandwidth part #1 (indicated by reference numeral 3-05) and bandwidth part #2 (indicated by reference numeral 3-10). The base station may configure one or multiple bandwidth parts for the UE, and may configured information as shown in <Table 2> below for each bandwidth part.

```
BWP ::=                     SEQUENCE {
    bwp-Id                      BWP-Id,
    locationAndBandwidth        INTEGER (1..65536),
    subcarrierSpacing           ENUMERATED {n0, n1, n2, n3, n4,
n5},
    cyclicPrefix                ENUMERATED { extended }
}
```

In addition to the configuration information described in <Table 2>, various parameters related to the bandwidth part may be configured for the UE. The information described above may be transmitted by the base station to the UE via higher layer signaling, for example, RRC signaling. According to certain embodiments, at least one bandwidth part among the configured one or multiple bandwidth parts may be activated. Whether to activate the configured bandwidth part may be semi-statically transmitted via RRC signaling from the base station to the UE, or may be dynamically transmitted through a MAC control element (CE) or DCI.

The bandwidth part supported by the 5G communication system may be used for various purposes.

For example, in a case that the bandwidth supported by the UE is smaller than the system bandwidth, only the bandwidth supported by the UE may be configured through the configuration of the bandwidth part. For example, in <Table 2>, since the frequency position of the bandwidth part is configured for the UE, the UE may transmit or receive data at a specific frequency position within the system bandwidth.

According to some embodiments, for the purposes of supporting different nu-merologies, the base station may configure multiple bandwidth parts for the UE. For example, in order to provide support for data transmission or reception using a subcarrier spacing of 15 kHz and a subcarrier spacing of 30 kHz to an arbitrary UE, two bandwidth parts may be configured to use subcarrier spacings of 15 kHz and 30 kHz, respectively. Different bandwidth parts may be subject to frequency division multiplexing (FDM), and in the case of trying to transmit or receive data at a specific subcarrier interval, a bandwidth part configured at corresponding subcarrier intervals may be activated.

According to some embodiments, for the purposes of reducing the amount of power consumed by the UE, the base station may configure, for the UE, a bandwidth part having different bandwidths. For example, in case that the UE supports a very large bandwidth, for example, a bandwidth of 100 MHz, and always transmits or receives data through a corresponding bandwidth, that may cause very large power consumption. In particular, in the situation where there is no traffic, unnecessary monitoring of a downlink control channel for a large bandwidth of 100 MHz by the UE may be very inefficient in terms of power consumption.

Therefore, for the purpose of reducing the power consumption by the UE, the base station may configure, for the UE, a bandwidth part corresponding to a relatively small bandwidth, for example, a bandwidth part of 20 MHz. In the situation where there is no traffic, the UE may perform a monitoring operation in a 20 MHz bandwidth part, and in the case of transmission of data, the UE may transmit or receive data using 100 MHz bandwidth part according to the instructions of the base station.

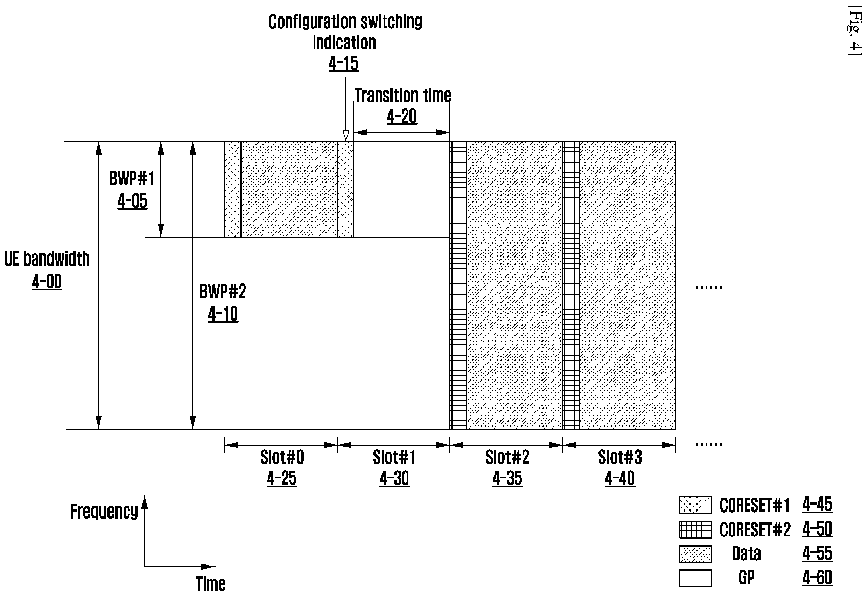

FIG. 4 illustrates an example of indication and switching of a bandwidth part in a wireless communication system according to certain embodiments of this disclosure.

Referring to the illustrative example of FIG. 4, as described in <Table 2> above, the base station may configure one or more bandwidth parts for the UE, and notify the UE of information about the bandwidth of a bandwidth part and the frequency position of the bandwidth part, and the numerology of the bandwidth part, as the configuration for each bandwidth part. FIG. 4 illustrates an example in which two bandwidth parts, namely a bandwidth part #1 (BPW #1) 4-05 and a bandwidth part #2 (BWP #2) 4-10 are configured in in a UE bandwidth 4-00. One or multiple bandwidth parts may be activated among the configured bandwidths, and an example in which one bandwidth part is activated is considered in FIG. 4. As shown in the explanatory example of FIG. 4, among bandwidth parts configured in a slot #0 4-25, a bandwidth part #1 4-02 is in an activated state, and the UE may monitor a physical downlink control channel (PDCCH) in a control area #1 4-45 configured in a bandwidth part #1 4-05, and may transmit or receive data 4-55 in the bandwidth part #1 4-05. According to an activated bandwidth part among the configured bandwidth parts, the control area in which the UE receives the PDCCH may differ, and accordingly, the bandwidth in which the UE monitors the PDCCH may be changed.

The base station may additionally transmit an indicator for switching the configuration for the bandwidth part to the UE. Here, switching the configuration for the bandwidth part may be considered the same as an operation of activating a specific bandwidth part (e.g., switching activation of the bandwidth part A to activation of the bandwidth part B). The base station may transmit a configuration-switching indication to the UE in a specific slot, and the UE may receive the configuration switching indicator from the base station, may determine the bandwidth part to be activated by applying the switched configuration according to the configuration-switching indication from a specific time point, and may perform monitoring for the PDCCH in a control area configured in the activated bandwidth part.

Referring to the illustrative example of FIG. 4, the base station transmits, to the UE, a configuration-switching indication 4-15 instructing the UE to change the activated bandwidth part from existing bandwidth part #1 4-05 to bandwidth part #2 4-10 in slot #1 4-30. After receiving the corresponding indicator, the UE may activate bandwidth part #2 4-10 according to the content of the indicator. Here, a transition time 4-20 at which a bandwidth part to be is changed may be required, and accordingly, a time point at which a bandwidth part to be activated is changed and applied may be determined.

FIG. 4 illustrates, without limitation, an example in which a transition time 4-20 of slot #1 is taken after reception of the configuration-switching indication 4-15. Data transmission or reception may not be performed during the transition time 4-20 (indicated by reference numeral 4-60). Accordingly, the bandwidth part #2 4-10 is activated in slot #2 4-35, and thus an operation of transmission or reception of a control channel and data to or from the corresponding bandwidth part may be performed.

The base station may preconfigure one or more bandwidth parts for the UE via higher layer signaling (for example, RRC signaling), and may perform indication using a method for mapping the configuration-switching indication 4-15 to one of the bandwidth part configurations preconfigured by the base station. For example, the indicator of the $\log_2 N$ bit may select and indicate one of the N preconfigured bandwidth parts. <Table 3> below shows an example in which configuration information for a bandwidth part is indicated using a 2-bit indicator.

[Table 3]

| Indicator Value | Bandwidth Part Configuration |
|---|---|
| 00 | BWP A configured via higher layer signaling |
| 01 | BWP B configured via higher layer signaling |
| 10 | BWP C configured via higher layer signaling |
| 11 | BWP D configured via higher layer signaling |

The configuration-switching indication 4-15 for the bandwidth part illustrated in FIG. 4 may be transmitted from the base station to the UE, in a format of medium access control (MAC) control element (CE) signaling or L1 signaling (e.g., common DCI, group-common DCI, UE-specific DCI).

According to the configuration-switching indication 4-15 for the bandwidth part described in FIG. 4, the time point from which the bandwidth part activation is applied will be described below. That is, a time point from which the configuration switching is applied may be configured according to a predetermined value (for example, slot $N (\geq 1)$ after reception of the configuration-switching indication), may be configured by the base station via higher layer signaling (e.g., RRC signaling) to the UE, or may be transmitted as part of the content of the configuration-switching indication 4-15. Alternatively, the time point from which the configuration switching is applied may be determined by a combination of the methods described above. After receiving the configuration-switching indication 4-15 for the bandwidth part, the UE may apply the switched configuration from the time point obtained by the methods described above.

Hereinafter, a downlink control channel in a 5G communication system will be described in more detail with reference to the drawings.

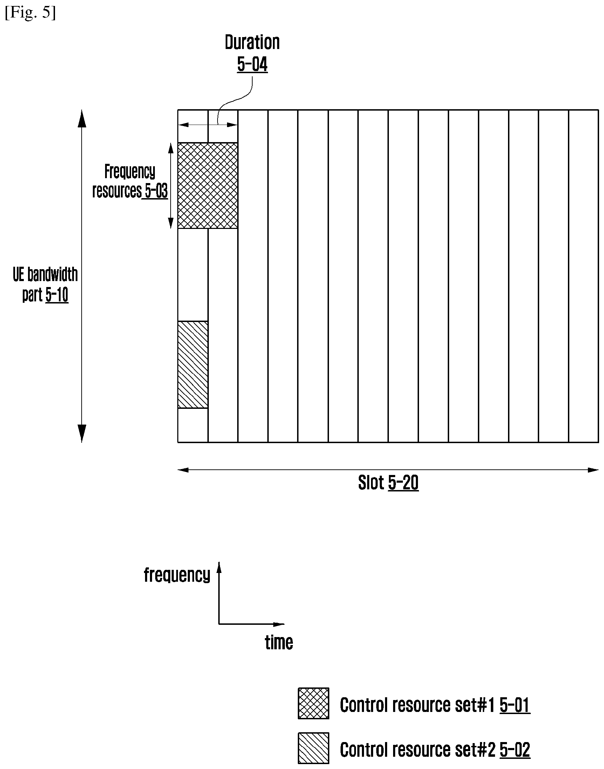

FIG. 5 illustrates an example of a configuration of a control area of a downlink control channel n a wireless communication system according to certain embodiments of this disclosure.

Referring to the non-limiting example of FIG. 5, an example in which a bandwidth part 5-10 of a UE is configured on the frequency axis and two control areas (control area #1 5-01 and control area #2 5-02) are configured in one slot 5-20 on the time axis is shown. The control areas 5-01 and 5-02 may, in some embodiments, be configured in a specific frequency resource 5-03 within an entire UE bandwidth part 5-10 on the frequency axis. The control areas 5-01 and 5-02 may be configured as one or multiple OFDM symbols on the time axis, and may be defined as a control area length (control resource set duration 5-04). In the example of FIG. 5, control area #1 5-01 is configured as the length of the control area of two symbols, and control area #2 5-02 is configured as the length of the control area of one symbol.

The control area in 5G described above may, in certain embodiments, be configured, by the base station, for the UE via higher layer signaling (e.g., system information, master information block (MIB), radio resource control (RRC) signaling). Configuration of the control area to the UE may denote that the base station provides information, such as a control area identity, a frequency position of the control area, and a symbol length of the control area, to the UE. For example, the information may include the information shown in <Table 4>.

[Table 4]

```
ControlResourceSet ::=                    SEQUENCE {
    -- Corresponds to L1 parameter 'CORESET-ID'
    controlResourceSetId              ControlResourceSetId,
    frequencyDomainResources          BIT STRING (SIZE (45)),
    duration                          INTEGER
(1..maxCoReSetDuration),
    cce-REG-MappingType                    CHOICE {
        interleaved                    SEQUENCE {
            reg-BundleSize                    ENUMERATED {n2,
n3, n6},
            precoderGranularity               ENUMERATED
{sameAsREG-bundle, allContiguousRBs},

            interleaverSize                   ENUMERATED {n2,
n3, n6}

            shiftIndex
        INTEGER(0..maxNrofPhysicalResourceBlocks-1)
            },
        nonInterleaved                    NULL
        },
    tci-StatesPDCCH                   SEQUENCE(SIZE
(1..maxNrofTCI-StatesPDCCH)) OF TCI-StateId          OPTIONAL,
    tci-PresentInDCI                  ENUMERATED {enabled}
}
```

In <Table 4>, tci-StatesPDCCH (simply referred to as TCI state) configuration information may include information about one or multiple synchronization signals (SSs) or a physical broadcast channel (PBCH) block index or channel state information reference signal (CSI-RS) index, having a quasi-co-located (QCL) relationship with a demodulation reference signal (DMRS) transmitted from the corresponding control area.

Next, downlink control information (DCI) in NR will be described in detail. Scheduling information about uplink data (or physical uplink shared channel (PUSCH)) or downlink data (or physical downlink shared channel (PDSCH)) in NR is transmitted to the UE from the base station through DCI. For efficient control channel reception by the UE, various examples of DCI formats are illustrated n in <Table 5>, with the usage of each format specified accordingly.

[Table 5] [102]

| DCI format | Usage |
|---|---|
| 0_0 | Scheduling of PUSCH in one cell |
| 0_1 | Scheduling of PUSCH in one cell |
| 1_0 | Scheduling of PDSCH in one cell |

12

(continued)

| DCI format | Usage |
|---|---|
| 1_1 | Scheduling of PDSCH in one cell |
| 2_0 | Notifying a group of UEs of the slot format |
| 2_1 | Notifying a group of UEs of the PRB(s) and OFDM symbol(s) where UE may assume no transmission is intended for the UE |
| 2_2 | Transmission ofTPC commands for PUCCH and PUSCH |
| 2_3 | Transmission of a group of TPC commands for SRS transmissions by one or more UEs |

The UE may monitor a DCI format for fallback and a DCI format for non-fallback for PUSCH or PDSCH. The DCI format for fallback may be configured by fixed fields pre-defined between the base station and the UE, and the DCI format for non-fallback may include a configurable field.

In certain embodiments, the DCI may be transmitted through a physical downlink control channel (PDCCH) after performing a channel coding and modulation process. A cyclic redundancy check (CRC) is attached to a DCI message payload, and the CRC is scrambled using a radio network temporary identifier (RNTI), corresponding to the identity of the UE.

Different RNTIs are used according to the purpose of the DCI message, for example, UE-specific data transmission, power control command, or random access response. That is, the RNTI is not explicitly transmitted, but is included in the CRC calculation process and transmitted. Upon receiving the DCI message transmitted on the PDCCH, the UE checks the CRC using the allocated RNTI, and if the CRC check result is correct, the UE may be made aware that the corresponding message is transmitted to the UE.

For example, DCI scheduling a PDSCH for system information (SI) may be scrambled using SI-RNTI. The DCI scheduling the PDSCH for a random access response (RAR) message may be scrambled using RA-RNTI. The DCI scheduling the PDSCH for the paging message may be scrambled using P-RNTI. DCI providing notification of a slot format indicator (SFI) may be scrambled using SFI-RNTI. DCI providing notification of a transmit power control (TPC) may be scrambled using TPC-RNTI. DCI for scheduling the UE-specific PDSCH or PUSCH may be scrambled using C-RNTI (Cell RNTI).

DCI format 0_0 may be used as DCI for fallback for scheduling PUSCH, and here, CRC may be scrambled using C-RNTI. DCI format 0_0, in which CRC is scrambled using C-RNTI may include, for example, the information shown in <Table 6> below.

[Table 6]

- Identifier for DCI formats- [1] bit

       - Frequency domain resource assignment- $[\lceil \log_2(N_{RB}^{ULBWP}(N_{RB}^{ULBWP}+1)/2) \rceil]_{bits}$

- Time domain resource assignment - X bits
- Frequency hopping flag - 1 bit.
- Modulation and coding scheme- 5 bits
- New data indicator- 1 bit
- Redundancy version - 2 bits
- HARQ process number- 4 bits
- TPC command for scheduled PUSCH - [2] bits
- UL/SUL indicator - 0 or 1 bit

DCI format 0_1 may be used as DCI for non-fallback for scheduling PUSCH, and CRC may be scrambled using C-RNTI. DCI format 0_1, in which CRC is scrambled using C-RNTI, may include, for example, the information shown in <Table 7> below.

[Table 7]

- Carrier indicator - 0 or 3 bits
- UL/SUL indicator-0 or 1 bit

(continued)

| |
|---|
| - Identifier for DCI formats - [1] bits<br>- Bandwidth part indicator - 0, 1 or 2 bits<br>- Frequency domain resource assignment<br><br>        • For resource allocation type 0, $\left\lceil N_{RB}^{UL,BWP}/P \right\rceil$ bits<br><br>        • For resource allocation type 1, $\left\lceil \log_2(N_{RB}^{UL,BWP}(N_{RB}^{UL,BWP}+1)/2) \right\rceil$ bits<br>- Time domain resource assignment -1, 2, 3, or 4 bits<br>- VRB-to-PRB mapping - 0 or 1 bit, only for resource allocation type 1.<br>        • 0 bit if only resource allocation type 0 is configured;<br>        • 1 bit otherwise.<br>- Frequency hopping flag - 0 or 1 bit, only for resource allocation type 1.<br>        • 0 bit if only resource allocation type 0 is configured;<br>        • 1 bit otherwise.<br>- Modulation and coding scheme - 5 bits<br>- New data indicator - 1 bit<br>- Redundancy version - 2 bits<br>- HARQ process number - 4 bits<br>- 1st downlink assignment index - 1 or 2 bits<br>        • 1 bit for semi-static HARQ-ACK codebook;<br>        • 2 bits for dynamic HARQ-ACK codebook with single HARQ-ACK codebook<br>- 2nd downlink assignment index - 0 or 2 bits<br>        • 2 bits for dynamic HARQ-ACK codebook with two HARQ-ACK sub-codebooks;<br>        • 0 bit otherwise.<br>- TPC command for scheduled PUSCH - 2 bits<br><br>- SRS resource indicator - $\left\lceil \log_2\left(\sum_{k=1}^{L_{max}}\binom{N_{SRS}}{k}\right) \right\rceil$ or $\left\lceil \log_2(N_{SRS}) \right\rceil$ bits<br><br>    • $\left\lceil \log_2\left(\sum_{k=1}^{L_{max}}\binom{N_{SRS}}{k}\right) \right\rceil$ bits for non-codebook based PUSCH transmission;<br><br>    • $\left\lceil \log_2(N_{SRS}) \right\rceil$ bits for codebook based PUSCH transmission.<br>- Precoding information and number of layers-up to 6 bits<br>- Antenna ports- up to 5 bits<br>- SRS request-2 bits<br>- CSI request - 0, 1, 2, 3,4, 5, or 6 bits<br>- CBG transmission information- 0, 2, 4, 6, or 8 bits<br>- PTRS-DMRS association-0 or 2 bits.<br>- beta_offset indicator-0 or 2 bits<br>- DMRS sequence initialization-0 or 1 bit |

DCI format 1_0 may be used as DCI for fallback for scheduling PDSCH, and here, CRC may be scrambled using C-RNTI. DCI format 1_0 in which CRC is scrambled using C-RNTI may include, for example, the information shown in <Table 8> below.

[Table 8]

| |
|---|
| - Identifier for DCI formats-[1] bit |

(continued)

| |
|---|
| - Frequency domain resource assignment - $[\lceil \log_2(N_{RB}^{DL,BWP}(N_{RB}^{DL,BWP}-1)/2) \rceil]$ bits |
| - Time domain resource assignment - X bits |
| - VRB-to-PRB mapping -1 bit. |
| - Modulation and coding scheme - 5 bits |
| - New data indicator-1 bit |
| - Redundancy version - 2 bits |
| - HARQ process number - 4 bits |
| - Downlink assignment index - 2 bits |
| - TPC command for scheduled PUCCH - [2] bits |
| - PUCCH resource indicator - 3 bits |
| - PDSCH-to-HARQ feedback timing indicator- [3] bits |

DCI format 1_1 may be used as DCI for non-fallback for scheduling a PDSCH, and CRC may be scrambled using C-RNTI. DCI format 1_1, in which CRC is scrambled using C-RNTI may include, for example, the information shown in <Table 9> below.

[Table 9]

| |
|---|
| - Carrier indicator - 0 or 3 bits |
| - Identifier for DCI formats - [1] bits |
| - Bandwidth part indicator-0,1 or 2 bits |
| - Frequency domain resource assignment |
|      • For resource allocation type 0, $\lceil N_{RB}^{DL,BWP}/P \rceil$ bits |
|      • For resource allocation type 1, $\lceil \log_2(N_{RB}^{DL,BWP}(N_{RB}^{DL,BWP}+1)/2) \rceil$ bits |
| - Time domain resource assignment -1, 2, 3, or 4 bits |
| - VRB-to-PRB mapping - 0 or 1 bit, only for resource allocation type 1. |
|      • 0 bit if only resource allocation type 0 is configured; |
|      • 1 bit otherwise. |
| - PRB bundling size indicator - 0 or 1 bit |
| - Rate matching indicator- 0, 1, or 2 bits |
| - ZP CSI-RS trigger - 0, 1, or 2 bits |
| For transport block 1: |
| - Modulation and coding scheme - 5 bits |
| - New data indicator - 1 bit |
| - Redundancy version - 2 bits |
| For transport block 2: |
| - Modulation and coding scheme - 5 bits |
| - New data indicator - 1 bit |
| - Redundancy version - 2 bits |
| - HARQ process number - 4 bits |
| - Downlink assignment index - 0 or 2 or 4 bits |
| - TPC command for scheduled PUCCH - 2 bits |
| - PUCCH resource indicator-3 bits |
| - PDSCH-to-HARQ_feedback timing indicator-3 bits |
| - Antenna ports - 4, 5 or 6 bits |
| - Transmission configuration indication- 0 or 3 bits |
| - SRS request-2 bits |
| - CBG transmission information - 0, 2, 4, 6, or 8 bits |

(continued)

| |
|---|
| - CBG flushing out information-0 or 1 bit |
| - DMRS sequence initialization -1 bit |

In NR, in addition to frequency axis resource candidate allocation through BWP indication, the detailed frequency domain resource assignment (FD-RA) methods may be provided using DCI, as follows.

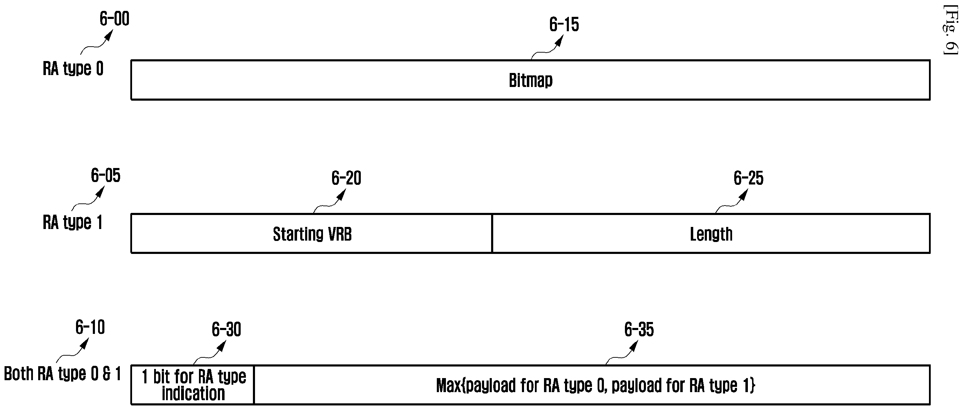

FIG. 6 illustrates an example of PDSCH frequency domain resource assignment in a wireless communication system according to certain embodiments of this disclosure.

Referring to the non-limiting example of FIG. 6, if the UE is configured to use only resource type 0 via higher layer signaling (indicated by reference numeral 6-00), some downlink control information (DCI) for allocating PDSCH to the UE includes a bit map configured by NRBG bits. The conditions thereof will be explained again later. Here, NRBG denotes the number of resource block groups (RBGs) determined as shown in <Table 10> according to the size of BWP allocated by the BWP indicator and a higher layer parameter rbg-Size. Data is transmitted to RBG indicated by 1 in the bit map.

[Table 10]

| Bandwidth Part Size | Configuration 1 | Configuration 2 |
|---|---|---|
| 1 - 36 | 2 | 4 |
| 37 - 72 | 4 | 8 |
| 73 - 144 | 8 | 16 |
| 145 - 275 | 16 | 16 |

According to certain embodiments, if the UE is configured to use only resource type 1 via higher layer signaling (indicated by reference numeral 6-05), some DCIs allocating PDSCH to the UE include frequency domain resource assignment information configured by

$$\left\lceil \log_2\left(N_{RB}^{DL,BWP}\left(N_{RB}^{DL,BWP} + 1\right)/2\right)\right\rceil$$

bits. Accordingly, the base station may configure a starting VRB 6-20 and a length 6-25 of the frequency axis resource that are continuously allocated therefrom.

If the UE is configured to use both resource type 0 and resource type 1 via higher layer signaling (indicated by reference numeral 6-10), some DCIs allocating PDSCH to the corresponding UE includes frequency domain resource assignment information configured by bits of a large value (6-35) among a payload 6-15 for configuring resource type 0 and payloads 6-20 and 6-25 for configuring resource type 1. The conditions thereof will be explained again later. Here, one bit may be added to the very first part (MSB) of the frequency domain resource assignment information in DCI, and the case in which the corresponding bit is 0 indicates that resource type 0 is used and the case in which the corresponding bit is 1 indicates that resource type 1 is used.

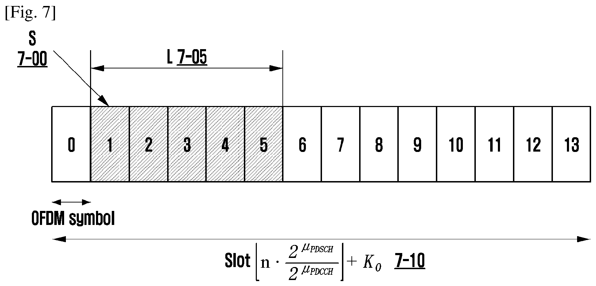

FIG. 7 illustrates an example of a PDSCH time domain resource assignment in a wireless communication system according to certain embodiments of this disclosure.

Referring to the non-limiting example of FIG. 7, the base station may indicate the time axis position of the PDSCH resource according to a subcarrier interval ($\mu_{PDSCH}, \mu_{PDCCH}$) of a data channel and a control channel configured through a higher layer, a scheduling offset ($K_0$) value, and an OFDM symbol start position 7-00 and length 7-05 in one slot, as dynamically indicated through DCI.

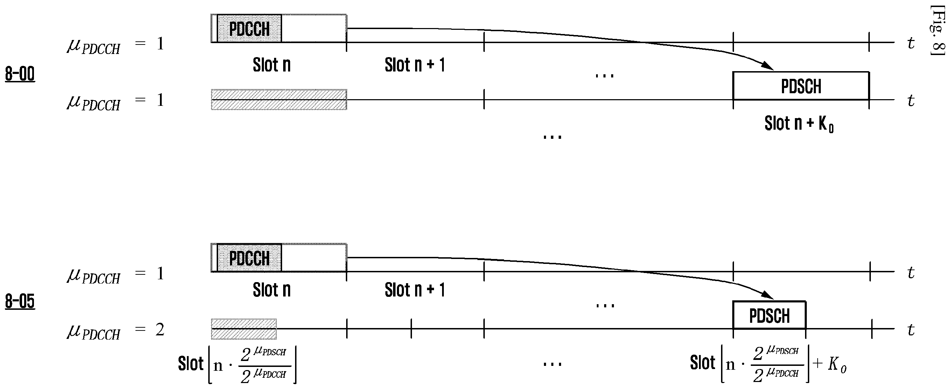

FIG. 8 illustrates an example of PDSCH time domain resource assignment according to a subcarrier interval of a data channel and a control channel in a wireless communication system according to certain embodiments of this disclosure.

Referring to the non-limiting example of FIG. 8, the case in which subcarrier intervals of a data channel and a control channel are the same (indicated by reference numeral 8-00, $\mu_{PDSCH}=\mu_{PDCCH}$), since the slot number is the same for the data and the control channel, scheduling offset may occur according to a predetermined slot offset $K_0$. On the other hand, in the case in which the data channel and the control channel have different subcarrier intervals (indicated by reference numeral 8-05), the slot numbers for data and control are different, and thus scheduling offset may occur according to a predetermined slot offset $K_0$, based on the subcarrier interval of the PDCCH.

Next, a modulation and coding scheme (MCS) indication process for a PDSCH, which is scheduled or activated using DCI, in NR will be described in detail.

The UE may receive an indication of an MCS for PDSCH together with frequency and time resource information allocated for the PDSCH through the DCI. The MCS field of DCI may indicate an index for a table selected through a higher layer among the following three tables, namely <Table 11>, <Table 12>, and <Table 13>. The range of the index indicated at the time of initial transmission and HARQ retransmission may be different. At the time of the initial transmission, indexes 0 to 28 of <Table 11>, indexes 0 to 27 of <Table 12>, and indexes 0 to 28 of <Table 13> may be used. At the time of retransmission, indexes 29 to 31 in <Table 11>, indexes 28 to 31 in <Table 12>, and indexes 29 to 31 in <Table 13> are used. The index indicated at the time of the initial transmission may indicate information on a modulation order and a target code rate of the transmitted PDSCH, and the index indicated at the time of the retransmission may indicate information on a modulation order of the transmitted PDSCH.

[Table 11] MCS index table 1 for PDSCH

| MC S Index $I_{MCS}$ | Modulation Order $Q_m$ | Target code Rate $R \times [1024]$ | Spectral efficiency |
|---|---|---|---|
| 0 | 2 | 120 | 0.2344 |
| 1 | 2 | 157 | 0.3066 |
| 2 | 2 | 193 | 0.3770 |
| 3 | 2 | 251 | 0.4902 |
| 4 | 2 | 308 | 0.6016 |
| 5 | 2 | 379 | 0.7402 |
| 6 | 2 | 449 | 0.8770 |
| 7 | 2 | 526 | 1.0273 |
| 8 | 2 | 602 | 1.1758 |
| 9 | 2 | 679 | 1.3262 |
| 10 | 4 | 340 | 1.3281 |
| 11 | 4 | 378 | 1.4766 |
| 12 | 4 | 434 | 1.6953 |
| 13 | 4 | 490 | 1.9141 |
| 14 | 4 | 553 | 2.1602 |
| 15 | 4 | 616 | 2.4063 |
| 16 | 4 | 658 | 2.5703 |
| 17 | 6 | 438 | 2.5664 |
| 18 | 6 | 466 | 2.7305 |
| 19 | 6 | 517 | 3.0293 |
| 20 | 6 | 567 | 3.3223 |
| 21 | 6 | 616 | 3.6094 |
| 22 | 6 | 666 | 3.9023 |
| 23 | 6 | 719 | 4.2129 |
| 24 | 6 | 772 | 4.5234 |
| 25 | 6 | 822 | 4.8164 |
| 26 | 6 | 873 | 5.1152 |
| 27 | 6 | 910 | 5.3320 |
| 28 | 6 | 948 | 5.5547 |

(continued)

| MC S Index $I_{MCS}$ | Modulation Order $Q_m$ | Target code Rate $R \times [1024]$ | Spectral efficiency |
|---|---|---|---|
| 29 | 2 | reserved | |
| 30 | 4 | reserved | |
| 31 | 6 | reserved | |

[Table 12] MCS index table 2 for PDSCH [136]

| MCS Index $I_{MCS}$ | Modulation Order $Q_m$ | Target code Rate $R \times [1024]$ | Spectral efficiency |
|---|---|---|---|
| 0 | 2 | 120 | 0.2344 |
| 1 | 2 | 193 | 0.3770 |
| 2 | 2 | 308 | 0.6016 |
| 3 | 2 | 449 | 0.8770 |
| 4 | 2 | 602 | 1.1758 |
| 5 | 4 | 378 | 1.4766 |
| 6 | 4 | 434 | 1.6953 |
| 7 | 4 | 490 | 1.9141 |
| 8 | 4 | 553 | 2.1602 |
| 9 | 4 | 616 | 2.4063 |
| 10 | 4 | 658 | 2.5703 |
| 11 | 6 | 466 | 2.7305 |
| 12 | 6 | 517 | 3.0293 |
| 13 | 6 | 567 | 3.3223 |
| 14 | 6 | 616 | 3.6094 |
| 15 | 6 | 666 | 3.9023 |
| 16 | 6 | 719 | 42129 |
| 17 | 6 | 772 | 4.5234 |
| 18 | 6 | 822 | 4.8164 |
| 19 | 6 | 873 | 5.1152 |
| 20 | 8 | 682.5 | 5.3320 |
| 21 | 8 | 711 | 5.5547 |
| 22 | 8 | 754 | 5.8906 |
| 23 | 8 | 797 | 6.2266 |
| 24 | 8 | 841 | 6.5703 |
| 25 | 8 | 885 | 6.9141 |
| 26 | 8 | 916.5 | 7.1602 |
| 27 | 8 | 948 | 7.4063 |
| 28 | 2 | reserved | |
| 29 | 4 | reserved | |
| 30 | 6 | reserved | |

18

(continued)

| MCS Index $I_{MCS}$ | Modulation Order $Q_m$ | Target code Rate $R \times$ [1024] | Spectral efficiency |
|---|---|---|---|
| 31 | 8 | reserved | |

[Table 13] MCS index table 3 for PDSCH

| MCS Index $I_{MCS}$ | Modulation Order $Q_m$ | Target code Rate $R \times$ [1024] | Spectral efficiency |
|---|---|---|---|
| 0 | 2 | 30 | 0.0586 |
| 1 | 2 | 40 | 0.0781 |
| 2 | 2 | 50 | 0.0977 |
| 3 | 2 | 64 | 0.1250 |
| 4 | 2 | 78 | 0.1523 |
| 5 | 2 | 99 | 0.1934 |
| 6 | 2 | 120 | 0.2344 |
| 7 | 2 | 157 | 0.3066 |
| 8 | 2 | 193 | 0.3770 |
| 9 | 2 | 251 | 0.4902 |
| 10 | 2 | 308 | 0.6016 |
| 11 | 2 | 379 | 0.7402 |
| 12 | 2 | 449 | 0.8770 |
| 13 | 2 | 526 | 1.0273 |
| 14 | 2 | 602 | 1.1758 |
| 15 | 4 | 340 | 1.3281 |
| 16 | 4 | 378 | 1.4766 |
| 17 | 4 | 434 | 1.6953 |
| 18 | 4 | 490 | 1.9141 |
| 19 | 4 | 553 | 2.1602 |
| 20 | 4 | 616 | 2.4063 |
| 21 | 6 | 438 | 2.5664 |
| 22 | 6 | 466 | 2.7305 |
| 23 | 6 | 517 | 3.0293 |
| 24 | 6 | 567 | 3.3223 |
| 25 | 6 | 616 | 3.6094 |
| 26 | 6 | 666 | 3.9023 |
| 27 | 6 | 719 | 4.2129 |
| 28 | 6 | 772 | 4.5234 |
| 29 | 2 | reserved | |
| 30 | 4 | reserved | |
| 31 | 6 | reserved | |

Next, an example of a method for encoding and decoding LDPC codes applied to downlink and uplink data channels in NR will be described in detail. In order to easily implement LDPC codes used in a communication system or a broadcasting system, generally, quasi-cyclic LDPC codes (or QC-LDPC codes) using a quasi-cyclic parity-check matrix are mainly used. The QC-LDPC code has the parity-check matrix configured by a zero matrix including a small square matrix or circulant permutation matrices. In this case, the permutation matrix denotes a matrix in which each row or each column includes only one 1, and all other entries are zero. In addition, the circulant permutation matrix denotes a matrix in which each entry of an identity matrix is cyclically shifted to the right or the left.

Hereinafter, the QC-LDPC code according to certain embodiments of this disclosure will be specifically described.

First, a circulant permutation matrix $P=(P_{i,j})$ having a size of $Z \times Z$ is defined by <Equation 1>. Here, $P_{i,j}$ denotes entries of an i-th row and a j-th column in the matrix P (here, $0 \leq i$, j <Z).

[Equation 1]

$$P_{i,j} = \begin{cases} 1 & \text{if } i+1 = j \mod Z \\ 0 & \text{otherwise} \end{cases}$$

For the permutation matrix P defined as above, it can be appreciated that $P^i$ ( $O \leq i < L$) is a circulant permutation matrix in which respective entries of the identity matrix having a size of $Z \times Z$ are circularly shifted to the right i times.

The parity-check matrix H of the QC-LDPC code may be expressed by <Equation 2> below.

[Equation 2]

$$H = \begin{bmatrix} P^{a_{11}} & P^{a_{12}} & \cdots & P^{a_{1n}} \\ P^{a_{21}} & P^{a_{22}} & \cdots & P^{a_{2n}} \\ \vdots & \vdots & \ddots & \vdots \\ P^{a_{m1}} & P^{a_{m2}} & \cdots & P^{a_{mn}} \end{bmatrix}$$

If $P^{-1}$ is defined as zero matrix having a size of $Z \times Z$, in Equation 2, each exponent $a_{i,j}$ of the circulant permutation matrix or zero matrix includes one of values of {-1, 0, 1, 2, ..., Z-1}. In addition, it can be appreciated that the parity-check matrix H in <Equation 2> has n column blocks and m row blocks and therefore has the size of $mZ \times nZ$.

If the parity-check matrix of <Equation 2> includes a full rank, it is obvious that the size of the information word bit of the QC-LDPC code corresponding to the parity-check matrix is (n-m)Z. For convenience, (n-m) column blocks corresponding to information word bits are called information word column blocks, and m column blocks corresponding to the remaining parity bits are called parity column blocks. In case that the parity-check matrix of <Equation 2> does not include a perfect coefficient, the information word bit has a size greater than (n-m)Z.

Generally, in the parity-check matrix of <Equation 2>, a binary matrix having a size of $m \times n$ obtained by replacing each circulant permutation matrix and the zero matrix by 1 and 0, respectively, is referred to as a mother matrix, a base matrix M (H), or a base graph having the parity-check matrix H, and an integer matrix having a size of $m \times n$ obtained by <Equation 3>, that is, by selecting the exponent of each circulant permutation matrix or zero matrix is called an exponent matrix E (H) of the parity-check matrix H.

[Equation 3]

$$E(\mathbf{H}) = \begin{bmatrix} a_{11} & a_{12} & \cdots & a_{1n} \\ a_{21} & a_{22} & \cdots & a_{2n} \\ \vdots & \vdots & \ddots & \vdots \\ a_{m1} & a_{m2} & \cdots & a_{mn} \end{bmatrix}$$

As a result, one integer included in the exponent matrix corresponds to the circulant permutation matrix or zero matrix in the parity-check matrix, and therefore, the exponent matrix may be represented by sequences of integers for convenience. (However, the zero matrix may be represented by expressions other than an integer, or may be omitted according to a predetermined rule.) In general, the parity-check matrix may be represented by various sequences having algebraically the same characteristics as well as an exponent matrix. In the disclosure, for convenience, the parity-check matrix is represented by a sequence indicating the position of "1" within the exponent matrix or the parity-check matrix. However, there are various sequence notation methods that may identify the position of "1" or "0" included in the parity-check matrix, and therefore the sequence notation is not limited to the method expressed in the specification. Therefore, there are various sequence forms showing algebraically the same effect. In order to identify the sequence from other sequences, the sequence may be referred to by various methods, such as an LDPC sequence, an LDPC code sequence, an LDPC matrix sequence, or a parity-check matrix sequence.

Further, a transmission/reception device on a device may directly generate the parity-check matrix to perform LDPC coding and decoding, but according to the feature of the implementation, the LDPC coding and decoding may also be performed using the exponent matrix or a sequence having algebraically the same effect as the parity-check matrix. Accordingly, although the disclosure describes the encoding and decoding using the parity-check matrix for convenience, it is to be noted that the encoding and decoding can be implemented through various methods capable of obtaining the same effect as the parity-check matrix on the actual device.

For reference, "algebraically the same effect" encompasses the property where two or more different representations can be explained or transformed to be perfectly identical to each other logically or mathematically.

For convenience, the disclosure describes that the number of the circulant permutation matrices corresponding to one block is only one, but the same disclosure may be applied even to the case in which several circulant permutation matrices are included in one block. For example, in case that the sum of two circulant permutation matrices $P^{a_{ij}^{(1)}}, P^{a_{ij}^{(2)}}$ is included in one i-th row block and a j-th column block as shown in the following <Equation 4>, the exponent matrix can be expressed by the following <Equation 5>. Referring to <Equation 5>, it can be seen that two integers correspond to the i-th row and the j-th column corresponding to the row block and the column block including the sum of the plurality of circulant permutation matrices.

[Equation 4]

$$\mathbf{H} = \begin{bmatrix} \ddots & & \square & & \cdots & \square & \square & & \cdot \\ \square & & P^{a_{ij}^{(1)}} + P^{a_{ij}^{(2)}} & & \square & \square \\ \square & & & & \square & \square \\ \cdot & & \square & & \square & \ddots \end{bmatrix}$$

[Equation 5]

$$E(\mathbf{H}) = \begin{bmatrix} \ddots & & \square & & \square & \cdot \\ \square & & \left( a_{ij}^{(1)}, a_{ij}^{(2)} \right) & & \square & \square \\ \square & & & & \square & \square \\ \cdot & & \square & & \square & \ddots \end{bmatrix}$$

According to the above embodiment, generally, in the QC-LDPC code, a plurality of circulant permutation matrices may correspond to one row block and one column block in the parity-check matrix, but the disclosure describes the case where one circulant permutation matrix corresponds to one block for the sake of convenience. However, embodiments according to the present disclosure are not limited thereto. For reference, a matrix having a size of $Z \times Z$ in which a plurality of circulant permutation matrices is duplicated in one row block and one column block is called a circulant matrix or a circulant.

Meanwhile, the mother matrix, the base matrix, or the base graph for the parity-check matrix and the exponent matrix of the above <Equation 4> and <Equation 5> denote a binary matrix obtained by replacing each circulant permutation matrix and the zero matrix by 1 and 0, respectively, similarly to the definition used in <Equation 2>. Here, the sum of the plurality of circulant permutation matrices (i.e., circulant matrix) included in one block is also replaced by 1.

Since the performance of the LDPC code is determined according to the parity-check matrix, there is a need to design the parity-check matrix for the LDPC code having excellent performance. Further, a method for LDPC coding and decoding capable of supporting various input lengths and code rates is required.

As used in this disclosure, lifting encompasses a method which is used not only for efficiently designing the QC-LDPC code but also for generating parity-check matrices having various lengths from a given exponent matrix or generating the LDPC codeword. That is, the lifting denotes a method which is applied in order to efficiently design a very large parity-check matrix by setting a Z-value determining the size of the circulant permutation matrix or the zero matrix from the given small mother matrix according to a specific rule, generates parity-check matrices having various lengths or generates the LDPC codeword by applying an appropriate Z value to the given exponent matrix or a sequence corresponding thereto.

In case that an LDPC code $C_0$ is given, S QC-LDPC codes to be designed by the lifting method are set to be $C_1, \ldots, C_S$, and values corresponding to sizes of row blocks and column blocks of the parity-check matrices of each QC-LDPC code are set to be Lk. Here, $C_0$ corresponds to the smallest LDPC code having the base matrix of $C_1, \ldots, C_S$ codes as the parity-check matrix and the $Z_0$ value corresponding to the size of the row block and the column block is 1.

Further, for convenience, a parity-check matrix $H_k$ of each code $C_k$ has an exponent matrix $E(H_k)=(e_{i,j}^{(k)})$ having a size of m×n and each exponent $e_{i,j}^{(k)}$ is selected as one of the values in the {-1, 0, 1, 2, ... , $Z_k$-1}.

The existing lifting method includes operations such as $C_0$->$C_1$-> . . . ->$C_S$ and has the feature satisfying conditions such as $Z_{(k+1)}=q_{(k+1)}Z_k$ (here, $q_{(k+1)}$ is a positive integer, k=0, 1, ... , S-1). Further, if only a parity-check matrix $H_s$ of $C_S$ is stored due to the feature of the lifting process, all of the QC-LDPC codes $C_0$, $C_1$, ..., $C_S$ may be expressed by the following <Equation 6> according to the lifting method.

[Equation 6]

$$E(H_k) = \left\lfloor \frac{L_k}{L_S} E(H_S) \right\rfloor$$

Or

[Equation 7]

$$E(H_k) = E(H_S) \bmod Z_k$$

In this manner, not only a method for designing QC-LDPC codes $C_1$, . . . , $C_S$ or the like greater than $C_0$ but also a method for generating small codes $C_i$ (i=k-1, k-2, ... , 1, 0) using an appropriate method such as that shown in <Equation 6> or <Equation 7> from the large code $C_k$ is called lifting.

According to the lifting method for the above <Equation 6> or <Equation 7>, $L_k$ values corresponding to the sizes of the row blocks or the column blocks of the parity-check matrices of each QC-LDPC code $C_k$ have a multiple relationship with each other, and thus the exponent matrix is also selected by a specific scheme. As described above, the existing lifting method helps facilitate the design of QC-LDPC code having improved error floor characteristics by improving the algebraic or graphical characteristics of each parity-check matrix designed by the lifting.

In general, the lifting may be considered to change the values of entries in the exponent matrix of <Equation 3> with respect to various Z values in order to use the exponent matrix for LDPC coding and decoding. For example, in case that the exponent matrix of <Equation 3> is called $E=(a_{i,j})$ and the exponent matrix transformed according to the Z value is called $E_Z=(a_{i,j}^{(Z)})$ , a transformation equation such as the following <Equation 8> may generally be applied.

[Equation 8]

$$a_{i,j}^{(Z)} = \begin{cases} a_{i,j} & a_{i,j} < 0 \\ f(a_{i,j}, Z) & a_{i,j} \geq 0 \end{cases}$$

or

$$a_{i,j}^{(Z)} = \begin{cases} a_{i,j} & a_{i,j} \leq 0 \\ f(a_{i,j}, Z) & a_{i,j} > 0 \end{cases}$$

In <Equation 8>, f (x, Z) may be defined in various forms. For example, the definitions shown in <Equation 9> below may be used.

[Equation 9]

$$f(x,Z) = \text{mod}(x, 2^{\lfloor \log_2 Z \rfloor})$$

or

$$f(x,Z) = \frac{x}{2^{D - \lfloor \log_2 Z \rfloor}}$$

or

$$f(x,Z) = \lfloor \frac{Z}{D} x \rfloor$$

In <Equation 9>, mod (a, b) denotes a modulo-b operation for a, and D denotes a constant, which is a positive integer defined in advance.

For reference, in the transformation equation of <Equation 8>, the criterion for applying the transformation equation f is represented by 0 for convenience, but the reference value may be configured differently depending on the value of the block size Z to be supported. In addition, in case that the exponent corresponding to the zero matrix is defined by excluding the same from the beginning in the expression of the exponent matrix or LDPC sequence, in <Equation 8>, the rule for values whose exponent is smaller than 0 can be omitted.

According to certain embodiments, the case of applying LDPC coding and decoding based on multiple exponent matrices or LDPC sequences on one predetermined base matrix will be described. In other words, one base matrix is fixed, an exponent matrix or sequence of LDPC codes defined on the base matrix or base graph is determined, and lifting is applied according to the block size included in each block size group from the exponent matrix or sequence, and thus variable-length LDPC coding and decoding are performed. Certain embodiments of the above-described method are characterized in that the exponent matrix of LDPC codes or the entries or numbers configuring the LDPC sequence may have different values, but the positions of the corresponding entries or numbers exactly match on the base matrix. As described above, the exponent matrix or LDPC sequences each represent the exponent of the circulant permutation matrix, which is a kind of circular shift value for bits, and enable easy identification of position of the bits corresponding to the corresponding circulant permutation matrix by configuring the positions of entries or numbers to be identical to each other. For reference, since the exponent matrix or LDPC sequence corresponds to a circular shift value of bits corresponding to block size (Z), the exponent matrix may be variously referred to as a shift matrix, a shift value matrix, a shift sequence, or a shift value sequence.

According to certain embodiments, the block size (Z) to be supported is divided into multiple block size groups (or sets) as shown in <Equation 10> below. Note that the block size Z is a value corresponding to the size of the circulant permutation matrix or the size of ZxZ of the circulant matrix in the parity-check matrix of LDPC codes.

[Equation 10]

$$Z1 = \{2, 4, 8, 16, 32, 64, 128, 256\}$$
$$Z2 = \{3, 6, 12, 24, 48, 96, 192, 384\}$$
$$Z3 = \{5, 10, 20, 40, 80, 160, 320\}$$
$$Z4 = \{7, 14, 28, 56, 112, 224\}$$
$$Z5 = \{9, 18, 36, 72, 144, 288\}$$
$$Z6 = \{11, 22, 44, 88, 176, 352\}$$
$$Z7 = \{13, 26, 52, 104, 208\}$$
$$Z8 = \{15, 30, 60, 120, 240\}$$

size group of <Equation 10> may be used, or block size values included in an appropriate subset may be used as shown in <Equation 11> below. In addition, appropriate values may be added or excluded from the block size group (or set) of <Equation 10> or <Equation 11>.

[Equation 11]

$$Z1' = \{8, 16, 32, 64, 128, 256\}$$
$$Z2' = \{12, 24, 48, 96, 192, 384\}$$
$$Z3' = \{10, 20, 40, 80, 160, 320\}$$
$$Z4' = \{14, 28, 56, 112, 224\}$$
$$Z5' = \{9, 18, 36, 72, 144, 288\}$$
$$Z6' = \{11, 22, 44, 88, 176, 352\}$$
$$Z7' = \{13, 26, 52, 104, 208\}$$
$$Z8' = \{15, 30, 60, 120, 240\}$$

According to certain embodiments, the block size groups of <Equation 10> and <Equation 11> are characterized in that they have different granularities but the ratios of neighboring block sizes are all identical integers. In other words, the block sizes included in one group are divisors or multiples of each other. If it is assumed that the exponential matrices corresponding to p-th (p=1, 2, . . . , 8) group are $E_p = (e_{i,j}^{(p)})$ and that the exponential matrices corresponding to Z values included in the p-th group are $E_p(Z) = (e_{i,j}(Z))$, the sequence transform method expressed in <Equation 8> is applied using $f_p(x, Z) = x(\mathrm{mod}Z)$. For example, if the block size Z is determined as Z=28, respective entries $e_{i,j}(28)$ of the exponent matrix (or LDPC sequence) $E_p(20) = e_{i,j}(28)$ for Z=28 can be obtained as in <Equation 12> below with respect to the exponent matrix (or LDPC sequence) $E_4 = (e_{i,j}^{(4)})$ corresponding to the 4-th block size group in which Z=28 is included.

[Equation 12]

$$e_{i,j}(28) = \begin{cases} e_{i,j}^{(4)} & e_{i,j}^{(4)} \leq 0 \\ e_{i,j}^{(4)} \pmod{28} & e_{i,j}^{(4)} > 0 \end{cases}$$

or

$$e_{i,j}(28) = \begin{cases} e_{i,j}^{(4)} & e_{i,j}^{(4)} < 0 \\ e_{i,j}^{(4)} \pmod{28} & e_{i,j}^{(4)} \geq 0 \end{cases}$$

The transformation of <Equation 12> may be simply expressed as <Equation 13> below.

[Equation 13]

$$E_p(Z) = E_p(\mathrm{mod}\,Z),\ Z \in Z_p$$

For reference, although an explanation has been made on the assumption that lifting or transforming the exponent matrix expressed in Equations 8, 9 or 10 to 13 is applied to the whole exponent matrix corresponding to the parity check matrix, it is also applicable to a part of the exponent matrix. For example, it is general for the sub-matrix corresponding to the parity bits of the parity check matrix to have a special structure for efficient encoding. In this case, the encoding method or complexity may be changed due to the lifting. Accordingly, in order to maintain the same encoding method or complexity, with respect to a part of the exponent matrix for the sub-matrix corresponding to the parity in the parity check matrix, the lifting may not be applied, or a lifting method different from the lifting method applied to the exponent matrix for the sub-matrix corresponding to information word bits may be applied. In other words, the lifting method applied to the sequence corresponding to the information word bits in the exponent matrix and the lifting method applied to the sequence corresponding to the parity bits may be configured differently, and depending on the circumstances, the lifting is not applied to a part or all of the sequence corresponding to the parity bit, and thus a fixed value may be used without a sequence transform.

Examples of a method for applying various block sizes based on QC-LDPC codes in a communication system or a broadcasting system supporting LDPC codes of various lengths according to various embodiments of this disclosure have been described. In general, in case that an appropriate sequence is transformed and used for various block sizes of Z from one LDPC exponent matrix or sequence, such as the lifting method described in Equations 8 and 9, there are many advantages, because the system only has to be implemented in one or a small number of sequences.

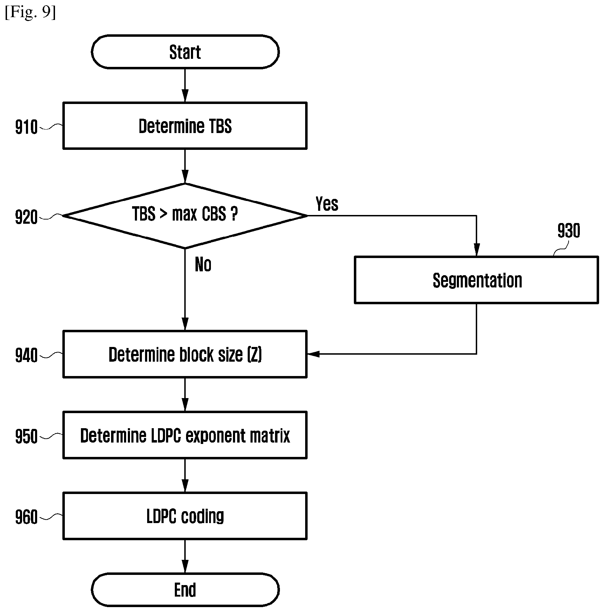

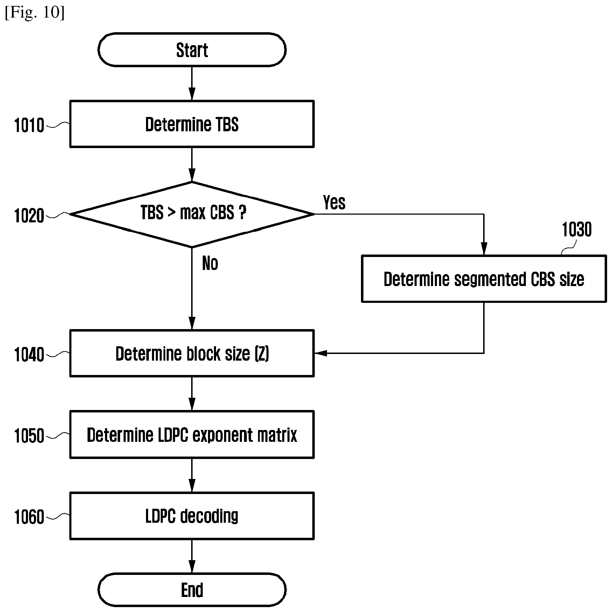

FIG. 9 and FIG. 10 illustrate examples of a process of LDPC coding and decoding based on a base matrix or an exponent matrix according to certain embodiments of this disclosure.

FIG. 9 illustrates an example of an LDPC coding method according to certain embodiments of this disclosure.

Referring to the non-limiting example of FIG. 9, first, the transmitter identifies a transport block size (TBS) to be transmitted, as in operation 910 of FIG. 9. Then, in operation 920, the transmitter determines whether the TBS is greater than or equal to or smaller than the maximum code block size (CBS).

If the TBS is greater than the maximum CBS, in operation 930, the transmitter performs segmentation of the transport block to determine a new CBS, and if the TBS is smaller than or equal to the CBS, the segmentation operation is omitted and the TBS is determined as the CBS.

In operation 940, the transmitter determines a block size (Z) value to be applied to LDPC coding, based on the CBS. In operation 950, the transmitter appropriately determines an LDPC exponent matrix or sequence according to the TBS, the CBS, or the block size (Z) value. Next, in operation 960, the transmitter performs LDPC coding based on the determined block size, exponent matrix, or sequence. Operation 950 may include a process of transforming the determined LDPC exponent matrix or sequence based on the determined block size in some cases. It is obvious that the LDPC exponent matrix, the sequence, or the parity-check matrix for LDPC coding may be determined in various ways based on the TBS or the CBS depending on the system. For example, a base matrix may be first determined based on the TBS, an LDPC exponent matrix or a sequence parity-check matrix may be determined based on the determined base matrix and CBS, or various other methods may also be applied.

The LDPC decoding process may be similar to that illustrated in FIG. 10. FIG. 10 illustrates an embodiment of an LDPC decoding process according to certain embodiments of this disclosure.

The receiver may receive a signal corresponding to a transport block transmitted by the transmitter. In operation 1010, the receiver may determine a TBS based on the received signal. Next, in operation 1020, the transmitter determines whether the TBS is greater than or smaller than or equal to the maximum CBS, and if the TBS is greater than the maximum CBS, the transmitter determines the size of the CBS to which segmentation is applied in operation 1030. If it is determined that TBS is smaller than or equal to the maximum CBS, the TBS is determined to be the same as the CBS. Here, since the maximum CBS may differ depending on the base matrix or parity-check matrix used for LDPC coding, a process (not shown) of determining the maximum CBS according to the TBS or code rate may be additionally required.

As shown in the illustrative example of FIG. 10, at operation 1040, the receiver determines a block size (Z) value to be applied to LDPC decoding, and then in operation 1050, the receiver appropriately determines an LDPC exponent matrix or sequence based on the TBS, the CBS, or block size (Z) value. Next, in operation 1060, the receiver may perform LDPC decoding using the determined block size, exponent matrix, or sequence. Operation 1050 may include a process of transforming the determined LDPC exponent matrix or sequence based on the determined block size in some cases.

According to the above example, the processes of determining the exponent matrix or sequence of LDPC codes in operations 950 and 1050 of FIGS. 9 and 10 are described based on at least one of TBS, CBS, and block size (Z). However, various other methods may exist. For example, the exponent matrix or sequence may be determined based on at least one of TBS and code rate. Specifically, the base matrix is first determined based on the TBS or the code rate, the maximum CBS is determined based on the determined base matrix, the CBS is determined based on the maximum CBS, and then the block size Z, the LDPC exponent matrix, or the sequence parity-check matrix may be determined based on the determined CBS. In addition, various other methods may also be applied.

According to certain embodiments of this disclosure, the LDPC coding and decoding process based on the base matrix and exponent matrix (or LDPC sequence) of the LDPC codes of FIGS. 9 and 10, some of information word bits are shortened appropriately for the LDPC code and some of codeword bits are punctured and repeated, and thus LDPC coding and decoding of various code rates and various lengths may be supported. For example, in the examples of FIGS. 9 and 10, in the case where some of the information word bits are shortened in the base matrix or exponent matrix determined for LDPC coding and decoding, and then some of information word bits corresponding to the first two column blocks in the parity-check matrix or a part of a code block are punctured, some parities are punctured, or some of the LDPC codewords are repeated, various lengths of information words and the code block and various code rates may be supported.

In addition, in case that a variable information word length or a variable coding rate is supported using the shortening or zero-padding of the LDPC code, the code performance may be improved according to the order or method for shortening. If the shortening order is already configured, the encoding performance may be improved by rearranging all or part of the given base matrix. In addition, the performance may be improved by appropriately determining a block size or the number of column blocks to which the shortening is to be applied with respect to a specific information word length (or code block length CB).

In general, the coding rate of the LDPC code may be adjusted by differently applying puncturing of codeword bits according to the coding rate (this is also commonly referred to as rate matching). In case that parity bits corresponding to a column of degree 1 are punctured in the LDPC code, the LDPC decoder may perform decoding without using part or all of the corresponding part in the parity check matrix. Therefore, there is an advantage of reducing decoding complexity. However, in the case of considering the coding performance, embodiments of a method for improving the performance of the LDPC codes by adjusting the puncturing order of parity bits or the transmission order of the generated LDPC codeword are provided herein. For example, it is possible to support better performance in case that some of information word bits and parity bits are appropriately punctured than in the case of simply supporting the variable code rate by puncturing the parity bits. In addition, LDPC coding performance may be improved by appropriately determining the order in advance in case that repetition of some of the LDPC codeword bits is performed in order to support a lower code rate.

In the parity-check matrix of LDPC codes, the degree denotes the number of nonzero entries in the column or row. For example, in the parity-check matrix, the number of nonzero entries in a column may be represented by the degree of the corresponding column or the weight of the column, and the number of nonzero entries in a row may be represented by the degree of the row or the weight of the row.

Generally, in the LDPC coding process, the transmitter may first determine the number (or size) of input bits (or code blocks) to which LDPC coding is to be applied, determine the block size (Z) to which the LDPC coding is applied according to the number of input bits (or code blocks), determine a suitable LDPC exponent matrix or sequence according to the determined block size, and then perform the LDPC coding based on the block size (Z) and the determined exponent matrix or LDPC sequence. In this case, the LDPC exponent matrix or sequence may be applied to the LDPC coding without transform, or LDPC coding may be performed by appropriately transforming the LDPC exponent matrix or sequence according to the block size (Z) in some cases. Similarly, in the LDPC decoding process, the receiver may determine the number (or size) of input bits (or code blocks) of the transmitted LDPC codewords, determine the block size (Z) to which the LDPC decoding is applied according to the number of input bits (or code blocks), determine a suitable LDPC exponent matrix or sequence according to the determined block size, and then perform the LDPC decoding based on the block size (Z) and the determined exponent matrix or LDPC sequence. In this case, the LDPC exponent matrix or sequence may be applied to the LDPC decoding without transform, or LDPC decoding may be performed by appropriately transforming the LDPC exponent matrix or sequence according to the block size (Z) in some cases. For reference, in the disclosure, the input bits may denote LDPC information word bits, bits configuring a transport block, bits obtained by adding a CRC to a transport block, or bits configuring a code block.

If two or more basic matrices are configured in the system, a process of determining a base matrix based on various parameters, such as the number of input bits, TBS or CBS values, or code rates to which LDPC coding may be added (or applied) before determining the LDPC exponent matrix or sequence according to the block size in the LDPC coding and decoding process.

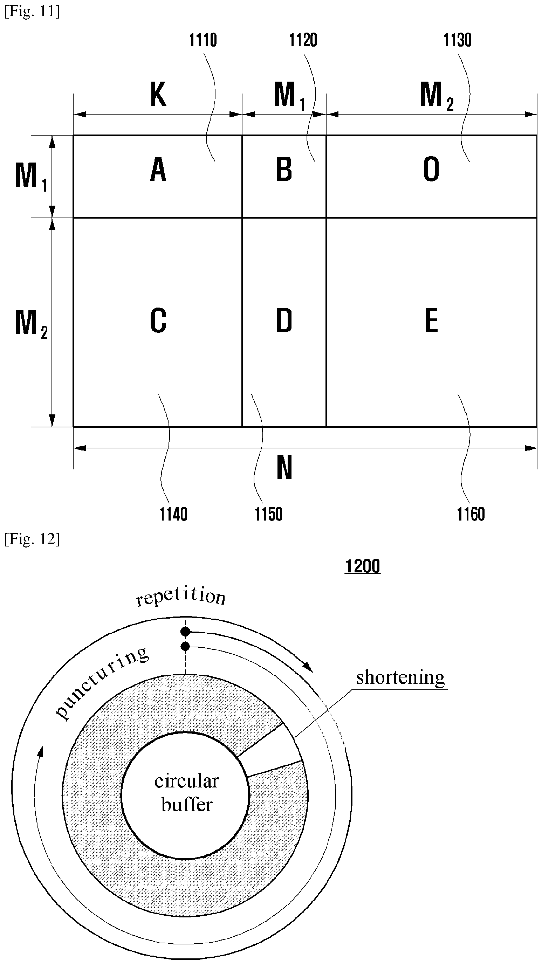

FIG. 11 illustrates an example of a general structure of a parity-check matrix of LDPC codes applied to a channel encoder and a channel decoder according to some embodiments of this disclosure.

In the parity-check matrix in the illustrative example of FIG. 11, the number of columns is N and the number of rows is ($M_1 + M_2$). In general, in case that the parity-check matrix has a full rank, the number of columns corresponding to information word bits in the parity-check matrix is equal to the number obtained by subtracting the total number of rows from the total number of columns. That is, if the parity-check matrix in FIG. 9 has a full rank ($M_1+M_2$), it may denote that the number K of information word bits is to be N-($M_1+M_2$). In the disclosure, for convenience, only the case where the parity-check matrix in FIG. 9 has a full rank is described, but the disclosure is not limited thereto.

First, the parity-check matrix of FIG. 11 may be divided into a first part of the parity-check matrix configured by sub-matrices A 1110 and B 1120, and a second part of the parity-check matrix configured by sub-matrices C1140, D 1150, and E 1160.

Sub-matrix O 1130 may be a zero matrix having a size of ($M_1 \times M_2$). Even if the sub-matrix O 1130 is included in the first part of the parity-check matrix, it has no effect on the operation of the matrix because the sub-matrix O 1130 is a zero matrix having a size of ($M_1 \times M_2$). For this reason, the disclosure, for convenience, defines a matrix configured by sub-matrices A 1110 and B 1120 except for sub-matrix O 1130, which is a zero matrix having a size of ($M_1 \times M_2$), as the first part of the parity-check matrix. If necessary, the first part of the parity-check matrix may include the sub-matrix O 1130.

For convenience, in FIG. 11, if the parity-check matrix is called H, information word bits (or information word bit vectors) corresponding to the sub-matrix A 1110 or C 1140 are called $i=(i_0,i_1,...,i_{K-1})$, the first parity bits (or first parity bit vector) corresponding to the sub-matrix B 1120 or D 1150 are called $p_1=(p_{1,0},p_{1,1},...,p_{1,M1-1})$, and the second parity bits (or second parity bit vector) corresponding to sub-matrix E 1160 are called $p_2=(p_{2,0},p_{2,1},...,p_{2,M2-1})$, <Equation 14> may be satisfied as follows.

[Equation 14]

$$H \cdot c^T = H \cdot \begin{bmatrix} i^T \\ p_1^T \\ p_2^T \end{bmatrix} = \begin{bmatrix} A & B & O \\ C & D & E \end{bmatrix} \cdot \begin{bmatrix} i^T \\ p_1^T \\ p_2^T \end{bmatrix}$$

$$= \begin{cases} A \cdot i^T + B \cdot p_1^T = 0 \\ C \cdot i^T + D \cdot p_1^T + E \cdot p_2^T = 0 \end{cases}$$

Referring to the example provided in <Equation 14>, it may be seen that the first parity vector $p_1$ may be determined based on the information word bit vector i and the first part of the parity-check matrix. Further, the parity vector $p_2$ may be determined based on the information word bit vector i, the parity vector $p_1$, and the second part of the parity-check matrix.

The disclosure may limit the structural features of the parity check matrix corresponding to FIG. 11 by using at least one of the following characteristics

Feature 1: The column weights (i.e., column degree) of the sub-matrix B 1120 of FIG. 11 are all 2 or more, and the column weights for at least one column are 3 or more. In addition, not all column weights or all row weights are even numbers (that is, the degree of one or more columns or one or more rows is an odd number).

Feature 2: In case that the parity-check matrix of FIG. 11 is defined as a quasi-cyclic parity-check matrix, at least one column block in the sub-matrix B 1120 in the feature 1 may have a column weight of 3 or more. In addition, the degrees of all column blocks or the degrees of all row blocks are not even numbers (that is, the degrees of one or more column blocks or row blocks are odd numbers).

Feature 3: The column weight and row weight of the sub-matrix E 1160 of FIG. 11 are both 1. Therefore, E 1160 may be an identity matrix or may be transformed to an identity matrix by applying an appropriate column permutation or row permutation (that is, E 1160 is an identity matrix or has a feature equivalent thereto). If the parity-check matrix of FIG. 11 is defined as a quasi-cyclic parity-check matrix, the sub-matrix E 1160 may be divided into multiple identity matrices.

In the illustrative example of FIG. 11, a sub-matrix configured by $M_2$ columns having degree 1 corresponding to E 1160 may be regarded as a single parity-check code, and may be easily extended. That is, the parts corresponding to C 1140, D 1150, and E 1160 of FIG. 11 may be configured to a form extending the parity-check matrix having a single parity check code, and since $N = K + M_1 + M_2$, it is noted that the codeword length N also increases as $M_2$ increases.

In the LDPC coding process, rate mapping may be necessary according to the allocated resources and requirements of the system.

FIG. 12 illustrates an example of rate mapping based on a circular buffer according to certain embodiments of this disclosure.

As shown in reference numeral 1200 of the illustrative example of FIG. 12, the LDPC coding process may include performing rate matching appropriately through operations such as appropriate shortening, puncturing, and repetition, as well as LDPC coding based on a parity-check matrix.

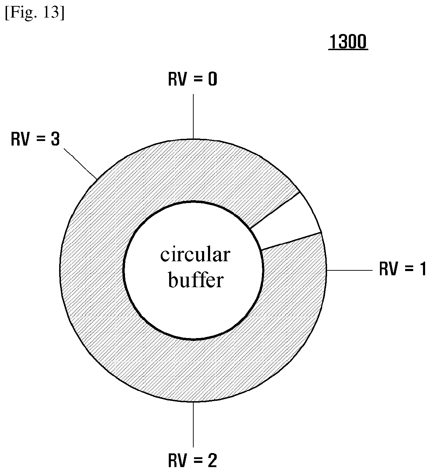

FIG. 13 illustrates an example of a redundancy version (RV) value corresponding to the circular buffer of FIG. 12 according to certain embodiments of this disclosure. According to some embodiments, the RV may be applied in order to optimize performance at the time of supporting a retransmission operation such as HARQ in a turbo encoding scheme.

Existing RV values have been defined at regular intervals on the circular buffer, but, referring to reference numeral 1300 of FIG. 13, the RV value may have an irregular characteristic. In particular, the interval between RV = 3 and RV = 0 is relatively small, and is a value obtained by considering the self-decodability of the channel code. In general, since information word bits, that is, code blocks or transport blocks, to which channel coding is applied based on RV = 0 are allocated by a transmitter, in case that transmission is performed based on RV = 0, successful decoding is possible by applying appropriate MCS. However, in case that the transmitter performs transmission based on RV = 1 or RV = 2, since most of the transmitted data is configured by parities, sometimes decoding is impossible even if the MCS is well controlled. On the other hand, in the case of appropriately configuring RV = 3 of FIG. 13, since the information word bits, that is, the code blocks or transport blocks to which the channel coding is applied, are always transmittable, successful decoding may be possible if the MCS is well controlled.

At the time of transmitting the result obtained from channel encoding based on a specific RV value, the case in which decoding is impossible, even if the MCS is controlled or the received signal-to-noise ratio (SNR) is large, indicates that there is no self-decodability. On the other hand, if decoding is possible without additional parity or other additional information, it indicates that there is self-decodability.

As described above, the RV concept is introduced in order to improve performance of retransmission such as HARQ, but may be applied to various service scenarios in addition to retransmission.

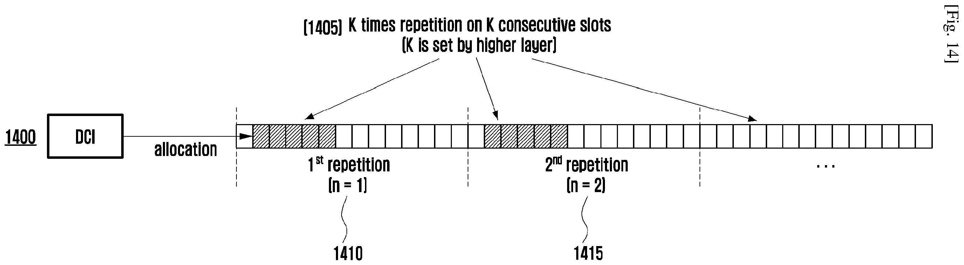

FIG. 14 illustrates an example of slot aggregation for each slot in a wireless communication system according to certain embodiments of this disclosure.

Referring to the non-limiting example of FIG. 14, in NR, repetitive transmission of the same PDSCH may be supported in order to improve the reliability of PDSCH reception of a UE (indicated by reference numeral 1400). The base station may configure the number of repetitive transmissions of the PDSCH, for example, pdsch-AggregationFactor in PDSCH-Config via higher layer such as RRC.

In case that the number of repetitive transmissions is set, the PDSCH scheduled by DCI may be repeatedly transmitted in a number of slots that is the same as the number of consecutive repetition transmissions (indicated by reference numeral 1405). All PDSCHs that are repeatedly transmitted may receive allocation of the same time resource in a slot, and the allocation corresponds to the OFDM symbol start position 7-00 and length 7-05 in one slot indicated by DCI, as shown in FIG. 7. In addition, it may be assumed that the same transport block is transmitted to all PDSCHs that are repeatedly transmitted. The UE may expect that the repeatedly transmitted PDSCH is transmitted via only a single layer. In addition, the RV of the repeatedly transmitted PDSCH may be determined according to the RV value indicated by the DCI scheduling the PDSCH and the index of the repeatedly transmitted PDSCH, as shown in the table below.

[Table 14-1]

| $rv_{id}$ indicated by the DCI scheduling the PDSCH | $rv_{id}$ to be applied to $n^{th}$ transmission occasion | | | |
|---|---|---|---|---|
| | $n$ mod 4 = 0 | $n$ mod 4 = 1 | $n$ mod 4 = 2 | $n$ mod 4 = 3 |
| 0 | 0 | 2 | 3 | 1 |
| 2 | 2 | 3 | 1 | 0 |
| 3 | 3 | 1 | 0 | 2 |
| 1 | 1 | 0 | 2 | 3 |

In the above table, n may indicate an index for each PDSCH within the number of repetitive transmissions determined by the higher layer (indicated by reference numerals 1410 and 1415).

Meanwhile, in NR, the same PUSCH repetitive transmission may be supported in order to improve the reliability of PUSCH reception. The base station may configure the number of repetitive transmissions of the PUSCH, for example, pdsch-AggregationFactor in PUSCH-Config, via a higher layer such as RRC, and in case that the number of repetitive transmissions is set, the PUSCH scheduled by DCI may be repeatedly transmitted in a number of slots that is the same as the number of consecutive repetition transmissions. All PUSCHs that are repeatedly transmitted may receive allocation of the same time resource in a slot, and the allocation corresponds to the OFDM symbol start position 7-00 and length 7-05 in one slot indicated by DCI. In addition, it may be assumed that the same transport block is transmitted to all repeatedly transmitted PUSCHs. The UE may expect that a repeatedly transmitted PUSCH is transmitted via only a single layer. In addition, the RV of the repeatedly transmitted PUSCH may be determined according to the RV value indicated by the DCI scheduling the PUSCH and the index of the repeatedly transmitted PUSCH, as shown in the table below. In the disclosure, for convenience, the feature wherein a transmission block is transmitted through a PUSCH is expressed as a PUSCH transmission. In addition, the transmission may be applied equally to other channels.

[Table 14-2]

| $rv_{id}$ indicated by the DCI scheduling the PUSCH | $rv_{id}$ to be applied to $n^{th}$ transmission occaion | | | |
|---|---|---|---|---|
| | $n$ mod 4 = 0 | $n$ mod 4 = 1 | $n$ mod 4= 2 | $n$ mod 4 = 3 |
| 0 | 0 | 2 | 3 | 1 |
| 2 | 2 | 3 | 1 | 0 |
| 3 | 3 | 1 | 0 | 2 |
| 1 | 1 | 0 | 2 | 3 |

According to certain embodiments, if the PUSCH repetitive transmission is performed based on the configured grant, the RV sequence of the repeatedly transmitted PUSCH may be indicated via the higher layer configuration by the base station, and the corresponding RV sequence may be one of, for example, {0, 2, 3, 1}, {0, 3, 0, 3}, and {0, 0, 0,0}.

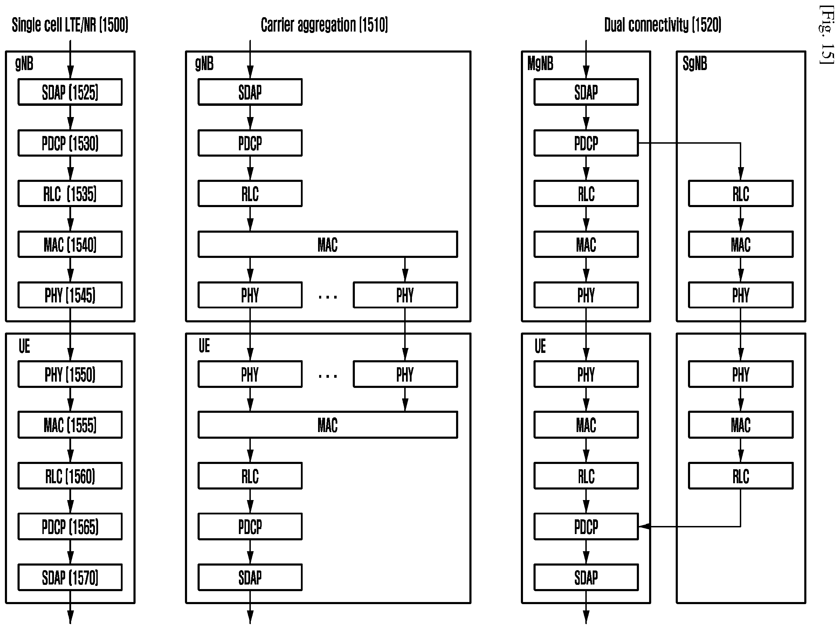

FIG. 15 illustrates an example of protocol structure of a base station and a UE radio at the time of performing single-cell connection, carrier aggregation, and dual connectivity according to some embodiments.

Referring to the non-limiting example of FIG. 15, a radio protocol of a next-generation mobile communication system is configured by service data adaptation protocols (NR SDAPs) 1525 and 1570, NR packet data convergence protocols (NR PDCPs) 1530 and 1565, NR radio link controls (RLCs) 1535 and 1560, and NR medium access controls (MACs) 1540 and 1555, in a UE and an NR base station, respectively.

The main functions of the NR SDAPs 1525 and 1570 may include some of the following functions.

- Transfer of user plane data
- Mapping between a QoS flow and a data bearer (DRB) for both uplink (UL) and downlink (DL)
- Marking QoS flow ID in both UL and DL packets
- Mapping reflective QoS flow to data bearer for UL SDAP PDUs.

According to some embodiments, a UE may receive a configuration, such as whether to use the header of an SDAP layer device or the function of the SDAP layer device, through an RRC message, for each PDCP layer device, for each bearer, or for each logical channel. If the SDAP header is configured, the UE may be indicated to update or reconfigure mapping information between a QoS flow and a data bearer for the uplink and downlink, via a NAS QoS reflection configuration 1-bit indicator (NAS reflective QoS) and AS QoS reflection configuration 1-bit indicator (AS reflective QoS) of the SDAP header. The SDAP header may include QoS flow ID information indicating QoS. The QoS information may be used as data processing priority, scheduling information, and the like in order to support smooth services.

The main function of the NR PDCPs 1530 and 1565 may include some of the following functions.

- Header compression and decompression (ROHC only)
- Transfer of user data
- In-sequence delivery of higher layer PDUs
- Out-of-sequence delivery of higher layer PDUs
- PDCP PDU reordering for reception
- Duplicate detection of lower layer SDUs
- Retransmission of PDCP SDUs
- Ciphering and deciphering
- Timer-based SDU discard in uplink

The reordering function of the NR PDCP device is a function of sequentially reordering PDCP PDUs, received from a lower layer, based on a PDCP sequence number (SN), and may include a function of transmitting data to a higher layer in the sequence of reordering, a function of directly transmitting data to a higher layer without taking the sequence into consideration, a function of reordering the sequence and recording missing PDCP PDUs, a function of providing a state report on the missing PDCP PDUs to a transmission side, and a function of requesting retransmission of the missing PDCP PDUs.

The main functions of the NR RLCs 1535 and 1560 may include some of the following functions.

- Transfer of higher layer PDUs
- In-sequence delivery of higher layer PDUs
- Out-of-sequence delivery of higher layer PDUs
- Error Correction through ARQ
- Concatenation, segmentation and reassembly of RLC SDUs
- Re-segmentation of RLC data PDUs
- Reordering of RLC data PDUs
- Duplicate detection
- Protocol error detection
- RLC SDU discard
- RLC re-establishment

According to certain embodiments, the in-sequence delivery function of the NR RLC device refers to a function of transmitting RLC SDUs, received from a lower layer, to a higher layer in the sequence of reception, and may include, if one RLC SDU is originally segmented into multiple RLC SDUs and received, a function of reassembling and transmitting the multiple RLC SDUs. The in-sequence delivery function may include a function of reordering the received RLC PDUs based on an RLC sequence number (SN) or PDCP SN, reordering the sequence and recording missing RLC PDUs, providing a state report on the missing RLC PDUs to a transmission side, and requesting retransmission of the missing RLC PDUs. Alternatively, the in-sequence delivery function of the NR RLC device may include a function of sequentially transmitting only the RLC SDUs prior to the missing RLC SDU to a higher layer if the missing RLC SDU occurs, sequentially transmitting all RLC SDUs received before a timer starts to a higher layer if the timer expires even though there is a missing RLC SDU, or sequentially transmitting all RLC SDUs received so far to a higher layer if a predetermined timer expires although there is a missing RLC SDU. In addition, the RLC PDUs may be processed in the sequence in which the RLC PDUS are received (in the sequence of arrival regardless of serial numbers or sequence numbers), and may be delivered out of sequence to a PDCP device. The in-sequence delivery function may include a function of receiving segments stored in a buffer or segments to be received later, reconfiguring the segments into one complete RLC PDU, processing the RLC PDU, and transmitting the RLC PDU to the PDCP device. The NR RLC layer may not include a concatenation function, and the concatenation function may be performed by the NR MAC layer or may be replaced by a multiplexing function of the NR MAC layer.

In some embodiments, the out-of-sequence delivery function of the NR RLC device is a function of directly transmitting the RLC SDUs, received from the lower layer, to a higher layer regardless of the order thereof, and may include, if one RLC SDU has been originally segmented into multiple RLC SDUs and received, a function of reassembling the multiple RLC SDUs and transmitting the same, and a function of storing the RLC SNs or PDCP SNs of the received RLC PDUs, reordering the sequence, and recording the missing RLC PDUs.

The NR MACs 1540 and 1555 may be connected to multiple NR RLC layer devices configured in one UE, and the main functions of the NR MAC may include some of the following functions.

- Mapping between logical channels and transport channels
- Multiplexing/demultiplexing of MAC SDUs
- Scheduling information reporting
- Error correction through HARQ
- Priority handling between logical channels of one UE
- Priority handling between UEs by means of dynamic scheduling
- MBMS service identification
- Transport format selection
- Padding

The NR PHY layers 1545 and 1550 may perform operations of channel-coding and modulating higher layer data, forming the higher layer data into an OFDM symbol, transmitting the OFDM symbols via a radio channel, or demodulating and channel decoding the OFDM symbols received via the radio channel, and of transferring the OFDM symbol to a higher layer.

The detailed structure of the radio protocol structure may vary depending on the carrier (or cell) operation method. For example, in case that a base station transmits data to a UE based on a single carrier (or cell), the base station and the UE use a protocol structure having a single structure for each layer, as indicated by reference numeral 1500. On the other hand, in case that a base station transmits data to a UE based on carrier aggregation (CA) using multiple carriers in a single TRP, the base station and the UE have a single structure for RLC, as indicated by reference numeral 1510, but use a protocol for multiplexing the PHY layer through the MAC layer. According to another example, in case that a base station transmits data to a UE based on dual connectivity (DC) using multiple carriers in multiple TRPs, the base station and the UE have a single structure for RLC, as indicated by reference numeral 1520, but use a protocol structure for multiplexing the PHY layer through the MAC layer.

Referring to the description of the DCI structure, PDSCH time/frequency resource assignment, and PDSCH transmission and reception procedures performed based on the DCI structure and the PDSCH time/frequency resource assignment, in release 15 of NR standard document, NR may use only a single transmission point/panel/beam at the time of single/repetitive transmission of PDSCH. If cooperative communication using multiple transmission points/panels/beams may be applied at the time of PDSCH transmission, more robust performance may be obtained, including for example channel blockage, so transmission techniques involving multiple transmission points/ panels/beams are actively being discussed in NR release 16.

Here, in case that LDPC coding is applied and transmitted to the same code block or transport block for each TRP/beam, the reception performance of the UE may vary according to the RV value for each TRP. If the same RV value is applied, the effect on the receiving terminal is similar to that obtained using repetition code. That is, since chase combining is simply applied to signals received from each TRP, it is (almost) impossible to obtain additional coding gain except for a diversity gain.

On the other hand, if different RV values are appropriately used, additional coding gain may be obtained, in addition to diversity gain. For example, one TRP (a first TRP) may perform transmission using an existing rate matching scheme, and the other TRP (second TRP) may apply a different rate matching scheme. As a specific example, in case that the first TRP transmits a modulation signal generated based on an existing rate matching scheme based on RV = 0 and the second TRP transmits a modulation signal which is generated by applying rate matching based on a value other than RV = 0, since the receiving terminal receives modulated signals corresponding to different LDPC-coded bits from the first TRP and the second TRP, an effect similar to that of incremental redundancy (IR) is obtained, and thus a coding gain superior to the chase combination can be expected.

According to certain embodiments of this disclosure, in the case of transmitting a signal by applying different RV patterns in different TRPs, a coding gain may be obtained at a receiving terminal, and the coding gain may differ according to the RV pattern. The reason is described below.

According to some embodiments, the RV value is assumed to be configured as shown in FIG. 13 and an existing rate matching scheme is applied thereto based on the first TRP. Further, LDPC-coded bits for code blocks or transport blocks are assumed to be modulated from RV = 0 to RV = 2 in a circular buffer and transmitted in the first TRP. In this case, if rate matching is applied based on RV = 1 in the second TRP, at least some of the LDPC-coded bits between RV = 1 and RV = 2 are used in the first TRP and the second TRP is simultaneously transmitted and thus a loss in coding gain may occur.

On the other hand, in case that rate matching is applied based on RV = 2 in the second TRP, almost no LDPC-coded bits are transmitted in a duplicate manner in the first TRP and the second TRP, and thus the coding gain may be improved.

According to another example, the RV value is assumed to be configured as shown in the illustrative example of FIG. 13 and the existing rate matching method is applied based on the first TRP. It is further assumed that the LDPC-coded bits for the code block or transport block are transmitted in the first TRP from RV = 0 to a specific point between RV = 1 and RV = 2. In particular, some parity bits of degree 2 or higher in the parity-check matrix of LDPC codes are assumed to be punctured because the LDPC code rate for the transport block is very high (the parity bits denote parity bits corresponding to B 1120 and D 1150 in FIG. 11). In this case, even if rate matching is applied based on RV = 1 in the second TRP, since few parity bits are transmitted in a duplicate manner and a punctured parity bit of degree 2 or higher is reconstructable, excellent coding gain is expected. On the other hand, if rate matching is applied based on RV = 2 in the second TRP, no LDPC-coded bits are transmitted in a duplicate manner in the first TRP or the second TRP, but a significant number of parity bits of degree 2, received at the receiving terminal, are in a punctured state, and thus loss of coding gain may occur. This problem may be more severe as the coding rate increases.

Accordingly, certain embodiments according to this disclosure comprise a method for improving reception reliability by optimally selecting RV for each beam/TRP at the time of transmitting data through multiple beams/TRPs. For the convenience of description, the disclosure is focused on a multi-beam/TRP downlink environment, but is applicable to other environments in which a code block or a transport block to which LDPC coding is applied are repeatedly transmitted, for example, a multi-beam/TRP uplink environment and single TRP downlink and uplink environments.

Hereinafter, certain embodiments of the disclosure will be described in detail with reference to the accompanying drawings. In addition, in describing the disclosure, if it is determined that a detailed description of related functions or configurations may unnecessarily obscure the subject matter of the disclosure, the detailed description will be omitted. In addition, terms to be described below are terms defined in consideration of functions in the disclosure, and may differ according to a user's or operator's intention or practice. Therefore, the definition should be made based on the contents throughout the specification.

In the following non-limiting examples, the base station is the entity that performs resource assignment to a terminal, and may be at least one of a gNode B, a gNB, an eNode B, a Node B, a base station (BS), a radio access unit, a base station controller, or a node on a network. The terminal may include a user equipment (UE), a mobile station (MS), a cellular phone, a smart phone, a computer, or a multimedia system capable of performing a communication function. In addition, hereinafter, embodiments describe NR or LTE/LTE-A systems by way of example, but embodiments of the disclosure may be applied to other communication systems having similar technical backgrounds or channel types. In addition, the embodiments of the disclosure may be applied to other communication systems through some modifications within a range that does not significantly depart from the scope of the disclosure as determined by a person skilled in the art.

The following details provided in the disclosure are applicable, without limitation, to FDD and TDD systems.

Hereinafter, in the disclosure, higher layer signaling encompasses a signal transmission method that is transmitted from a base station to a UE using a downlink data channel of a physical layer or is transmitted from a UE to a base station using an uplink data channel of a physical layer, and may be referred to as RRC signaling, PDCP signaling, or a medium access control (MAC) control element (CE) (MAC CE).

Hereinafter, in the disclosure, in determining whether to apply cooperative communication, a UE may use various methods in which a PDCCH(s) allocating a PDSCH to which cooperative communication is applied has a specific format, the PDCCH(s) allocating a PDSCH to which cooperative communication is applied includes a specific indicator indicating whether to apply cooperative communication, the PDCCH(s) allocating the PDSCH to which the cooperative communication is applied is scrambled using a specific RNTI, or cooperative communication is assumed in a specific section indicated by a higher layer. Hereinafter, for convenience of description, reception of the PDSCH to which the cooperative communication is applied, by the UE, based on conditions similarly to the above will be referred to as an NC-JT case.

Hereinafter, in certain embodiments according to the disclosure, determining the priority between A and B may be performed in various ways, such as, selecting one having a higher priority according to a predetermined priority rule and performing an operation corresponding thereto or omitting or dropping an operation related to one having a lower priority.

Hereinafter, in the disclosure, a plurality of embodiments is described in order to explain the examples in the above, but the embodiments are not independent, but one or more embodiments can be applied simultaneously or in combinations thereof.

<First embodiment: DCI reception for NC-JT>

The 5G wireless communication system may support not only services requiring a high transmission rate, but also services having a very short transmission latency and services requiring high connection density. In a wireless communication network including multiple cells, transmission and reception points (TRPs), or beams, coordinated transmission between respective cells, TRPs, and/or beams is one of element technologies that may satisfy various service requirements by increasing the strength of a signal received by the UE or efficiently performing interference control between respective cells, TRPs, and/or beams.

Joint transmission (JT) is a representative example of a transmission technology for cooperative communication described above, and supports one UE via different cells, TRPs, and/or beams through a joint transmission technology so as to increase the strength of a signal received by the UE. However, since a channel between the UE and respective cells, TRPs, and/or beams may have a significantly different characteristic, different precoding, MCS, resource assignment, etc. need to be applied to a link between the UE and respective cells TRPs and/or beams. Specifically, in the case of non-coherent joint transmission (NC-JT) supporting non-coherent precoding between respective cells, TRPs, and/or beams, individual down link (DL) transmission information configuration for respective cells, and TRPs, and/or beams is important. Meanwhile, individual DL transmission information configuration for respective cells, TRPs, and/or beams is a major factor that increases a payload required for DL DCI transmission, and that may adversely affect the reception performance of PDCCH transmitting DCI. Therefore, it may be necessary to carefully design a tradeoff between an amount of DCI information and PDCCH reception performance in order to support JT.

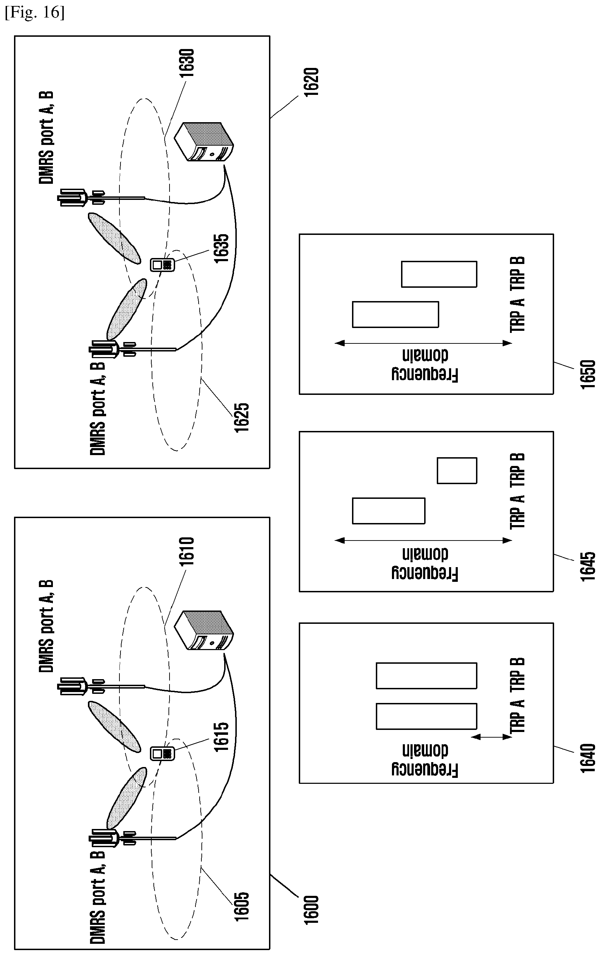

FIG. 16 illustrates an example of antenna port configuration and resource assignment for cooperative communication in a wireless communication system according to certain embodiments of this disclosure.

Referring to the non-limiting example of FIG. 16, examples of TRP-specific radio resource assignment depending on the joint transmission (JT) technology and the situation are illustrated.

In FIG. 16, 1600 is an example of coherent joint transmission (C-JT) supporting coherent precoding between respective cells, TRPs, and/or beams. In the case of C-JT, a single piece of data (PDSCH) may be transmitted to a UE 1615 in TRP A 1605 and TRP B 1610, and joint precoding may be performed in multiple TRPs. This denotes that the same DMRS port (for example, DMRS ports A and B in both TRPs) for reception of the PDSCH is transmitted in the TRP A 1605 and the TRP B 1610. In this case, the UE receives one piece of DCI information for receiving one PDSCH demodulated by DMRS ports A and B.

In FIG. 16, reference numeral 1620 illustrates an example of non-coherent joint transmission (NC-JT) supporting non-coherent precoding between respective cells, TRPs, and/or beams according to various embodiments of this disclosure. In the case of NC-JT, a PDSCH is transmitted to a UE 1635 for each cell, TRP, and/or beam, and individual precoding may be applied to each PDSCH. Different PDSCHs are transmitted via each cell, TRP, and/or beam so as to improve throughput with respect to single cell, TRP, and/or beam transmission, or the same PDSCH is repeatedly transmitted via each cell, TRP, and/or beam so as to improve the reliability with respect to transmission using a single cell, TRP, and/or beam.

For PDSCH transmission, if the same frequency and time resources are used by multiple TRPs (indicated by reference numeral 1640), various radio resource assignment may be considered such as the case where the frequency and time resources used by multiple TRPs do not overlap at all (indicated by reference numeral 1645), and the case where parts of the frequency and time resources used by multiple TRPs overlap (indicated by reference numeral 1650). In case that multiple TRPs repeatedly transmit the same PDSCH in order to improve reliability in each case for the above-mentioned radio resource assignment, if the reception UE does not know whether or not the PDSCH is repeatedly transmitted, the corresponding UE may not combine the corresponding PDSCH in the physical layer, and thus the improvement in reliability nay be limited. Therefore, certain embodiments according to this disclosure comprise a method for indication and configuration of repeated transmission for improving NC-JT transmission reliability.

According to some embodiments, in order to support NC-JT, DCIs of various forms, structures, and relationships may be considered to simultaneously allocate multiple PDSCHs to one UE.

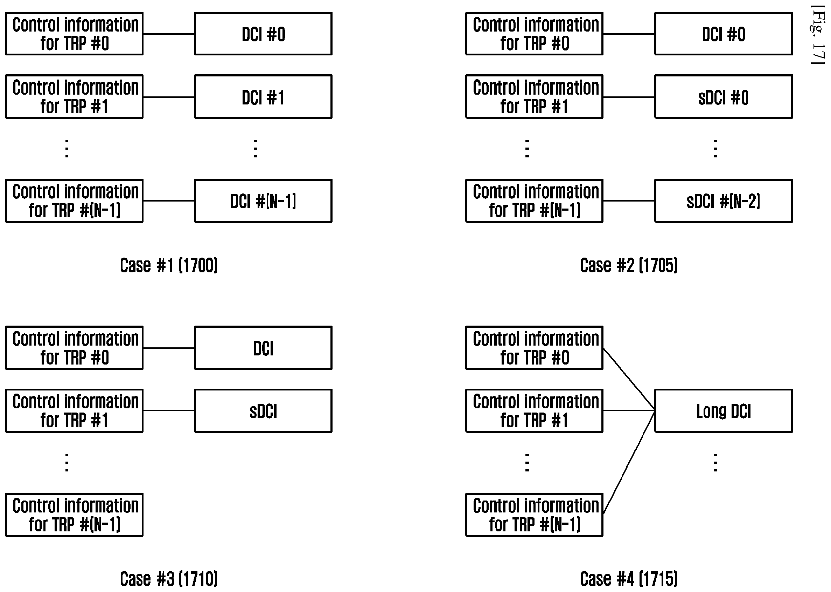

FIG. 17 illustrates an example of configuring downlink control information (DCI) for cooperative communication in a wireless communication system according to certain embodiments of this disclosure. Referring to FIG. 17, a non-limiting selection of four examples of DCI design for NC-JT support is provided.

Referring to the non-limiting example of FIG. 17, case #1 (indicated by reference numeral 1700) is an example in which control information for PDSCH transmitted in the additional (N-1) TRPs is transmitted in the same format (same DCI format) as control information for PDSCH transmitted in a serving TRP in the situation in which different (N-1) PDSCHs are transmitted in additional (N-1) TRPs (TRP #1 to TRP #(N-1)) in addition to a serving TRP (TRP #0) used at the time of transmission of a single PDSCH. That is, the UE may acquire control information about PDSCHs transmitted in different TRPs (TRP #0 to TRP #(N-1)) through DCIs (DCI #0 to DCI #(N-1)) having the same DCI format and the same payload. In Case #1 described above, the degree of freedom for each PDSCH control (assignment) may be completely guaranteed, but in case that DCI is transmitted in different TRPs, a coverage difference for each DCI occurs and reception performance may be deteriorated.

In FIG. 17, case #2 (indicated by reference numeral 1705) is an example in which control information for PDSCH transmitted in the additional (N-1) TRPs is transmitted in a different format (different DCI format or different DCI payload) from control information for PDSCH transmitted in serving TRP, in a situation in which different (N-1) PDSCHs are transmitted in additional (N-1) TRPs (TRP #1 to TRP #(N-1)) in addition to serving TRP (TRP #0) used at the time of transmitting a single PDSCH. For example, in the case of DCI #0, which transmits control information for PDSCH transmitted in the serving TRP (TRP #0), all information elements of DCI format 1_0 to DCI format 1_1 may be included. DCI that transmits control information for PDSCHs transmitted from cooperative TRP (TRP#1 to TRP #(N-1)) may be "shortened" DCIs (sDCI #0 to sDCI #(N-2)). If a shortened DCI is used, the sDCI may include some information elements of DCI format 1_0 to DCI format 1_1. Therefore, in the case of sDCI that transmits control information for PDSCHs transmitted in the cooperative TRP, the payload is small compared to normal DCI (nDCI) that transmits PDSCH-related control information transmitted in the serving TRP, or it is possible to include an insufficient number of reserved bits with respect to nDCI.

In case #2 described above, the degree of freedom of each PDSCH control (assignment) may be limited according to the content of the information elements included in the sDCI. However, since the reception performance of sDCI is superior to that of nDCI, the probability of occurrence of a coverage difference for each DCI may be lowered.

In FIG. 17, case #3 (indicated by reference numeral 1710) is another example in which control information for PDSCH transmitted in the additional (N-1) TRPs is transmitted in a different format (different DCI format or different DCI payload) from control information for PDSCH transmitted in the serving TRP in the situation in which different (N-1) PDSCHs are transmitted in additional (N-1) TRPs (TRP #1 to TRP #(N-1)) in addition to the serving TRP (TRP #0) used at the time of transmitting a single PDSCH. For example, in the case of DCI #0, which transmits control information for PDSCH transmitted in the serving TRP (TRP #0), all information elements of DCI format 1_0 to DCI format 1_1 may be included. The control information for PDSCHs transmitted from a cooperative TRP (TRP #1 to TRP #(N-1)) may be transmitted by collecting, in one "secondary" DCI (sDCI), some information elements of DCIformat 1_0 to DCI format 1_1. For example, the sDCI may include at least one of pieces of HARQ-related information, such as frequency domain resource assignment, time domain resource assignment, and MCS of cooperative TRPs. In addition, in case that information is not included in sDCI, such as a bandwidth part (BWP) indicator or a carrier indicator, transmission may be performed based on DCI (DCI #0, normal DCI, nDCI) of the serving TRP.

In case #3, the degree of freedom of each PDSCH control (assignment) may be limited according to the content of the information elements included in the sDCI, but the sDCI reception performance may be adjusted and compared with case #1 or case #2, whereby the complexity of DCI blind decoding may be reduced.

In the illustrative example of FIG. 17, case #4 (indicated by reference numeral 1715) is an example in which control information for PDSCH transmitted in the additional (N-1) TRPs is transmitted using the same DCI (long DCI, 1DCI) as control information for PDSCH transmitted in serving the TRP in the situation in which different (N-1) PDSCHs are transmitted in additional (N-1) TRPs (TRP #1 to TRP #(N-1)) in addition to the serving TRP (TRP #0) used at the time of transmitting a single PDSCH. That is, the UE may acquire control information for PDSCHs transmitted from different TRPs (TRP #0 to TRP #(N-1)) through a single piece of DCI. In case #4, the complexity of DCI blind decoding of the UE may not increase, but the degree of freedom of PDSCH control (assignment) may be lowered, for example, the number of cooperative TRPs may be limited due to the limitation of the long DCI payload.

In the following description and embodiments, the term sDCI encompasses various auxiliary DCIs, such as shortened DCI, secondary DCI, or normal DCI (PDI format 1 0 to 1_1 described above) including PDSCH control information transmitted from a cooperative TRP. If not specified, the description is similarly applicable to various auxiliary DCIs described above.

In the following descriptions and embodiments, case #1, case #2, and case #3 in which one or more DCIs (PDCCH) are used for NC-JT support are classified as multiple PDCCH-based NC-JTs, and case #4, in which a single piece of DCI (PDCCH) is used for JT support, may be classified as a single PDCCH-based NC-JT.

According to certain embodiments, "cooperative TRP" may be replaced by various terms such as "cooperative panel" or "cooperative beam" at the time of actual application.

According to certain embodiments, "the case where NC-JT is applied" may be interpreted in various ways depending on the situation, such as "the case where a UE simultaneously receives one or more PDSCHs in one BWP", "the case where a UE simultaneously receives PDSCH based on two or more transmission configuration indicator (TCI) indications in one BWP", and "the case where a PDSCH received by the UE is associated with one or more DMRS port groups". However, for convenience of explanation, only the expression "the case where NC-JT is applied" is used.

According to certain embodiments, the radio protocol structure for NC-JT may be used in various ways according to the TRP deployment scenario. For example, if there is no or little backhaul delay between cooperative TRPs, it is possible to use a structure based on MAC layer multiplexing (CA-like method), similarly to the method indicated by reference numeral 1510 in FIG. 15. On the other hand, in case that the backhaul delay between cooperative TRPs is unacceptably large (for example, in case that CSI exchange or scheduling information exchange between cooperative TRPs requires time of 2 ms or longer), it is possible to secure a characteristic robustness against delay by using a TRP-specific independent structure from the RLC layer, similarly to the method indicated by reference numeral 1520 of FIG. 15 (DC-like method).

<Second embodiment: NC-JT repetitive transmission configuration method>

A second example embodiment provides a method for a detailed configuration and instruction for repeatedly transmitting the same PDSCH through the same transmission band, for example, a transmission band, component carrier, BWP, etc., described in the first example embodiment.

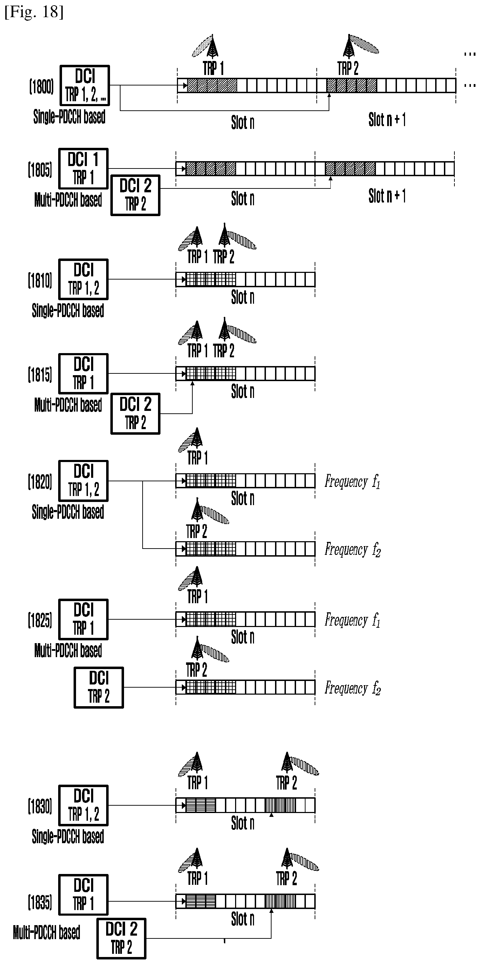

FIG. 18 illustrates an example of repetitive transmission in multiple TRPs in which multiple resource assignment methods are employed in a wireless communication system according to certain embodiments of this disclosure. Referring to the non-limiting example of FIG. 18, an example in which two or more TRPs repeatedly transmit the same PDSCH is illustrated.

Currently, in NR, as described above, at the time of repeatedly transmitting the same PDSCH, a number of slots equal to the number of repetitive transmissions are required, and the same cell, TRP, and/or beam may be used at the time of repetitive transmission. On the other hand, higher reliability may be achieved by using different TRPs for each repetitive transmission in each slot through the disclosed embodiment (indicated by reference numerals 1800 and 1805).

Meanwhile, other repetitive transmission methods may be used according to the capability of the UE, requirements for delay time, and available resource state between TRPs. For example, in case that the UE has the capability to receive NC-JT, each TRP may increase the frequency resource utilization rate and reduce the delay time required for PDSCH decoding by transmitting the same PDSCH using the same time and frequency resources (indicated by reference numerals 1810 and 1815). Certain embodiments of this method are efficient in case that the inter-TRP beams to be simultaneously transmitted are almost orthogonal to each other so there is little interference between beams.

According to another illustrative example, each TRP may use a method for transmitting the same PDSCH using the same time and frequency resources that do not overlap each other (indicated by reference numerals 1820 and 1825). Certain embodiments of this method are effective in case that the inter-beam interference of TRPs to be simultaneously transmitted is large and the amount of frequency resources available for each TRP is large.

According to another explanatory example, each TRP may use a method for transmitting the same PDSCH using different OFDM symbols in the same slot (indicated by reference numerals 1830 and 1835). Certain embodiments of this method are efficient in case that there are not many available frequency resources of each TRP and the size of data to be transmitted is small. In addition to the methods described above, modifications based on the above-described methods may be possible.

In the above-described examples, a single piece of DCI may be used to schedule repetitive transmission (indicated by reference numerals 1800, 1810, 1820, and 1830), and the DCI may indicate a list of all TRPs for performing repetitive transmission. The list of TRPs to be repeatedly transmitted may be provided in the form of a list of TCI states, and the length of the list of TCI states may be changed dynamically. The DCI may be repeatedly transmitted to improve reliability, and different beams may be applied to each DCI at the time of repetitive transmission.

Alternatively, multiple DCIs may be used to schedule repetitive transmissions (indicated by reference numerals 1805, 1815, 1825, and 1835), and each DCI may correspond to PDSCHs of different TRPs to participate in repetitive transmission. The TRP for each DCI may be indicated in the TCI state or the type of resource used for repetitive transmission. Alternatively, a shortened DCI may be used to schedule repetitive transmission, and each of the normal DCI and secondary DCI may correspond to PDSCHs of different TRPs participating in repetitive transmission. The above-described indication method may be commonly applied both to repetitive transmission through multiple TRPs and to different data transmission through multiple TRPs.

In certain embodiments, at the time of single/multiple/shortened DCI-based NC-JT transmission, if the UE does not know whether the PDSCH, transmitted by each TRP, is obtained from repetitive transmission or transmission of different data, each PDSCH may be decoded independently, and even if the PDSCH obtained from repetitive transmission is transmitted, inter-PDSCH combining cannot be performed and an improvement in performance cannot be obtained. The following examples may be considered as non-limiting illustrations of methods for determining whether to perform repetitive transmission.

A. Method 1: In case that a specific MCS table is configured for a higher layer, for example, in case that qam64LowSE or the like having low spectral efficiency is configured therefor, a UE may assume that each PDSCH, which is transmitted using NC-JT, contains the same data, otherwise the UE may assume that each PDSCH, which is transmitted using NC-JT, contains different data.

B. Method 2: In case that one or all DCIs for NC-JT transmission are scrambled using a specific RNTI, for example, in case that the DCIs are scrambled using MCS-C-RNTI, a UE may assume that each PDSCH, which is transmitted using NC-JT, contains the same data, or otherwise, the UE may assume that each PDSCH, which is transmitted using NC-JT, contains different data.

C. Method 3: In case that the MCS level indicated by one or all DCIs for NC-JT transmission is smaller than a specific threshold, a UE may assume that each PDSCH, which is transmitted using NC-JT, contains the same data, or otherwise, the UE may assume that each PDSCH, which is transmitted using NC-JT, contains different data. The DCI for the NC-JT transmission may indicate DCI received in the situation where DCI or NC-JT transmission including a control signal capable of recognizing the NC-JT transmission is recognized by the UE, such as the situation where two or more TCI states are indicated by codepoint, RNTI for NC-JT transmission is configured, or whether to perform NC-JT transmission is configured based on a higher layer.

D. Method 4: In case that there is one DMRS port, CDM group, or layer indicated using one DCI for NC-JT transmission, the UE may assume that each PDSCH, which is transmitted using NC-JT contains the same data, otherwise the UE may assume that each PDSCH transmitted using NC-JT contains different data.

E. Method 5: In case that two codewords are indicated using one DCI for NC-JT transmission, the UE assumes that each codeword is a repeatedly transmitted codeword. On the other hand, in the case where two codewords are indicated by DCI for single TRP transmission, the UE assumes that two codewords including different data are transmitted in a single TRP as before.

F. Method 6: If the HARQ process number and NDI values indicated by all DCIs for the NC-JT transmission are the same, the UE may assume that each PDSCH transmitted using NC-JT contains the same data, or otherwise, the UE may assume that each PDSCH transmitted using NC-JT contains different data. Currently, in NR, there is a restriction that the UE does not expect to receive the PDSCH designated by the same HARQ process ID before the ACK for the PDSCH designated by the specific HARQ process ID is transmitted, except in the case of retransmission. The restriction may be changed to a restriction whereby, in addition to a specific HARQ process ID, a PDSCH designated by the same HARQ process ID and TCI state is not expected to be received before an ACK for a PDSCH designated in a specific TCI state is transmitted. Therefore, repetitive data transmission between different TRPs is allowed, and at the same time, the same restrictions as before may be maintained within one TRP.

Two or more of the above-described examples may be combined and operated as necessary, and a similar method for determining whether to repeatedly transmit the PDSCH transmitted using the NC-JT may be used in addition to the examples described above.

On the other hand, currently, in NR, the number of repetitive transmissions may be semi-statically configured through RRC. However, request reliability may be satisfied without repetitive transmission according to a change in the channel state or even upon performing repetitive transmission a number of times smaller than a configured number of repetitive transmissions.

Therefore, the number of repetitive transmissions may be dynamically configured in order to increase transmission efficiency. For example, in case that the repetitive transmission is scheduled using a single piece of DCI, the number of repetitive transmissions may be equal to the number of TCI states indicated by DCI, or may be an arbitrary number x (for example, an arbitrary number proportional to the number of TCI states). The value of x may be configured dynamically or quasi-statically, and in case that the value of x is quasi-statically configured, the value may be the same as the value designated as the number of repetitive transmissions in NR. Alternatively, the number of semi-statically configured repetitive transmissions may be the maximum number of repetitive transmissions, and the actual number of repetitive transmissions may be dynamically indicated using DCI/MAC-CE. In the case that the number of repetitive transmissions is indicated using DCI, the number of repetitive transmissions may be indicated through a new field, or may be indicated by redefining an existing field.

For example, in case that only a single transport layer is used at the time of repetitive transmission, since codepoints indicating multiple DMRS ports in the DCI antenna port field are not used, the corresponding codepoint may be redefined to indicate the actual number of repetitive transmissions.

Meanwhile, if repetitive transmission is scheduled using multiple DCIs, the number of repetitive transmissions may be equal to number of pieces of DCI or may be an arbitrary number x (for example, an arbitrary number proportional to the number of pieces of DCI), and x may be determined through the same method as that described above.

If the number of repetitive transmissions is indicated both quasi-statically and dynamically, priority may be assigned to predetermined number of times of repetitive transmissions. For example, the number of dynamically indicated repetitive transmissions may be first applied, before the number of quasi-statically indicated repetitive transmissions.

With respect to the repetitive transmission method described above, in some embodiments, all TRPs may transmit one single codeword, or respective TRPs may transmit independent codewords. In case that independent codeword is transmitted from each TRP, since different MCSs, RV values, and/or interleaving patterns may be used for each codeword, adaptive transmission may be possible compared to the case where all TRPs transmit a single codeword. Here, a non-limiting example of a method for optimally determining the RV pattern or the interleaving pattern in consideration of the coding rate, LDPC BG, modulation order, and the like is presented in the following embodiment.

<Third embodiment: RV determination method at the time of performing NC-JT repetitive transmission>

<(3-1)th embodiment: RV determination method according to code rate>

As described above, the optimized RV pattern may differ according to the LDPC coding rate to be applied to each TRP. Therefore, in order to maximize the performance of multiple TRP transmissions, the RV pattern may be variably applied according to the LDPC coding rate. For example, it is possible to apply different RV patterns by configuring a code rate (hereinafter, a reference code rate) $R_{RV}$, serving as the reference, and comparing the code rate with an LDPC code rate R, and according to whether $R > R_{RV}$, $R \leq R_{RV}$ (or $R \geq R_{RV}$, $R < R_{RV}$) is satisfied. The code rate need not be one, and may be set in plural, such as $R_{RV1}$, $R_{RV2}$, ...... In general, in case that three or more TRPs exist, the reference code rate may be defined as different values, such as $R_{RV, TRP1}$ and $R_{RV, TRP2}$.

For reference, the LDPC code rate R may use a code rate configured based on MCS, and may use various code rates such as an effective LDPC code rate. In addition, the TRP transmission may consider all situations that are transmitted through space, frequency, and time resources.

<(3-2)th embodiment: RV determination method according to a parity-check matrix>

The above embodiment has described with reference to a method for maximizing performance by variably applying an RV pattern according to a transmission code rate in at least some TRPs. Since the performance of LDPC codes is generally affected by the degree distribution and algebraic characteristics of the parity-check matrix, the optimized RV pattern may also be affected according to the parity-check matrix.

For example, it is assumed that there are different basic matrices (or base graphs) BG1 and BG2, and that parity check matrices that may be determined from the basic matrices have the structure of FIG. 11 while satisfying the features 1, 2, and 3. In addition, it is assumed that BG1 has values of K = 22 * Z, $M_1$ = 4 * Z, and $M_2$ = 42 * Z in FIG. 11, and that BG2 has values of K = 10 * Z, $M_1$ = 4 * Z, and $M_2$ = 38 * Z in FIG. 11. Here, Z denotes the block size defined in <Equation 8> to <Equation 13>, and since the parity-check matrix that may be determined from BG1 and BG2 is a quasi-cyclic parity-check matrix, the block size may correspond to the size of the circulant permutation matrices at the time of expressing the same by an exponent matrix such as <Equation 3> based on the circulant permutation matrices of <Equation 2>.

As described above, if the BG1 and the BG2 have different characteristics (structure and parameters, etc.), the characteristics of the parity-check matrix that may be determined from each of the characteristics of the BG1 and BG2 also have different characteristics, which may affect performance. Therefore, at the time of transmitting the same transport block or code block in multiple TRPs, the optimal RV pattern may differ according to selection by the BG1 or BG2. In conclusion, at the time of transmitting a signal in a specific TRP, the RV pattern may be variably applied according to a base matrix (or a base graph), or the RV pattern may be variably applied while simultaneously considering a base matrix and a code rate (since the parity-check matrix is determined from the base matrix, the RV pattern may be determined based on the parity-check matrix).

The above-described examples have illustrated embodiments of methods for differently applying an RV pattern based on a transmission code rate or a base matrix (or a parity-check matrix corresponding thereto). According to these methods, in case that a receiver performs LDPC decoding by appropriately combining signals received from multiple TRPs, the transmission code rate or the base matrix affects performance. Therefore, the RV pattern may be appropriately determined or variably used based on other factors affecting the performance of LDPC decoding.

<(3-3)th embodiment: RV determination method according to a modulation scheme>

A higher order modulation scheme may be considered as a factor influencing the decoding performance of LDPC codes. In general, higher-order modulation than QPSK, that is, 16QAM, 64QAM, 256QAM, and 1024QAM, has different reliability for each bit configuring each modulation symbol. The most representative example is that bit error rates (BERs) of the most significant bit (MSB) and the least significant bit (LSB) differ significantly. In the case of LDPC codes, the degree of each column and each row of the parity-check matrix is characterized by irregularity for the purpose of minimizing the bit error rate of information word bits (or code blocks), and thus, in general, the bit error rates of some of parity bits (especially parity bits of degree 1) may be quite high. Therefore, by considering the irregular bit error rate characteristics of LDPC-coded bits and the irregular bit error rate characteristics of respective bits configuring a higher-order modulation symbol, a high coding gain may be obtained by applying appropriate signal constellation mapping thereto. In other words, in the case of generating and transmitting a modulation symbol to which appropriate signal constellation mapping is not applied, loss of encoding performance may occur in a receiver.

In one specific, but non-limiting example, the RV value is assumed to be configured as shown in FIG. 13 and the existing rate matching method is applied based on the first TRP. Further, the LDPC-coded bits for the code block or transport block are assumed to be transmitted starting from RV = 0 in the first TRP. Consider the case where rate matching is applied based on RV = 1 and rate matching is applied based on RV = 2 in the second TRP. Here, all modulation orders applied to respective TRPs are assumed to be 16 QAM or more (for convenience of explanation, the case where the same modulation order is used in each TRP is described, but generally, different modulation orders may be applied to respective TRPs). In this case, it may be predicted that MSB and LSB mapping characteristics for at least some of the LDPC-coded bits according to the RV value are changed, and that the LDPC decoding performance also differs therebetween. In the case of 64QAM, 256QAM, 1024QAM, etc., since the reliability of bits configuring each modulation symbol differs variously, the optimal RV pattern may differ depending on the modulation scheme. That is, the optimal RV pattern may differ according to a higher-order modulation scheme (or modulation order).

The above examples have described embodiments methods for differently applying an RV pattern based on a transmission code rate, a base matrix (or a parity-check matrix corresponding thereto), or a modulation order. In case that a receiver performs LDPC decoding by appropriately combining signals received from multiple TRPs, since the transmission code rate, the base matrix, or the modulation order affects performance, the methods described above may be considered. Therefore, the RV pattern may be appropriately determined or variably used based on other factors affecting the performance of LDPC decoding or by considering two or more factors simultaneously.

<(3-4)th embodiment: RV determination method considering self-decodability>

According to certain embodiments, in the case of applying an optimized RV pattern in a specific TRP, the case in which self-decodability is prioritized over coding gain may be considered. By irregularly configuring the RV value, such as RV = 3, shown in FIG. 13, rate-matching realizing enhanced self-decodability of a channel code is possible.

For example, in case that the LDPC-coded bits for the same code block or transport block are transmitted in the first TRP and the second TRP, an optimal RV pattern may be applied by considering a coding gain. However, if rate matching is applied based on RV = 3 in FIG. 13, in the second TRP, the LDPC-coded bits transmitted from respective TRPs may be combined by the receiver so as to obtain a coding gain, and even if one of the signals transmitted from the first TRP or the second TRP is completely lost for some reason (e.g., blockage) that is, if only one of the two signals is receivable, decoding is still possible. Therefore, an RV determination method considering self-decodability according to another embodiment has an advantage other than the coding gain. This advantage may also be obtained in case that signal transmission is repeated more than once in a single TRP (e.g., a single TRP, a situation of slow movement). For the same reason as described above, RV = 0, which has a high-degree of self-decodability, may be applied to the second TRP, and the corresponding RV may be the same as the RV applied to the first TRP.

In the case of applying an RV pattern, combining an RV having a high-degree of self-decodability and an RV other than the RV having a high-degree of self-decodability may be considered. For example, in case that the average channel gain between the UE and the first TRP is predicted to be greater than the average channel gain between the UE and the second TRP, RV having a high-degree of self-decodability, for example RV 0, is assigned to the first TRP, and another RV, for example, RV 1 or RV 2 is assigned to the second TRP. The reason is that the probability of receiving a signal only from the first TRP in the channel environment is higher than otherwise. The first TRP described above may be TRP that transmits control information, that is, PDCCH.

According to another illustrative example, the case in which the configured number of repetitive transmissions is greater than the number of transmission TRPs may be considered. Here, the same signal may be repeatedly transmitted two or more times in a specific TRP, in which case RV is determined to maximize coding gain at the time of performing repetitive transmission within the TRP, whereas the RV may be determined by considering self-decodability at the time of performing repetitive transmission between TRPs.

According to certain embodiments, the RV sequence for each repetitive transmission may be determined through the RV determination method in consideration of self-decodability. For example, among the repetitive transmission methods, with respect to methods (indicated by reference numerals 1820 and 1825) in which each TRP transmits the same PDSCH using the same time and frequency resources, which do not overlap, the RV sequence may be determined according to the following illustrative methods.

i) As the starting value of the RV sequence, one value among {0, 2, 3, 1} indicated through DCI in the same manner as in Rel-15 is selected. That is, as the RV value for the first PDSCH during multiple-TRP-based PDSCH repetitive transmission, one value among {0, 2, 3, 1}, indicated through DCI in the same manner as in Rel-15, is selected.
ii) The second and subsequent values in the RV sequence may be selected by considering self-decodability. According to the reasons described above, it is advantageous to designate RVs having self-decodability for each transmission in multiple-TRP-based PDSCH repetitive transmission. Therefore, in case that the starting value of the RV sequence is a value having self-decodability, for example, 0 or 3, it is advantageous for the second and subsequent values in the RV sequence to also have self-decodability. That is, in case that the starting value of the RV sequence is 0 or 3, it is advantageous for the second and subsequent values of the RV sequence to also be 0 or 3.
iii) The second and subsequent values in the RV sequence may be selected considering a combining gain. In order to increase the combining gain between multiple-TRP-based PDSCH repetitive transmissions, it is advantageous to designate different RV values between repetitive transmissions. In the example of ii) above, in case that the starting value of the RV sequence is 0, it is advantageous for the second value of the RV sequence to be 3 rather than 0.

According to the invention as claimed, in a method in which each TRP transmits the same PDSCH using the same time and frequency resources, which do not overlap, in case that two TRPs perform PDSCH repetitive transmission, RV for each PDSCH may be configured as shown in the following table. Here, PDSCH for the first TRP refers to PDSCH corresponding to the first TCI state among two TCI states indicated using DCI, and PDSCH for the second TRP refers to PDSCH corresponding to the second TCI state among the two indicated TCI states (In Table 15, $rv_{id}$ denotes the RV value of the specification).

[Table 15] RV sequence for FDM-based multiple-TRP repetition

| $rv_{id}$ indicated by the DCI scheduling the PDSCH | $rv_{id}$ to be applied to $n^{th}$ transmission occasion | |
|---|---|---|
| | $n = 0$ | $n = 1$ |
| 0 | 0 | 3 |
| 2 | 2 | 1 |
| 3 | 3 | 0 |
| 1 | 1 | 2 |

<Table 15> may be applied to a method for performing transmission to different symbols in the same frequency resource and slot as well as a method for performing transmission using the same time and frequency resources, which do not overlap.

<(3-5)th embodiment: RV determination method according to TBS (or CBS)>

An example method for differently applying an optimized RV pattern according to TBS (or CBS) according to certain embodiments is described below.

In general, the decoding performance of LDPC codes is greatly affected by a parity-check matrix used in decoding. Therefore, in case that a part of the parity-check matrix that is substantially used or affects performance according to TBS or CBS has a large difference, the optimized RV pattern may be different.

According to Document TS 38.212, which describes a standard of 3GPP 5G NR, in the case of mapping a code block (or information word bit) to a sub-matrix corresponding to an information word in a parity-check matrix, the range of the code block is configured differently according to TBS. For example, in case that coding is performed based on the second base matrix BG2 defined in TS 38.212 (the base matrix is represented by a base graph in TS 38.212) and TBS = A, if the value of B (= A + L), which is obtained by adding the number of CRC bits L, is greater than 640, $K_b$ = 10 column blocks are selected; $K_b$ = 9 column blocks are selected for the case where B (= A + L) has a value exceeding 560 and smaller than or equal to 640; $K_b$ = 8 column blocks are selected for the case where B (= A + L) has a value smaller than or equal to 560 and exceeding 192; $K_b$ = 6 column blocks are selected for the case where B (= A + L) has a value smaller than or equal to 192, and then encoding is performed based on the $K_b$ column blocks.

Therefore, in the sub-matrix of the parity-check matrix corresponding to the information word bit or the code block, remaining column blocks other than the $K_b$ column blocks may not be used in the encoding process. Similarly, in the actual decoding process, the corresponding column blocks do not have a substantial effect on performance, and are thus not used.

According to Document TS 38.212, which describes the 3GPP 5G NR standard, since the 10 column blocks correspond to information word bits or code blocks in the second base matrix BG2, (10-$K_b$) column blocks in the parity-check matrix corresponding to BG2 may be shortened depending on the value of B. That is, the shortening may be performed by (10-$K_b$) * Z bits, where the Z value may denote the block size described in <Equation 1> to <Equation 13> and in FIG. 11. Here, the "shortening" is a method used to achieve the effect of not substantially using the specific columns, in the case where it is not necessary to use specific columns in a general channel code based on a parity-check matrix, by mutually using the values for the specific columns by a transmitter and a receiver (i.e., using predetermined values for specific columns), and in many cases, the transmitter and receiver apply zero values to the specific columns.

Although, in some embodiments, the receiver may actually apply the value 0, a value determined for decoding may be applied in advance. For example, since it is known that bits corresponding to the specific columns contain the value of 0, a maximum or minimum value among log likelihood ratio (LLR) values configured in the system may be applied. The LLR is a value obtained by taking the logarithm of the likelihood ratio (LR) value, which denotes the ratio between the probability that the received bit is 0 and the probability that the received bit is 1, and the value may be substituted with various values based on the probability that the received bit is 0 and 1 including the LR and LLR according to the receiver.

More specifically, the shortening process is such that since $K_b$ = 10 in the case of B> 640, the basic shortening may not be applied thereto. However, in order to configure the length of the code block as multiples of Z according to the document TS 38.212 describing the 3GPP 5G NR standard, shortening by a number of filter bits smaller than Z may be required. On the other hand, in case that the value of B is smaller than or equal to 192, since $K_b$ = 6, basically, a minimum (10-6) * Z = 4 * Z bits needs to be shortened, and additional shortening by a filler bit may be required.

The shortening technology described above denotes that the degree distribution affecting the performance of an actual LDPC code is changed because the shortening technology provides the same effect as in the case where columns corresponding to shortened bits in the parity-check matrix do not substantially exist. In other words, since the characteristics for decoding performance of the LDPC code may differ greatly depending on the length of the TBS or CBS, the optimized RV pattern may differ depending on the length of the TBS or CBS for the LDPC code to be transmitted in each TRP, and in multiple TRP transmission, the RV pattern may be variably applied according to the LDPC coding rate in order to maximize performance.

According to Document TS 38.212, which describes the 3GPP 5G NR standard, unlike the second base matrix BG2, since the $K_b$ value does not change if encoding is performed based on the first base matrix BG1, the number of shortened bits is smaller than or equal to Z bits. Therefore, it is highly likely that the optimized RV pattern does not differ based on TBS or CBS. As described above, a method for applying an RV pattern may be configured differently depending on the method for using a base matrix.

In fact, according to the 3GPP 5G NR standard, since the base matrix used for LDPC coding and decoding is determined differently according to the TBS and the code rate, a performance improvement may be predicted in case that the TBS and the code rate are simultaneously considered and configured as a criterion for applying the optimal RV pattern. Of course, it is not necessary to configure the reference value for the TBS and the code rate to be the same as the reference for configuration of the base matrix.

The (3-1)th embodiment to the (3-5)th embodiment may be applied not only to grant-based transmission in which every PDSCH or PUSCH transmission is scheduled through DCI, but also to configured grant-type transmission in which transmission is periodically performed according to a period and the like configured in a higher layer parameter. In the configured grant-type transmission, since the PDSCH or PUSCH transmission during a first period is activated by DCI, RV can be indicated through the DCI, but the PDSCH or PUSCH transmission for the second and subsequent periods is transmitted without scheduling DCI. Therefore, the (3-1)th embodiment to (3-5)th embodiment can be applied to the PDSCH or PUSCH transmission during the second and subsequent periods, and the (3-1)th embodiment to the (3-5)th embodiment may also be applied to the PDSCH or PUSCH transmission during the first period, activated by DCI.

<Fourth embodiment: Method for determining interleaving or modulation symbol mapping pattern at the time of NC-JT repetitive transmission>

The fourth example embodiment illustrates an example of a method for applying an optimal interleaving pattern or a modulation symbol mapping pattern as a method for maximizing the combined performance of LDPC codes at the time of transmitting multiple TRPs. Particularly, in the case of applying a higher-order modulation scheme, the fourth embodiment proposes a method of improving performance by variably applying interleaving patterns or modulation symbol mapping patterns using different reliability characteristics of bits corresponding to higher-order modulation symbols, or by variably applying a signal constellation mapping scheme.

Although the embodiment referred to herein as the fourth embodiment describes a method for determining an interleaving pattern or a modulation symbol mapping pattern according to a modulation scheme, an efficient pattern may be determined by considering, similarly to the third embodiment, the code rate or LDPC base graph (or parity-check matrix corresponding thereto), self-decodability, or TBSs (or CBSs). In addition, for convenience, the technology of the disclosure is described based on the technology of TS 38.212, which describes the 3GPP 5G NR standard, but is not necessarily limited to 3GPP 5G NR standard technology.

According to the TS 38.212 standard, first, with respect to $d_i$, (i =0, 1, ..., $N_{cb}$), which is all or part of the LDPC codeword bits generated by performing LDPC coding, in case that a bit stream, which is determined by appropriately applying rate matching, is indicated as $e_i$, k = 0, 1, 2,..., E-1, LDPC codeword bits to be transmitted are determined based on <Equation 15> below.

[Equation 15]

$$k = 0;$$

$$j = 0;$$

$$\text{while } k < E$$

$$\text{if } d_{(k_0+j) \bmod N_{cb}} \neq < NULL >$$

$$e_k = d_{(k_0+j) \bmod N_{cb}};$$

$$k = k + 1;$$

$$\text{end if}$$

$$j = j + 1;$$

$$\text{end while}$$

In the example of <Equation 15>, the value of $k_0$ denotes a position value for starting rate matching in a circular buffer according to the RV value as shown in FIG. 13, and the following values may be used in the following 3GPP 5G NR system (In <Table 16>, $rv_{id}$ denotes the RV value of the current specification, and Zc denotes the value of the block size Z.)

[Table 16]

| $rv_{id}$ | $k_0$ | |
|---|---|---|
| | LDPC base graph 1 | LDPC base graph 2 |
| 0 | 0 | 0 |
| 1 | $\left\lfloor \dfrac{17N_{cb}}{66Z_c} \right\rfloor Z_c$ | $\left\lfloor \dfrac{13N_{cb}}{50Z_c} \right\rfloor Z_c$ |
| 2 | $\left\lfloor \dfrac{33N_{cb}}{66Z_c} \right\rfloor Z_c$ | $\left\lfloor \dfrac{25N_{cb}}{50Z_c} \right\rfloor Z_c$ |
| 3 | $\left\lfloor \dfrac{56N_{cb}}{66Z_c} \right\rfloor Z_c$ | $\left\lfloor \dfrac{43N_{cb}}{50Z_c} \right\rfloor Z_c$ |

Depending on the system, the starting point of rate matching for the RV value may be defined with values different from the above table.

The selected bit stream $e_0,e_1,e_2...,e_{E-1}$ obtains an interleaved bit stream $f_0,f_1,f_2...,f_{E-1}$ through interleaving as shown in <Equation 16> below before applying modulation thereto. Here, Qm denotes a modulation order, and Qm has values of 2, 4, 6, 8, 10,... in the case of QPSK, 16-QAM, 64-QAM, 256-QAM, 1024-QAM,..., respectively.

[Equation 16]

$$\text{for } j = 0 \text{ to } E/Q_m - 1$$

$$\text{for } i = 0 \text{ to } Q_m - 1$$

$$f_{i+j \cdot Q_m} = e_{i \cdot E/Q_m + j};$$

$$\text{end for}$$

$$\text{end for}$$

As shown in <Equations 15> and <Equation 16>, rate matched and interleaved bit stream $f_0,f_1,f_2...,f_{E-1}$ through LDPC coding for each code block may be appropriately modulated according to a modulation order configured in the system. A process such as code block concatenation is additionally performed for the bit streams interleaved for each code block, and then modulation may be applied thereto, if necessary.

In order to describe the modulation symbol mapping process of the interleaved bit stream, a kth modulation symbol is expressed as $y(k)=(y_0(k),y_1(k),...,y_{Q_{m}-1}(k))$. Here, $y_0(k)$ and $y_1(k)$ denote coordinate values on the real axis and the imaginary axis, respectively, corresponding to respective most significant bits (MSBs) for the kth modulation symbol, and $y_{Q_{m}-2}(k)$ and $y_{Q_{m}-1}(k)$ denote coordinate values on the real axis and imaginary axis, respectively, corresponding to respective least significant bits (LSBs) for the kth modulation symbol.

According to the 3GPP 5G NR system, the modulation symbol mapping scheme as in <Equation 17> below may be applied.

[Equation 17]

$$\left(f_{k\cdot Q_m}, f_{k\cdot Q_m+1}, \ldots, f_{(k+1)\cdot Q_m-1}\right) \rightarrow \left(y_0(k), y_1(k), \ldots, y_{Q_m-1}(k)\right) = y(k)$$

$$\left(k = 0, 1, \ldots, \frac{E}{Q_m} - 1\right)$$

In general, in case that a modulation order is greater than 2, that is, in case that a modulation scheme higher than QPSK is used, the reliability of respective bits configuring the modulation symbol is not regular. For example, in the case of using the 16QAM modulation scheme, one 16QAM modulation symbol is configured by 4 bits, and the 2 MSBs are more reliable than the other 2 LSB bits. Here, "high reliability" may denote that the probability of an average bit error is low.

In case that a higher-order modulation scheme having a modulation order of 4 or more is applied, the performance of LDPC codes may be significantly changed according to a modulation symbol mapping scheme due to the difference in reliability for each bit. Therefore, in case that decoding is enabled by combining transmitted signals by applying LDPC coding to the same code block, such as in the case of multiple TRP transmission, HARQ retransmission, PUSCH repetition, etc., the modulation symbol mapping scheme is appropriately applied to improve the combined performance of LDPC codes.

Certain embodiments according to this disclosure comprise a method for improving the combined performance of LDPC codes by considering the characteristics of the reliability difference for each bit by differently applying interleaving schemes or modulation symbol mapping schemes.

<(4-1)th embodiment: Method for applying different interleaving schemes>

In the case of applying the symbol modulation mapping of <Equation 17> after applying the interleaving of <Equation 16>, bit mapping is sequentially assigned (or corresponds) to MSB and LSBs, from the first of bit streams of $e_0, e_1, e_2 \ldots, e_{E-1}$, re-

$$e_{\left(E-\frac{2E}{Q_m}\right)}, e_{\left(E-\frac{2E}{Q_m}+1\right)}, e_{\left(E-\frac{2E}{Q_m}+2\right)}, \ldots, e_{E-1}$$

bits are sequentially mapped to LSB. Therefore, since MSB bits have an average absolute value of received LLR values relatively larger than those of LSB bits, $e_0, e_1, e_2 \ldots, e_{\left(\frac{2E}{Q_m}-1\right)}$ is characterized in that a received bit error rate is low on average and

$$e_{\left(E-\frac{2E}{Q_m}\right)}, e_{\left(E-\frac{2E}{Q_m}+1\right)}, e_{\left(E-\frac{2E}{Q_m}+2\right)}, \ldots, e_{E-1}$$

is characterized in that a bit error rate is high on average.

If the interleaving scheme of <Equation 16> is applied to the first TRP (or the first transmission), the interleaving scheme of <Equation 18> below may be applied to the second TRP (or the second transmission).

[Equation 18]

$$\text{for } j = 0 \text{ to } (E/Q_m - 1)$$

$$\text{for } i = 0 \text{ to } (Q_m - 1)$$

$$f_{(i+j \cdot Q_m)} = e_{\left((Q_m-1-i) \cdot \frac{E}{Q_m}+j\right)} \quad \left(\text{or } f_{E-1-(i+j \cdot Q_m)} = e_{\left(i \cdot \frac{E}{Q_m}+j\right)}\right)$$

$$\text{end for}$$

$$\text{end for}$$

The case of applying the interleaving scheme of <Equation 18> may be the same as that interleaved in reverse order, in terms of reliability, with respect to the result obtained by applying the interleaving scheme of <Equation 16>. Therefore, in case that the interleaving scheme of <Equation 18> is applied and then the symbol mapping method of <Equation 17> is applied, $e_0, e_1, e_2 \ldots, e_{\left(\frac{2E}{Q_m}-1\right)}$ bits are mapped to the LSB and

$$e_{\left(E-\frac{2E}{Q_m}\right)}, e_{\left(E-\frac{2E}{Q_m}+1\right)}, e_{\left(E-\frac{2E}{Q_m}+2\right)}, \ldots, e_{E-1}$$

bits are sequentially mapped to the MSB. Therefore, $e_0, e_1, e_2 \ldots, e_{\left(\frac{2E}{Q_m}-1\right)}$ is characterized in that the received bit error rate is high on

$$e_{\left(E-\frac{2E}{Q_m}\right)}, e_{\left(E-\frac{2E}{Q_m}+1\right)}, e_{\left(E-\frac{2E}{Q_m}+2\right)}, \ldots, e_{E-1}$$

average, and has the characteristic that the bit error rate is low on average.

Therefore, if transmission is performed by applying a first interleaving scheme such as <Equation 16> in the first TRP and a second interleaving scheme such as <Equation 18> in the second TRP, each bit stream achieves the same effect as that obtained by being received by a receiver after passing through channels having different average bit error rate characteristics (or reliabilities). Accordingly, in case that decoding is performed by combining LLR values for each bit, obtained by performing demodulation based on signals transmitted from each TRP, a channel compensation effect may be obtained for each bit.

For example, if the symbol mapping method of <Equation 17> is applied through the interleaving scheme of <Equation 16> in the first TRP, the bit error rate is relatively low, because $e_0$ is mapped to the MSB, but if the symbol mapping method of <Equation 17> is applied through the interleaving scheme of <Equation 18> in the second TRP, the bit error rate is relatively high because $e_0$ is mapped to the LSB, and thus the bit error rates compensate for each other. Similarly, in case that the symbol mapping method of <Equation 17> is applied through the interleaving scheme of <Equation 16> in the first TRP, the bit error rate is relatively high because $e_{E-1}$ is mapped to the LSB, but in case that the symbol mapping of <Equation 17> is applied through the interleaving scheme of <Equation 18> in the second TRP, $e_{E-1}$ is mapped to the MSB, and thus the bit error rate is relatively low, so the bit error rates compensated for each other. Accordingly, by appropriately compensating for the LLR value for each bit, the LDPC code may greatly improve decoding performance through combining between signals.

According to some embodiments, LDPC codes do not guarantee the best combined decoding performance of reverse-order relationship between interleaving schemes corresponding to <Equation 16> and <Equation 18>. In general, applying different interleaving patterns according to LDPC codes may provide better performance. In addition, different interleaving patterns may be applied according to various conditions such as the number of TRPs and the number of retransmissions, and thus may provide better performance.

As described above, the interleaving pattern considering the number of TRPs or the number of retransmissions may be generally expressed as <Equation 19> below.

[Equation 19]

$$\text{for } j = 0 \text{ to } \left( E/Q_m - 1 \right)$$

$$\text{for } i = 0 \text{ to } \left( Q_m - 1 \right)$$

$$f_{(i+j \cdot Q_m)} = e_{\left( \pi(i) \cdot \frac{E}{Q_m} + j \right)} \quad \left( \text{or } f_{(\pi(i)+j \cdot Q_m)} = e_{\left( i \cdot \frac{E}{Q_m} + j \right)} \right)$$

$$\text{end for}$$

$$\text{end for}$$

Here,

$\pi(i)$ ($i$ = 0, 1, ... , $Q_m$ - 1) denotes permutation for integers from 0 to $Q_m$-1.

If $\pi(i)$ is appropriately configured in <Equation 19>, various symbol mappings considering the reliability of various modulation symbols are possible. For example, the interleaving scheme of <Equation 18>, as a reverse-order modulation symbol mapping scheme of <Equation 16>, corresponds to the case $\pi(i)=Q_m$-1-$i$ of <Equation 19>.

In general, if the number of TRPs or the total number of transmissions including retransmissions is $N_{Tr}$, by configuring a permutation such as $\pi_j(i)$, j = 1, ..., T or an interleaving pattern corresponding thereto, with respect to an integer T smaller than or equal to $N_{Tr}$, the permutation and the interleaving pattern may be used differently or in a duplicate manner for each TRP or transmission. Therefore, it is possible to maximize decoding performance through signal combination by the receiver.

For reference, as the reverse-order modulation symbol mapping scheme of <Equation 16>, the interleaving scheme of <Equation 18> may apply the same pattern as $(\pi(0),\pi(1),...,\pi(Q_m-1))=(Q_m-2,Q_m-1,Q_m-4,Q_m-3,...,0,1)$ in <Equation 19>. The pattern described above is characterized in that real axis coordinates and imaginary axis coordinates for MSB or LSB are switched and mapped. In general, the average reliability is the same in the modulation symbol mapping. However, considering the case where the real axis coordinates and the imaginary axis coordinates are switched as described above, it can be seen that various interleaving patterns having similar performance characteristics may exist.

<(4-2)th embodiment: Method for applying different modulation symbol mapping methods>

The (4-2)th embodiment may consider a method for variably applying a modulation symbol mapping pattern for mapping the interleaved bits to signal constellation as well as applying an interleaving pattern, as a method for mapping bits to a modulation symbol by considering the reliability of respective bits configuring the modulation symbol at the time of applying high-order modulation to LDPC coded bits. For example, in the above <(4-1)th embodiment: Method for determining interleaving pattern at the time of repetition transmission of NC-JT>, it is assumed that interleaved bits are sequentially mapped from MSB to LSB as shown in <Equation 17>. However, the modulation symbol mapping pattern is generally expressed by <Equation 20> below.

[Equation 20]

$$\left(f_{k \cdot Q_m}, f_{k \cdot Q_m+1}, \ldots, f_{(k+1) \cdot Q_m-1}\right) \rightarrow \left(y_{\pi(0)}(k), y_{\pi(1)}(k), \ldots, y_{\pi(Q_m-1)}(k)\right)$$

or

$$\left(f_{k \cdot Q_m+\pi(0)}, f_{k \cdot Q_m+\pi(1)}, \ldots, f_{k \cdot Q_m+\pi(Q_m-1)}\right) \rightarrow \left(y_0(k), y_1(k), \ldots, y_{Q_m-1}(k)\right)$$

Here,

$$\pi(i) \quad (i = 0, 1, \ldots, Q_m - 1)$$

may denote a permutation for integers from 0 to $Q_m$-1.

If $\pi(i)$ is appropriately configured in <Equation 20>, various modulation symbol mappings are possible in consideration of the reliability of various modulation symbols. For example, the interleaving scheme for <Equation 18>, which is a reverse-order modulation symbol mapping scheme for <Equation 16>, may correspond to the case of $\pi(i)=Q_m$-1-$i$ in <Equation 20>.

In general, if the number of TRPs or the total number of transmissions including retransmissions is $N_{Tr}$, by configuring a permutation such as $\pi_j(i)$, j = 1, ..., T or an interleaving pattern corresponding thereto, with respect to an integer T smaller than or equal to $N_{Tr}$, the permutation and the interleaving pattern may be used differently or in a duplicate manner for each TRP or transmission. Therefore, it is possible to maximize decoding performance through combination of signals by the receiver.

For reference, as the reverse-order modulation symbol mapping scheme of <Equation 16>, the interleaving scheme of <Equation 18> may apply the same pattern as $(\pi(0),\pi(1),\ldots,\pi(Q_m-1))=(Q_m-2,Q_m-1,Q_m-4,Q_m-3,\ldots,0,1)$ in <Equation 20>. The pattern described above is characterized in that real axis coordinates and imaginary axis coordinates for MSB or LSB are switched and mapped. In general, the average reliability is the same in the modulation symbol mapping. However, considering the case where the real axis coordinates and the imaginary axis coordinates are switched as described above, it may be seen that various interleaving patterns having similar performance characteristics may exist.

In the above two embodiments, <(4-1)th embodiment: Method for applying different interleaving schemes> and <(4-2)th embodiment: Method for applying different modulation symbol mapping methods>, with respect to the interleaving or modulation symbol mapping pattern $\pi(i)$, for convenience, permutations of integers from 0 to $Q_m$-1 are used. In particular, the operation in the above embodiments is the same as that of applying interleaving or demuxing using a block interleaver or an appropriate demux after dividing $e_0,e_1,e_2,\ldots,e_{E-1}$ bit stream into $E/Q_m$ sub-bit streams, as shown in <Equation 16> to <Equation 20>.

However, this is only an example and various types of modulation symbol mapping patterns may be applied. For example, $e_0,e_1,e_2,\ldots,e_{E-1}$ bit stream may be divided into $Q_m/2$ sub-bit streams and $\pi(i)$ is defined as an integer permutation from 0 to $Q_m/2$-1 and used. In addition, in the case of dividing the bit streams into sub-bit streams by a multiple of $Q_m/2$ or by a multiple of the modulation order, $\pi(i)$ may be expressed in the form of a sequence configured by a multiple of $Q_m/2$ or a multiple of Qm.

In addition, for convenience, embodiments have described only the case of mapping MSB (real), MSB (imaginary), ..., LSB (real), LSB (imaginary) in mapping bit streams to be transmitted to transmission symbols. However, various mapping methods such as MSB (real), ..., LSB (real), MSB (imaginary), ..., LSB (imaginary) may be applied depending on the system, and accordingly the optimized modulation symbol mapping pattern may be expressed differently.

The embodiments described above may be summarized as follows.

A method for determining the optimal RV pattern, interleaving pattern, or modulation symbol mapping pattern according to certain embodiments of this disclosure may include:

1) Determining an RV pattern, an interleaving pattern, or a modulation symbol mapping scheme according to a code rate;

2) Determining an RV pattern, an interleaving pattern, or a modulation symbol mapping scheme according to an LDPC base graph (or parity-check matrix corresponding thereto);

3) Determining an RV pattern, an interleaving pattern, or a modulation symbol mapping scheme according to a modulation order;

4) Determining an RV pattern, an interleaving pattern, or a modulation symbol mapping scheme considering self-decodability (an RV having a high-degree of self-decodability or an RV having a low-degree of self-decodability (e.g., RV = 0 or RV = 3, which has a high-degree of self-decodability, is prioritized in FIG. 13); and

5) Determining an RV pattern, an interleaving pattern, or a modulation symbol mapping scheme according to TBS (or CBS).

According to certain embodiments, a method for determining the optimal RV pattern, interleaving pattern, or modulation symbol mapping pattern may determine the optimized pattern by using two or more methods simultaneously. For example, if the method 1) for determining the optimal RV pattern, interleaving pattern, or modulation symbol mapping scheme and the method 4) for determining the optimal RV pattern, interleaving pattern, or modulation symbol mapping scheme are considered simultaneously, RV = 3 is first prioritized, and then the next RV pattern, interleaving pattern, or modulation symbol mapping schemes may be determined in consideration of LDPC decoding performance according to a code rate.

In addition, different RV patterns, interleaving patterns, or modulation symbol mapping patterns may be applied according to various service scenarios. For example, in the case of supporting a service requiring the minimum delay or fast decoding, LDPC-coded bits are transmitted by applying the same pattern for each TRP, without considering LDPC coding gain, or the LDPC-coded bits are repeatedly transmitted by applying the same pattern in a single TRP. In case that the same pattern is applied to each TRP, since the receiving terminal performs LDPC decoding by performing chase combining, only the bits corresponding to the combination are used for LDPC decoding, and thus decoding complexity is low, which may result in fast decoding. In addition, two or more of the variable RV pattern, interleaving pattern, or modulation symbol mapping patterns may be applied at the same time. For example, LDPC-coded bits for the same transport or code block may be transmitted by differently applying, with respect to different TRPs, at least two or more of the RV pattern, the interleaving pattern, or the transmission symbol mapping pattern at the same time according to a code rate, modulation order, or TBS (or CBS). Alternatively, with respect to the first TRP and the second TRP, the RV pattern is the same under specific conditions but the interleaving pattern thereof is different. The RV pattern is different but the same interleaving pattern may be applied under conditions different from the specific conditions.

As described above, according to various scenarios, such as the number of TRPs or the number of retransmissions or PUSCH repetitive transmissions, the RV pattern, the interleaving pattern, or the modulation symbol mapping pattern may be applied in combination with each other.

Although the above embodiments have been described, for convenience, with respect to the case where at least some of LDPC-coded bits of the same transport block or code block is repeatedly transmitted in a single TRP or at least some of the LDPC-coded bits of the same transport block or code block is transmitted in two TRP, in certain embodiments according to this disclosure, three or more TRPs exist. More specifically, according to the disclosure, if a transmitter distinguishes the case where at least some of the LDPC-coded bits for the same transport block or code block is repeatedly transmitted, such as HARQ retransmission and PUSCH repetition transmission, in a single TRP transmission as well as multiple TRP transmissions, using space, time, or frequency resources, into first transmission, second transmission, and the like, a receiver may combine reception signals corresponding to the first transmission, the second transmission, and the like, and apply the combined reception signals to all cases in which decoding is enabled so as to maximize reception performance.

Various methods may be considered to notify the UE of the RV pattern, the interleaving pattern, or the modulation symbol mapping pattern for each repetitive transmission, determined as described above. For example, a set of possible RV patterns, interleaving patterns, or modulation symbol mapping patterns in case that NC-JT repetitive transmission is performed is predefined or configured through a higher layer, and a subset of patterns or one pattern may be implicitly selected using one of the code rate, the LDPC base graph, the modulation order, and the TBS (or CBS), which have been described, or a combination thereof. Meanwhile, one pattern among the set of patterns or subset is explicitly indicated through MAC-CE/DCI and the like.

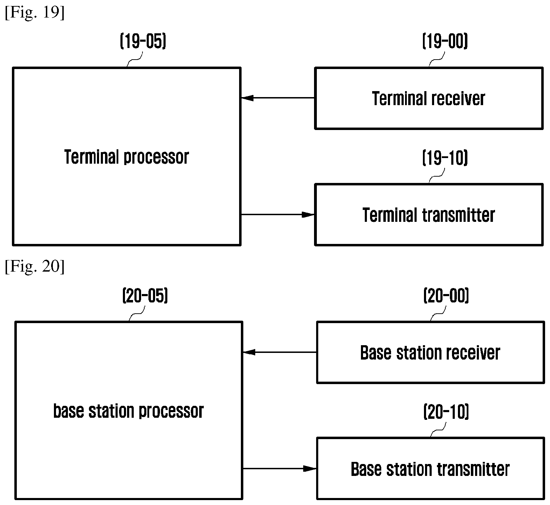

FIG. 19 illustrates an example of structure of a UE in a wireless communication system according to certain embodiments of this disclosure.

Referring to the non-limiting example of FIG. 19, a UE may include a transceiver 19-00, a memory 19-05, and a processor 19-10. The transceiver 19-00 and the processor 19-10 of the UE may operate according to the communication method of the UE described above. However, the elements of the UE are not limited to the example described above. For example, the UE may include a greater or smaller number of elements than described above. In addition, the transceiver 19-00, the memory 19-05, and the processor 19-10 may be implemented in the form of a single chip.

The transceiver 19-00 may transmit or receive a signal to or from a base station. Here, the signal may include control information and data. To this end, the transceiver 19-00 may include an RF transmitter for up-converting and amplifying the frequency of a transmitted signal and an RF receiver for low-noise amplifying a received signal and down-converting the frequency of the received signal. However, this is only an embodiment of the transceiver 19-00, and the elements of the transceiver 19-00 are not limited to the RF transmitter and the RF receiver.

In addition, the transceiver 19-00 may receive a signal through a radio channel, output the signal to the processor 19-10, and transmit the signal output from the processor 19-10 through the radio channel.

The memory 19-05 may store a program and data necessary for the operation of the UE. Further, the memory 19-05 may store control information or data included in a signal transmitted or received by the UE. The memory 19-05 may include a storage medium such as a ROM, a RAM, a hard disk, a CD-ROM, and a DVD, or a combination of storage media. In addition, multiple memories 19-05 may be provided.

According to certain embodiments, the processor 19-10 may control a series of processes so that the UE may operate according to the embodiment described above. For example, the processor 19-10 may control elements of the UE to receive DCI configured by two layers and receive multiple PDSCHs at the same time. Multiple processors 19-10 may be provided, and the processor 19-10 may perform an operation of controlling elements of the UE by executing a program stored in the memory 19-05.

FIG. 20 illustrates an example of the structure of a base station in a wireless communication system according to certain embodiments of this disclosure.

Referring to the non-limiting example of FIG. 20, the base station may include a transceiver 20-00, a memory 20-05, and a processor 20-10. The transceiver 20-00 and the processor 20-10 of the base station may operate according to the communication method of the base station described above. However, the elements of the base station are not limited to the above-described examples. For example, the base station may include a greater or smaller number of elements than described above. In addition, the transceiver 20-00, the memory 20-05, and the processor 20-10 may be implemented in the form of a single chip.

The transceiver 20-00 may, in some embodiments, transmit or receive a signal to or from a UE. Here, the signal may include control information and data. To this end, the transceiver 20-00 may include an RF transmitter for up-converting and amplifying the frequency of a transmitted signal and an RF receiver for low-amplifying a received signal and down-converting the frequency of the received signal. However, this is only an embodiment of the transceiver 20-00, and the elements of the transceiver 20-00 are not limited to the RF transmitter and the RF receiver.

In addition, the transceiver 20-00 may receive a signal through a radio channel and output the signal to the processor 20-10, and may transmit the signal output from the processor 20-10 through a radio channel.

The memory 20-05 may store a program and data necessary for the operation of the base station. Further, the memory 20-05 may store control information or data included in signals transmitted or received by the base station. The memory 20-05 may include a storage medium such as a ROM, a RAM, a hard disk, a CD-ROM and a DVD, or a combination of storage media. In addition, multiple memories 20-05 may be provided.

The processor 20-10 may control a series of processes so that the base station may operate according to the embodiment described above. For example, the processor 20-10 may configure two layers of DCIs including allocation information for multiple PDSCHs, and may control each element of the base station in order to transmit the DCIs. Multiple processors 20-10 may be provided, and the processor 20-10 may perform an operation of controlling elements of the base station by executing a program stored in the memory 20-05.

Hereinafter, an embodiment of a transmission/reception operation of an LDPC coding and decoding apparatus will be described in more detail.

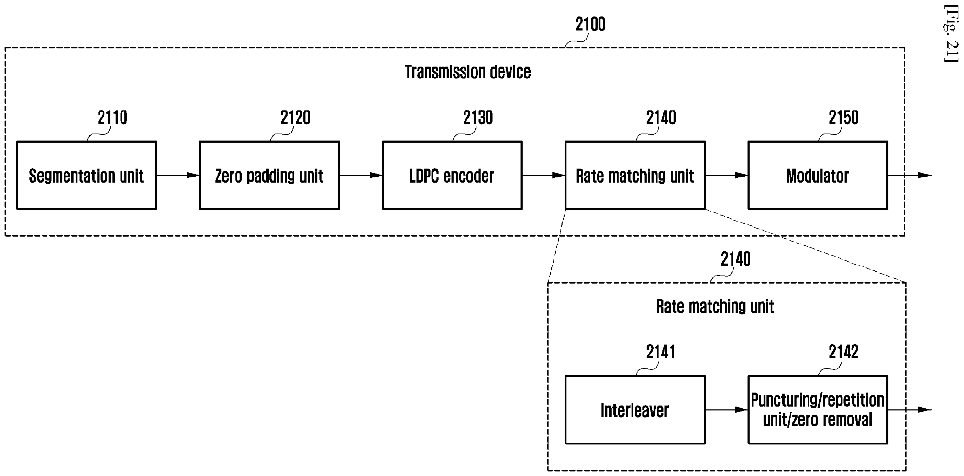

FIG. 21 illustrates, in block diagram format, an example of a transmission device according to certain embodiments of this disclosure. Specifically, as shown in the illustrative example of FIG. 21, in order to process variable-length input bits, the transmission device 2100 may include a segmentation unit 2110, a zero-padding unit 2120, an LDPC encoder 2130, a rate-matching unit 2140, and a modulator 2150, and the like. The rate-matching unit 2140 may include an interleaver 2141 and a puncturing/repetition/zero removal unit 2142.

Here, elements illustrated in FIG. 21 are elements configured to perform encoding and modulation on variable-length input bits. This is only an example. In some cases, some of the elements illustrated in FIG. 21 may be omitted or changed, and other elements may be added. As an example of the modulation scheme, any of the QAM schemes such as QPSK, 16-, 64-, 256-, and 1024-QAM, or a scheme such as a phase shift keying (PSK) scheme or an amplitude and PSK (APSK) scheme is possible.

On the other hand, the transmission device 2100 determines required parameters (e.g., parameters for input bit length, modulation and code rate (ModCod), zero padding or shortening, parameters for a code rate of LDPC code, information word or codeword length, interleaving, parameters for repetition and puncturing, a modulation scheme, or the like), and encodes input bits based on the determined parameters so as to transmit the encoded input bits to a reception device 2100.

Since the number of input bits is variable, if the number of input bits is greater than a preset threshold, the input bits may be segmented to have length shorter than or equal to the preset threshold. Each segmented block may correspond to one LDPC-coded block. If the number of input bits is smaller than or equal to the threshold, the input bits are not segmented, and the input bits may correspond to one LDPC-coded block.

Meanwhile, the transmission device 2100 may pre-store various parameters used for coding, interleaving, and modulation. Here, the parameters used for coding may include at least one of the code rate of an LDPC code, the information word or codeword length, and information on the parity-check matrix. In addition, the parameters used for interleaving may include information on the interleaving rule, and the parameters used for modulation may include information on the modulation scheme. In addition, the information about puncturing may include the puncturing length. In addition, the information about repetition may include the repetition length. The information on the parity-check matrix may include exponent values of the circulant matrix or values corresponding thereto in the case where the parity-check matrix proposed in the disclosure is used.

In this case, each element configuring the transmission device 2100 may perform an operation using these parameters. Meanwhile, although not illustrated, in some cases, the transmission device 2100 may further include a controller (not shown) for controlling the operation of the transmission device 2100.

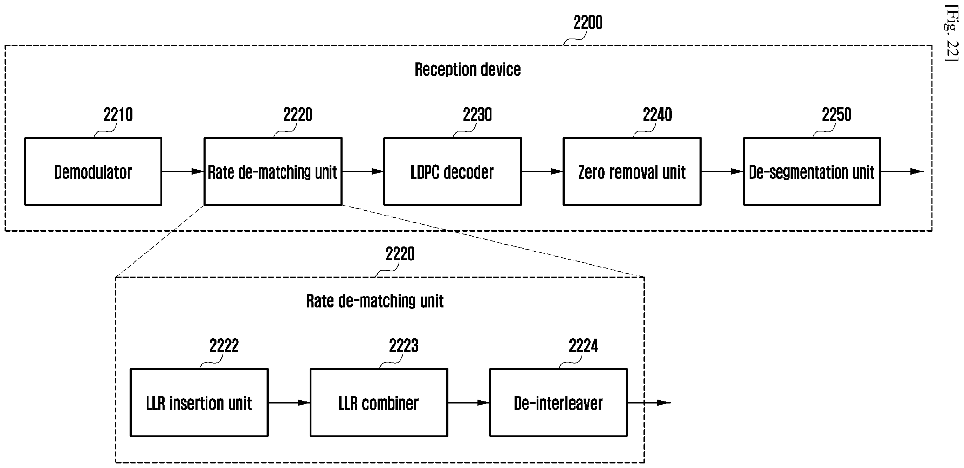

FIG. 22 illustrates, in block diagram format, an example of a reception device according to certain embodiments of this disclosure.

Specifically, as illustrated in the non-limiting example of FIG. 22, in order to process variable length information, the reception device 2200 may include a demodulator 2210, a rate de-matching unit 2220, an LDPC decoder 2230, a zero removal unit 2240, and a de-segmentation unit 2250. The rate de-matching unit 2220 may include an LLR insertion unit 2222, an LLR combiner 2223, a deinterleaver 2224, and the like. The LLR insertion unit 2222, the LLR combiner 2223, and the like may have different names according to the values used for decoding. For example, in the case of performing decoding based on values such as a likelihood ratio (LR) instead of LLR, the name of the corresponding entity may be determined based on values used for decoding, such as an LR insertion unit and an LR combiner, and operation may differ based on the above values.

According to certain embodiments, the operation of the demodulator 2210 may be subdivided into multiple processes depending on the case. For example, the operation of the demodulator may be subdivided, after performing channel estimation based on the received signal, into a process of determining values (e.g., LLR or LR or a value corresponding thereto), necessary for FEC decoding corresponding to the transmitted codeword bit, using the demodulated signal or symbol based on the result. In this case, the operation in each demodulator may be subdivided into operations of each channel measurement block and symbol-to-LLR (symbol-to-LLR) conversion block. Various subdivisions are possible depending on the structure of the system.

Here, elements illustrated in FIG. 22 are elements for performing the functions corresponding to elements illustrated in FIG. 22. This is an example only. In some cases, some of the elements may be omitted or changed, or other elements may be added.

The parity-check matrix in the disclosure may be read using memory, may be provided in advance by the transmission device or the reception device, or may be generated directly in the transmission device or the reception device. In addition, the transmission device may store or generate a sequence or an exponent matrix corresponding to the parity-check matrix and apply the sequence or exponent matrix to the encoding. Likewise, the reception device may store or generate a sequence or an exponent matrix corresponding to the parity-check matrix and apply the sequence or exponent matrix to the decoding.

Hereinafter, a detailed description of the operation of the receiver according to certain will be made based on the non-limiting example of FIG. 22.

Referring to the illustrative example of FIG. 22, the demodulator 2210 demodulates a signal received from the transmission device 2100.

Specifically, the demodulator 2210 is an element that corresponds to the modulator 2150 of the transmission device 2100 and receives and demodulates the signal transmitted from the transmission device 2100, and thus may generate values (e.g., LLR, LR, or values corresponding thereto) corresponding to bits transmitted from the transmission device 2100.

To this end, the reception device 2200 may store information about a modulation scheme for performing modulation according to a mode in the transmission device 2100. Alternatively, the information about the modulation scheme may be pre-stored in the reception device. Accordingly, the demodulator 2210 may demodulate the signal received from the transmission device 2100 according to a mode and generate values corresponding to LDPC codeword bits.

The LR value denotes the ratio between the probability that the bit transmitted from the transmission device 2100 is 0 and the probability that the bit transmitted from the transmission device 2100 is 1, and the LLR value may be represented by a value obtained by taking the logarithm of the ratio between the probability that the bit transmitted from the transmission device 2100 is 0 and the probability that the bit transmitted from the transmission device 2100 is 1. Alternatively, the LR or LLR value may be obtained through a hard decision according to the probability, or the ratio between the probabilities, or the log value of the ratio between the probabilities, and thus may be expressed by the bit value itself, or may be indicated as a representative value defined in advance according to the interval to which the probability, or the ratio between the probabilities, or the log value of the ratio between the probabilities belongs. An example of a method for determining the representative value defined in advance according to the interval to which the probability, or the ratio between the probabilities, or the log value of the ratio between the probabilities belongs includes a method in which quantization is considered. In addition, various other values corresponding to the probability, the ratio between the probabilities, or the log value of the ratio between the probabilities may be used.

In the disclosure, in order to explain the reception method and the operation of the device, operation based on the LLR value has been described for convenience, but the disclosure is not limited thereto.

According to certain embodiments, demodulator 2210 includes a function of performing multiplexing (not shown) of LLR values. Specifically, the mux (not shown) is an element corresponding to the bit demux (not shown) of the transmission device 2100, and may perform an operation corresponding to the bit demux (not shown).

To this end, the reception device 2200 may, in some embodiments, store information on parameters used by the transmission device 2100 in order to perform demultiplexing and block-interleaving operations. Accordingly, the mux (not shown) may reversely perform the demultiplexing and block-interleaving operations, performed in the bit demux (not shown) with respect to an LLR value corresponding to a cell word (information representing the received symbol for the LDPC codeword as a vector value), and thus may multiplex the LLR value corresponding to the cell word in bit units.

The rate de-matching unit 2220 may additionally insert LLR values into LLR values output from the demodulator 2210. In this case, the rate de-matching unit 2220 may insert predetermined LLR values between the LLR values output from the demodulator 2210.

Specifically, the rate de-matching unit 2220 is an element corresponding to the rate-matching unit 2140 of the transmission device 2100, and may perform operations corresponding to the interleaver 2141 and the puncturing/repetition/zero removal unit 2142.

First, the rate de-matching unit 2220 performs deinterleaving corresponding to the interleaver 2141 of the transmitter. The LLR insertion unit 2222 may insert LLR values corresponding to zero bits into the output values of the deinterleaver 2224 at the position where zero bits are padded in the LDPC codeword. In this case, the LLR value corresponding to the padded zero bits, that is, shortened zero bits, may be $\infty$ or $-\infty$. However, or - is a theoretical value, and thus may effectively be the maximum value or the minimum value of the LLR value used in the reception device 2200.

To this end, the reception device 2200 may pre-store information about the parameters used by the transmission device 2100 for padding zero bits. Accordingly, the rate de-matching unit 2220 may determine the positions where the zero bits are padded in the LDPC codeword and insert an LLR value corresponding to the shortened zero bits at the corresponding position.

In addition, the LLR insertion unit 2222 of the rate de-matching unit 2220 may insert an LLR value corresponding to the punctured bits at the positions where bits are punctured in the LDPC codeword. Here, the LLR value corresponding to the punctured bits may be zero or another predetermined value. In general, in case that the parity bits of degree 1 are punctured, there is no effect on performance improvement in the LDPC decoding process, which thus may not be used in the LDPC decoding process without LLR insertion at positions corresponding to some or all of the puncturing positions. However, in order to increase the efficiency of the LDPC decoding process based on the parallel process, the LLR insertion unit 2222 may insert a predetermined LLR at positions corresponding to part or all of the puncturing bits of order 1 regardless of the decoding performance improvement.

To this end, the reception device 2200 may pre-store information on parameters used by the transmission device 2100 in order to perform puncturing. Accordingly, the LLR insertion unit 2222 may insert an LLR value (e.g., LLR = 0) corresponding to the punctured bits at positions where the LDPC information word bits or parity bits are punctured. However, this process may be omitted at a position where some parity bits are punctured.

The LLR combiner 2223 may perform combination, that is, may sum LLR values output from the LLR insertion unit 2222 and the demodulation unit 2210. Specifically, the LLR combiner 2223 is an element corresponding to the puncturing/repetition/zero removal unit 2142 of the transmission device 2100, and may perform an operation corresponding to the repetition unit 2142. First, the LLR combiner 2223 may combine an LLR value corresponding to repetition bits with another LLR value. Here, the another LLR value may be an LLR value for bits, serving as the basis for generation of repetition bits in the transmission device 2100, that is, LDPC information word bits or parity bits selected to be repeated. In addition, according to Document TS 38.212, which describes the 3GPP 5G standard, the repetition bits may be variously determined based on parameters such as a redundancy version (RV) value or a code rate configured in a retransmission process such as HARQ (hybrid ARQ).

That is, as described above, the transmission device 2100 selects LDPC-coded bits and, if necessary, repeatedly transmits the LDPC information word bits and LDPC parity bits to the reception device 2200. Accordingly, the LLR value for LDPC-coded bits may include an LLR value for repeated LDPC-coded bits and an LLR value for non-repeated LDPC-coded bits. The LLR combiner 2223 may combine LLR values corresponding to the same LDPC-coded bits.

To this end, the reception device 2200 may pre-store information on parameters used for repetition in the transmission device 2100. Accordingly, the LLR combiner 2223 may determine the LLR value for the repeated LDPC-coded bits and combine the LLR value for the repeated LDPC-coded bits with the LLR value for the LDPC coded bits, serving as the basis of the repetition.

In addition, the LLR combiner 2223 may combine the LLR value corresponding to the retransmitted or incremental redundancy (IR) bits with another LLR value. Here, the another LLR value may be the LLR value for some or all of the LDPC codeword bits, serving as the basis of the generation of retransmitted or IR bits in the transmission device 2100.

As described above, in case that the NACK occurs for the HARQ, the transmission device 2100 may transmit some bits or all bits of the codeword bits to the reception device 2200.

Accordingly, the LLR combiner 2223 may combine the LLR value for bits received through retransmission or IR with the LLR value for LDPC codeword bits received through the previous frame.

To this end, the reception device 2200 may pre-store information about parameters used for retransmission or generation of IR bits in the transmission device 2100. Accordingly, the LLR combiner 2223 may determine an LLR value for retransmitted or IR bits, and may combine the LLR value with an LLR value for at least some of the LDPC coded bits, serving as the basis for the generation of retransmission bits.

The deinterleaver 2224 may deinterleave the LLR value output from the LLR combiner 2223.

Specifically, the de-interleaver unit 2224 is an element corresponding to the interleaver 2141 of the transmission device 2100, and may perform an operation corresponding to the interleaver 2141.

To this end, the reception device 2200 may pre-store information on parameters used by the transmission device 2100 in order to perform interleaving. Accordingly, the deinterleaver 2224 may reversely perform the interleaving operation, performed by the interleaver 2141, with respect to the LLR values corresponding to the transmitted LDPC-coded bits, so as to deinterleave the LLR values corresponding to the transmitted LDPC-coded bits.

According to certain embodiments, LDPC decoder 2230 may perform LDPC decoding based on the LLR value output from the rate de-matching unit 2220.

Specifically, the LDPC decoder 2230 is an element corresponding to the LDPC encoder 2130 of the transmission device 2100, and may perform an operation corresponding to the LDPC encoder 2130.

To this end, the reception device 2200 may pre-store information on parameters used in the transmission device 2100 in order to perform LDPC coding according to a mode. Accordingly, the LDPC decoder 2230 may perform LDPC decoding based on the LLR value output from the rate de-matching unit 2220 according to a mode.

For example, the LDPC decoder 2230 may perform LDPC decoding based on the LLR value output from the rate de-matching unit 2220 based on an iterative decoding method based on a sum-product algorithm, and may output bits in which an error is corrected according to the LDPC decoding.

The zero removal unit 2240 may, in some embodiments, remove zero bits from bits output from the LDPC decoder 2230. Specifically, the zero removal unit 2240 is an element corresponding to the zero-padding unit 2120 of the transmission device 2100, and may perform an operation corresponding to the zero-padding unit 2120. To this end, the reception device 2200 may pre-store information about a parameter used to pad zero bits in the transmission device 2100. Accordingly, in case that the decoding is performed, by the LDPC decoder 2230, using the padded bits, the zero removal unit 2240 may remove, from the output bits, the zero bits padded by the zero-padding unit 2120. The operation of removing the zero padded (or shortened) bits by the zero removal unit 2240 may actually denote an operation of removing the padded bits, or may denote an operation of transmitting the output bits of the LDPC decoder 2230 to the de-segmentation unit 2250, excluding the padded bits. In addition, the bits padded with zeroes in the transmission device may not be used in the decoding process because the reception device accurately knows the position at which the bits are zero-padded, and in this case, the process of removing the zero padded bits may be omitted.

The de-segmentation unit 2250 is an element corresponding to the segmentation unit 2110 of the transmission device 2100, and may perform an operation corresponding to the segmentation unit 2110.

To this end, the reception device 2200 may pre-store information on parameters used by the transmission device 2100 in order to perform segmentation. Accordingly, the de-segmentation unit 2250 may combine bits, that is, segments for variable-length input bits, output from the zero removal unit 2240, and thus may reconstruct bits before segmentation.

On the other hand, LDPC codes may be decoded using an iterative decoding algorithm based on a sum-product algorithm on a bipartite graph, which is generally called a Tanner graph, and the sum-product algorithm is a kind of message-passing algorithm.

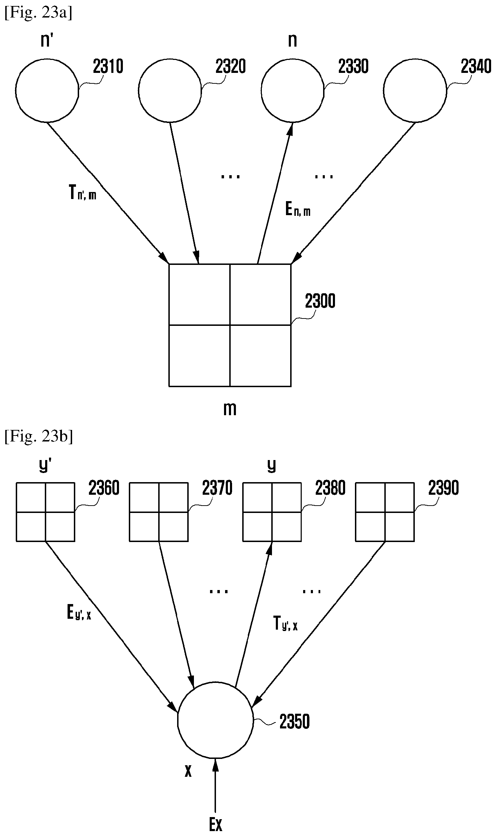

Hereinafter, examples of message-passing operations used for LDPC decoding according to certain embodiments of this disclosure will be described with reference to FIGS. 23A and 23B.

FIGS. 23A and 23B illustrate examples of a message-passing operation performed at arbitrary check and variable nodes in order to perform LDPC decoding, according to some embodiments of this disclosure.

FIG. 23A shows multiple variable nodes 2310, 2320, 2330, and 2340 connected to a check node m 2300 and a check node m 2300. In addition, the illustrated $T_{n',m}$ indicates a message passed from the variable node n' 2310 to the check node m 2300, and $E_{n,m}$ indicates a message passed from the check node m 2300 to the variable node n 2330. Here, the set of all variable nodes connected to the check node m 2300 is defined as "N(m)", and a set excluding the variable node n 2330 from the set N(m) is defined as "N(m)\n".

In this case, the message update rule based on the sum-product algorithm may be expressed as <Equation 21> below.

[Equation 21]

$$\left| E_{n,m} \right| = \Phi\left( \sum_{n' \in N(m)\backslash n} \Phi\left( \left| T_{n',m} \right| \right) \right),$$

$$\mathrm{sign}\left( E_{n,m} \right) = \left( \prod_{n' \in N(m)\backslash n} \mathrm{sign}\left( T_{n',m} \right) \right).$$

Here, Sign ($E_{n,m}$) represents the + and - signs of message $E_{n,m}$, and $|E_{n,m}|$ represents the magnitude of the message $E_{n,m}$. Meanwhile, the function $\Phi(x)$ may be expressed as <Equation 22> below.

[Equation 22]

$$\Phi(x) = -\log\left( \tanh\left( \frac{x}{2} \right) \right)$$

For reference, the -log (tanh (.)) function of <Equation 22> may be more simply expressed as log(coth (.)) function.

Meanwhile, FIG. 23B shows multiple check nodes 2360, 2370, 2380, and 2390 connected to a variable node x 2350 and a variable node x 2350. In addition, the illustrated $E_{y',x}$ indicates a message passed from the check node y' 2360 to the variable node x 2350, and $T_{y,x}$ indicates a message passed from the variable node x 2350 to the check node y 2380. Here, a set of all the check nodes connected to the variable node x 2350 is defined as "M(x)", and a set excluding the check node y 2380 from M(x) is defined as "M(x)\y". In this case, the message update rule based on the sum-product algorithm may be expressed by <Equation 23> below.

[Equation 23]

$$T_{y,x} = E_x + \sum_{y' \in M(x) \backslash y} E_{y',x}$$

Here, $E_x$ denotes the initial message value of the variable node x.

In addition, a bit value of the node x may be determined as <Equation 24> below.

[Equation 24]

$$P_x = E_x + \sum_{y' \in M(x)} E_{y',x}$$

In this case, the encoded bit corresponding to the node x may be determined according to the value of Px.

Since the scheme illustrated in FIGS. 23A and 23B is a general decoding scheme, a detailed description thereof will be omitted. In addition to the scheme described in FIGS. 23A and 23B, other schemes may be applied to determine message values passed at variable nodes and check nodes. For example, see Frank R. Kschischang, Brendan J. Frey, and Hans-Andrea Loeliger, "Factor Graphs and the Sum-Product Algorithm," IEEE TRANSACTIONS ON INFORMATION THEORY, VOL. 47, NO. 2, FEBRUARY 2001, pp. 498-519, incorporated herein by reference. For example, in <Equation 19> and <Equation 22>, the update expression of the check node is expressed in the form of a sum based on the -log (tanh (.)) function, but in the above reference document, there is a method expressed in the form of a product based on the tanh (.) function or the reverse function tanh$^{-1}$ (.). As such, various conceptually identical expression methods may exist. In addition, various simplified decoding methods such as a min-sum algorithm may exist in order to reduce complexity. In the disclosure, a detailed description of these various decoding algorithms is omitted, but it will be obvious that a method for combining multiple signals proposed by the disclosure including not only the decoding algorithms but also various other types of decoding algorithms falls within the scope of the disclosure.

Hereinafter, the detailed configuration and operation of an LDPC encoder (not shown) according to certain embodiments of this disclosure will be described.

The $K_{ldpc}$ bits may configure $K_{ldpc}$ LDPC information word bits $I = (i_0, i_{1, ...,} i_{Kldpc-1})$ for the LDPC encoder. The LDPC encoder systematically LDPC-encodes $K_{ldpc}$ LDPC information word bits, and thus may generate an LDPC codeword $C = (c_0, c_1, ..., c_{Nldpc-1}) = (i_0, i_1, ..., i_{Kldpc-1}, p_0, p_1, ..., P_{Nldpc-Kldpc-1})$ configured by $N_{ldpc}$ bits. As described in <Equation 14>, the codeword is determined such that the product of the LDPC codeword and the parity-check matrix becomes a zero vector.

Generally, the encoding device includes an LDPC encoder. The LDPC encoder may generate an LDPC codeword by performing LDPC coding on input bits based on a parity-check matrix, or an exponent matrix or sequence corresponding thereto. In this case, the LDPC encoder may perform LDPC coding using a parity-check matrix defined differently according to a code rate (that is, a code rate of an LDPC code), a TBS, CBS, or a block length Z according to a system.

Meanwhile, the encoding apparatus may further include a memory for pre-storing information about the code rate, information word or codeword length, block length, and parity-check matrix of LDPC codes, and the LDPC encoder may perform the LDPC coding using the information. The information about the parity-check matrix may include information about an exponent value of a circulant matrix or a value corresponding thereto in case that the parity-check matrix proposed in the disclosure is used.

Hereinafter, the detailed configuration and operation of the LDPC decoder according to certain embodiments of this disclosure will be described.

In general, the decoding device may include an LDPC decoder. The LDPC decoder performs LDPC decoding of an LDPC codeword based on a parity-check matrix, or an exponent matrix or sequence corresponding thereto. For example, the LDPC decoder may generate information word bits by performing LDPC decoding by passing an LLR value corresponding to LDPC codeword bits through an iterative decoding algorithm. Here, the LLR value is a channel value corresponding to LDPC codeword bits, and may be expressed in various ways.

In this case, the LDPC decoder may perform LDPC decoding using a parity-check matrix, which is defined differently according to a code rate (that is, a code rate of the LDPC code), a TBS, a CBS, or a block length Z.

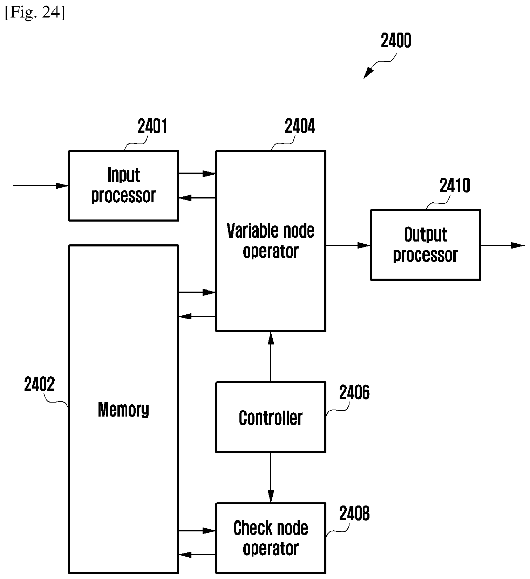

FIG. 24 illustrates, in block diagram format, an example of an LDPC decoder according to some embodiments of this disclosure.

Meanwhile, as described above, the LDPC decoder may perform LDPC decoding using an iterative decoding algorithm, and here, the LDPC decoder may be configured as shown in FIG. 24. However, the detailed configuration shown in FIG. 24 is only an example.

According to the non-limiting example of FIG. 24, a decoding device 2400 includes an input processor 2401, a memory 2402, a variable node operator 2404, a controller 2406, a check node operator 2408, an output processor 2410, and the like. For example, when defining a controller in the specification, it may be stated that "the controller may be a circuit, an application-specific integrated circuit or at least one processor."

The input processor 2401 stores input values. Specifically, the input processor 2401 may store an LLR value of a received signal received through a radio channel.

The controller 2404 determines the number of values input to the variable node operator 2404, the address value in the memory 2402, the number of values input to the check node operator 2408, and the address value in the memory 2402, based on the parity-check matrix corresponding to the block size (i.e., the length of the codeword) and the code rate of the received signal received through the radio channel.

The memory 2402 stores input data and output data of the variable node operator 2404 and the check node operator 2408.

The variable node operator 2404 receives data from the memory 2402 according to address information of input data and information on the number of pieces of input data, received from the controller 2406, to perform a variable node operation. Thereafter, the variable node operator 2404 stores, in the memory 2402, the results obtained from the variable node operation, based on the address information of the output data and information on the number of pieces of output data received from the controller 2406. In addition, the variable node operator 2404 inputs the results obtained from the variable node operation to the output processor 2410 based on the data received from the input processor 2401 and the memory 2402. Here, the variable node operation has been described above based on FIG. 6.

According to certain embodiments, the check node operator 2408 receives data from the memory 2402 based on the address information of the input data and the information on the number of pieces of input data received from the controller 2406 to perform a check node operation. Thereafter, the check node operator 2408 stores, in the memory 2402, the results obtained from the check node operation, based on the address information of the output data and the information on the number of pieces of output data received from the controller 2406. Here, the check node operation has been described above based on FIG. 6.

The output processor 2410 makes a hard decision as to whether each of the information word bits of the codeword of the transmitter is 0 or 1 based on the data received from the variable node operator 2404, and then outputs the result of the hard decision. The output value of the output processor 2410 becomes the finally decoded value. In this case, in FIG. 6, it is possible to make a hard decision based on the value obtained by adding all message values (initial message value and all message values input from the check node) input to one variable node.

Meanwhile, the memory 2402 of the decoding device 2400 may store information about the code rate, information word or codeword length, and parity-check matrix of LDPC codes, and the LDPC decoder 2510 may perform LDPC coding using the information. However, this is only an example, and corresponding information may be provided from the transmitting side.

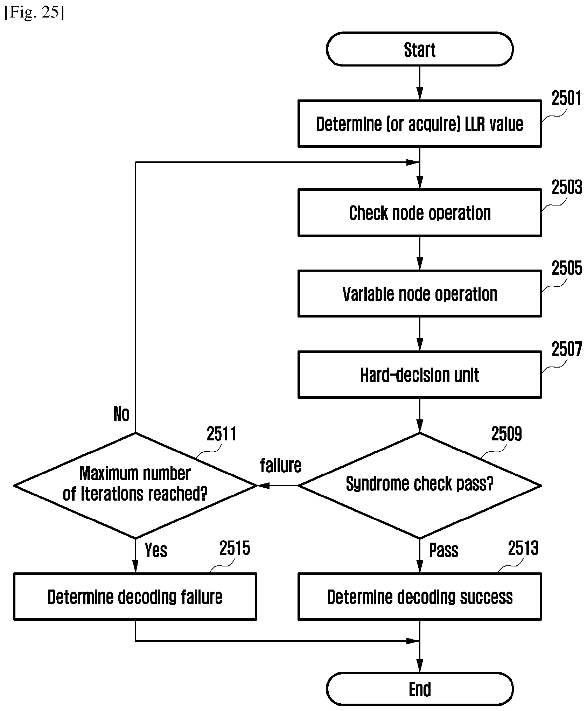

FIG. 25 illustrates an example of a decoding process in an LDPC decoder according to certain embodiments of this disclosure.

Referring to the illustrative example of FIG. 25, in operation 2501, a value referred to as a channel LLR or an intrinsic LLR of a corresponding bit, generated from a received signal, is input to each variable node. The input LLR values may be rate de-matched LLR values. In operation 2503, the intrinsic LLR of each variable node is transmitted to a neighboring check node, and each of the check nodes calculates a message corresponding to an extrinsic LLR to be transmitted to each variable node based on the received message. In the flooding-type LDPC decoder, all of the check nodes calculate and update message values, and the calculated message corresponding to the extrinsic LLR is transmitted to a neighboring variable node along the established connection line.

In some embodiments, at operation 2505, all variable nodes generate a complete LLR for determining a message and a bit value to be transmitted to the check nodes based on a message corresponding to the received extrinsic LLR and intrinsic LLR values. The complete LLR may be referred to as an a-posteriori probability (APP) metric, APP LLR, or another term having equivalent technical meaning thereto. The flooding-type LDPC code decoder calculates and updates the message values of all variable nodes.

In operation 2507, the variable node estimates bit values by making a hard-decision on the complete LLR before transmitting the message to the check node.

In operation 2509, it is checked whether the estimated bit value satisfies a syndrome check equation determined by a parity-check matrix. If it is identified that the syndrome check equation is satisfied, in operation 2511, the decoding is determined to be successful and information about the decoding success is output and reported.

If it is identified that the syndrome check equation is not satisfied, in operation 2513, it is identified whether the number of decoding iterations performed so far has reached the maximum number of decoding iterations. If the number of decoding iterations performed so far has not reached the maximum number of decoding iterations, the series of processes is repeated again. If the decoding result does not satisfy the syndrome check equation until the number of decoding iterations performed so far reaches the maximum number of decoding iterations, in operation 2515, a decoding failure is output and reported.

The layered-scheme LDPC decoding denotes a method for dividing check nodes into multiple layers and then sequentially decoding check nodes in its turn.

Referring to the explanatory example of FIG. 25, in operation 2503, the check node belonging to a layer receives, in its turn, a message from the connected variable node. The check node transmits the calculated and updated message to a neighboring variable node. In operation 2505, the variable node that received the updated message calculates and updates the message and the complete LLR to be transmitted to the check node. A series of operation processes for one layer as described above is referred to as layer processing.

In case that layer processing of all layers is performed, in operation 2507, a receiving terminal calculates a bit estimation value by making a hard-decision on the complete LLR calculated by each variable node. In operation 2509, the receiving terminal identifies whether decoding succeeds or fails by performing a syndrome check based on the bit estimation value. In this case, a syndrome check may be performed on all of the check nodes or predetermined some check nodes in the check nodes of the parity check matrix (for example, check nodes connected to a variable node of degree 1 may be excluded partially or entirely).

Generally, the LDPC code may detect an error through the syndrome check, but a CRC code, as an external code, may be additionally applied in order to support a higher level of error detection capability. In case that a CRC code is added, a receiver may perform a CRC check for the information word bit or code block obtained through LDPC decoding so as to finally determine whether an error has occurred.

Methods according to embodiments described in the claims or specification of the disclosure may be implemented in the form of hardware, software, or a combination of hardware and software.

In the case of implementation in software, a non-transitory computer-readable storage medium storing one or more programs (software modules) may be provided. One or more programs stored in a non-transitory computer-readable storage medium are configured to be executable by one or more processors in an electronic device. The one or more programs include instructions that cause an electronic device to execute methods according to embodiments described in the claims or specification of the disclosure.

The programs (software modules and software) may be included in a random access memory, a non-volatile memory including flash memory, a read only memory (ROM), an electrically erasable programmable read only memory (EEPROM), a magnetic disc storage device, a compact disc-ROM (CD-ROM), a digital versatile disc (DVD), another form of optical storage device, and a magnetic cassette. Alternatively, the programs may be stored in a memory configured as a combination of some or all of the memories or discs described above. In addition, multiple configuration memories may be included.

In addition, the program may be stored in an attachable storage device, which is accessible through a communication network such as the Internet, the Intranet, a local area network (LAN), a wide LAN (WLAN), a storage area network (SAN), or a communication network configured by combinations thereof. The storage device may access a device that performs embodiments through an external port. In addition, a separate storage device on the communication network may access a device that performs embodiments.

In the above-described detailed embodiments of the disclosure, an element included in the disclosure is expressed in the singular or the plural according to presented detailed embodiments. However, the singular form or plural form is selected appropriately to the presented situation for the convenience of description, and the disclosure is not limited by elements expressed in the singular or the plural. Therefore, either an element expressed in the plural may also include a single element or an element expressed in the singular may also include multiple elements.

The embodiments of the disclosure described and shown in the specification and the drawings have been presented to easily explain the technical contents of the disclosure and help understanding of the disclosure, and are not intended to limit the scope of the disclosure. Further, the above respective embodiments may be employed in combination, as necessary. For example, the embodiments of the disclosure may be partially combined to operate a base station and a terminal. As an example, embodiments 1 and 2 of the disclosure may be partially combined to operate a base station and a terminal. Further, although the above embodiments have been described by way of the FDD NR system, other variants based on the technical idea of the embodiments may be implemented in other systems such as the TDD NR and LTE systems.

Although the present disclosure has been described with various embodiments, various changes and modifications may be suggested to one skilled in the art. It is intended that the present disclosure encompass such changes and modifications as fall within the scope of the appended claims.

**Claims**

1. A transmission method performed by a first transmission and reception point, TRP, in a communication system supporting multiple TRPs, the transmission method comprising:

   determining a transport block;
   generating coded bits for the transport block based on a low density parity check (LDPC) code;
   applying rate matching to the coded bits based on a redundancy version, RV, pattern;
   generating a first modulation symbol by performing modulation on the coded bits to which rate matching is applied; and
   transmitting, to a terminal, the first modulated symbol on a physical downlink shared channel, PDSCH,
   wherein in case that the first TRP transmits, to the terminal, downlink control information, DCI, indicating a plurality of transmission configuration indicator, TCI,
   states associated to a plurality of PDSCHs, a starting value of a first RV pattern used for rate matching is indicated by the DCI,
   wherein in case that the DCI is transmitted by a second TRP, a starting value of a second RV pattern used for rate matching is determined according to the starting value of the first RV pattern indicated by the DCI, and
   wherein the first RV pattern is different from the second RV pattern applied to coded bits generated by the second TRP.

2. The transmission method of claim 1, wherein the first RV pattern is determined based on at least one of a code rate associated with a modulation and coding scheme, MCS, a base matrix of the LDPC code, a modulation order, or a size of the transport block.

3. The transmission method of claim 1,
   wherein the PDSCH carrying the first modulated symbol is transmitted in a slot different from a slot in which a PDSCH is transmitted by the second TRP.

4. The transmission method of claim 1,

   wherein in case that the DCI is transmitted by the second TRP, a starting value of the first RV pattern is indicated by the DCI as one of {0, 2, 3, 1}, and
   wherein in case that the starting value of the first RV pattern is 0, a value of the second RV pattern is determined as 3.

5. A reception method performed by a terminal in a communication system supporting multiple transmission and reception points, TRPs, the reception method comprising:

   receiving downlink control information, DCI, indicating a plurality of transmission configuration indicator, TCI, states;
   receiving, from a first TRP, a first physical downlink shared channel, PDSCH, associated with a first TCI state, based on the DCI;
   receiving, from a second TRP, a second PDSCH associated with a second TCI state, based on the DCI;
   identifying a starting value of a first redundancy version, RV, pattern applied to the first PDSCH, the starting value being indicated by the DCI;
   determining a starting value of a second RV pattern applied to the second PDSCH by using the starting value of the first RV pattern; and
performing demodulation for the first PSCH based on the first RV pattern and the second PDSCH based on the second RV pattern,
wherein the second RV pattern is different from the first RV pattern.

6. The reception method of claim 5, wherein the second RV pattern is determined based on at least one of a code rate associated with a modulation and coding scheme, MCS, a base matrix of a low density parity check, LDPC, code associated with the second TRP, or a modulation order.

7. The reception method of claim 5,

   wherein the first PDSCH and the second PDSCH are same, and
   wherein the first PDSCH and the second PDSCH are repeatedly received in different slots.

8. The reception method of claim 5,

   wherein a starting value of the first RV pattern is indicated by the DCI as one of {0, 2, 3, 1}, and
   wherein in case that the starting value of the first RV pattern is 0, a value of the second RV pattern is determined as 3.

9. A first transmission and reception point (TRP) in a communication system supporting multiple TRPs, the first TRP comprising:

   a transceiver; and
   a controller configured to:

   determine a transport block,
   generate coded bits for the transport block based on a low density parity check, LDPC, code,
   apply rate matching to the coded bits based on a redundancy version, RV, pattern,
   generate a first modulation symbol by performing modulation on the coded bits to which rate matching is applied, and
   transmit, via the transceiver to a terminal, the first modulated symbol on a physical downlink shared channel, PDSCH,
   wherein in case that the first TRP transmits, to the terminal, downlink control information, DCI, indicating a plurality of transmission configuration indicator, TCI, states associated to a plurality of PDSCHs, a starting value of a first RV pattern used for rate matching is indicated by the DCI,
   wherein in case that the DCI is transmitted by a second TRP, a starting value of a second RV pattern used for rate matching is determined according to the starting value of the first RV pattern indicated by the DCI, and
   wherein the first RV pattern is different from the second RV pattern applied to coded bits generated by the second TRP.

10. The first TRP of claim 9, wherein the first RV pattern is determined based on at least one of a code rate associated with a modulation and coding scheme, MCS, a base matrix of the LDPC code, a modulation order or a size of the transport block.

11. The first TRP of claim 10,

    wherein in case that the DCI is transmitted by the second TRP, a starting value of the first RV pattern is indicated by the DCI as one of {0, 2, 3, 1}, and
    wherein in case that the starting value of the first RV pattern is 0, a value of the second RV pattern is determined as 3.

12. A terminal in a communication system supporting multiple transmission and reception points, TRPs, the terminal comprising:

    a transceiver; and
    a controller configured to:

receive, via the transceiver, downlink control information, DCI, indicating a plurality of transmission configuration indicator, TCI, states,

receive, via the transceiver from a first TRP, a first physical downlink shared channel, PDSCH, associated with a first TCI state, based on the DCI,

receive, via the transceiver from a second TRP, a second PDSCH associated with a second TCI state, based on the DCI, and

identify a starting value of a first redundancy version, RV, pattern applied to the first PDSCH, the first RV pattern being indicated by the DCI, and

determine a starting value of a second RV pattern applied to the second PDSCH by using the starting value of the first RV pattern,

perform demodulation for the first PSCH based on the first RV pattern and the second PDSCH based on the second RV pattern,

wherein the second RV pattern is different from the first RV pattern.

13. The terminal of claim 12, wherein the second RV pattern is determined based on at least one of a code rate associated with a modulation and coding scheme, MCS, a base matrix of a low density parity check, LDPC, code associated with the second TRP, or a modulation order.

14. The terminal of claim 12,

wherein a starting value of the first RV pattern is indicated by the DCI as one of {0, 2, 3, 1}, and

wherein in case that the starting value of the first RV pattern is 0, a value of the second RV pattern is determined as 3.

15. The terminal of claim 12,

wherein the first PDSCH and the second PDSCH are same, and

wherein the first PDSCH and the second PDSCH are repeatedly received in different slots.

**Patentansprüche**

1. Übertragungsverfahren, das von einem ersten Übertragungs- und Empfangspunkt, TRP, in einem Kommunikationssystem ausgeführt wird, das mehrere TRPs unterstützt, wobei das Übertragungsverfahren Folgendes umfasst:

Bestimmen eines Transportblocks;

Erzeugen codierter Bits für den Transportblock basierend auf einem Low-Density-Parity-Check(LDPC)-Code;

Anwenden einer Ratenanpassung auf die codierten Bits basierend auf einem Redundanzversions(RV)-Muster;

Erzeugen eines ersten Modulationssymbols durch Ausführen einer Modulation an den codierten Bits, auf die eine Ratenanpassung angewendet wird; und

Übertragen des ersten modulierten Symbols auf einem gemeinsam genutzten physikalischen Downlink-Kanal, PDSCH, an ein Endgerät,

wobei, falls der erste TRP an das Endgerät Downlink-Steuerungsinformationen, DCI, überträgt, die eine Vielzahl von Übertragungskonfigurationsindikator(TCI)-Zuständen anzeigen, die mit einer Vielzahl von PDSCHs assoziiert sind, ein Startwert eines ersten RV-Musters, das für die Ratenanpassung verwendet wird, von den DCI angezeigt wird,

wobei, falls die DCI von einem zweiten TRP übertragen werden, ein Startwert eines zweiten RV-Musters, das für die Ratenanpassung verwendet wird, gemäß dem Startwert des ersten RV-Musters bestimmt wird, der von den DCI angezeigt wird, und

wobei sich das erste RV-Muster von dem zweiten RV-Muster unterscheidet, das auf codierte Bits angewendet wird, die von dem zweiten TRP erzeugt werden.

2. Übertragungsverfahren nach Anspruch 1, wobei das erste RV-Muster basierend auf einer Coderate, die mit einem Modulations- und Codierungsschema, MCS, assoziiert ist, einer Basismatrix des LDPC-Codes, einer Modulationsreihenfolge und/oder einer Größe des Transportblocks bestimmt wird.

3. Übertragungsverfahren nach Anspruch 1,
wobei der PDSCH, der das erste modulierte Symbol trägt, in einem Slot übertragen wird, der sich von einem Slot unterscheidet, in dem ein PDSCH von dem zweiten TRP übertragen wird.

4. Übertragungsverfahren nach Anspruch 1,

wobei, falls die DCI von dem zweiten TRP übertragen werden, ein Startwert des ersten RV-Musters von den DCI als einer von {0, 2, 3, 1} angezeigt wird, und
wobei, falls der Startwert des ersten RV-Musters 0 ist, ein Wert des zweiten RV-Musters als 3 bestimmt wird.

5. Empfangsverfahren, das von einem Endgerät in einem Kommunikationssystem ausgeführt wird, das mehrere Übertragungs- und Empfangspunkte, TRPs, unterstützt, wobei das Empfangsverfahren Folgendes umfasst:

Empfangen von Downlink-Steuerungsinformationen, DCI, die eine Vielzahl von Übertragungskonfigurationsindikator(TCI)-Zuständen anzeigen;
Empfangen eines ersten gemeinsam genutzten physikalischen Downlink-Kanals, PDSCH, der mit einem ersten TCI-Zustand assoziiert ist, basierend auf den DCI von einem ersten TRP;
Empfangen eines zweiten PDSCH, der mit einem zweiten TCI-Zustand assoziiert ist, basierend auf den DCI von einem zweiten TRP;
Identifizieren eines Startwerts eines ersten Redundanzversions(RV)-Musters, das auf den ersten PDSCH angewendet wird, wobei der Startwert von den DCI angezeigt wird;
Bestimmen eines Startwerts eines zweiten RV-Musters, das auf den zweiten PDSCH angewendet wird, unter Verwenden des Startwerts des ersten RV-Musters; und
Ausführen einer Demodulation für den ersten PDSCH basierend auf dem ersten RV-Muster und für den zweiten PDSCH basierend auf dem zweiten RV-Muster,
wobei sich das zweite RV-Muster von dem ersten RV-Muster unterscheidet.

6. Empfangsverfahren nach Anspruch 5, wobei das zweite RV-Muster basierend auf einer Coderate, die mit einem Modulations- und Codierungsschema, MCS, assoziiert ist, einer Basismatrix eines Low-Density-Parity-Check(LDPC)-Codes, der mit dem zweiten TRP assoziiert ist, und/oder einer Modulationsreihenfolge bestimmt wird.

7. Empfangsverfahren nach Anspruch 5,

wobei der erste PDSCH und der zweite PDSCH gleich sind, und
wobei der erste PDSCH und der zweite PDSCH wiederholt in unterschiedlichen Slots empfangen werden.

8. Empfangsverfahren nach Anspruch 5,

wobei ein Startwert des ersten RV-Musters von den DCI als einer von {0, 2, 3, 1} angezeigt wird, und
wobei, falls der Startwert des ersten RV-Musters 0 ist, ein Wert des zweiten RV-Musters als 3 bestimmt wird.

9. Erster Übertragungs- und Empfangspunkt (TRP) in einem Kommunikationssystem, das mehrere TRPs unterstützt, wobei der erste TRP Folgendes umfasst:

einen Transceiver; und
eine Steuerung, die zu Folgendem konfiguriert ist:

Bestimmen eines Transportblocks,
Erzeugen codierter Bits für den Transportblock basierend auf einem Low-Density-Parity-Check(LDPC)-Code,
Anwenden einer Ratenanpassung auf die codierten Bits basierend auf einem Redundanzversions(RV)-Muster,
Erzeugen eines ersten Modulationssymbols durch Ausführen einer Modulation an den codierten Bits, auf die eine Ratenanpassung angewendet wird, und
Übertragen des ersten modulierten Symbols auf einem gemeinsam genutzten physikalischen Downlink-Kanal, PDSCH, über den Transceiver an ein Endgerät,
wobei, falls der erste TRP an das Endgerät Downlink-Steuerungsinformationen, DCI, überträgt, die eine Vielzahl von Übertragungskonfigurationsindikator(TCI)-Zuständen anzeigen, die mit einer Vielzahl von PDSCHs assoziiert sind, ein Startwert eines ersten RV-Musters, das für die Ratenanpassung verwendet wird, von den DCI angezeigt wird,

wobei, falls die DCI von einem zweiten TRP übertragen werden, ein Startwert eines zweiten RV-Musters, das für die Ratenanpassung verwendet wird, gemäß dem Startwert des ersten RV-Musters bestimmt wird, der von den DCI angezeigt wird, und

wobei sich das erste RV-Muster von dem zweiten RV-Muster unterscheidet, das auf codierte Bits angewendet wird, die von dem zweiten TRP erzeugt werden.

10. Erster TRP nach Anspruch 9, wobei das erste RV-Muster basierend auf einer Coderate, die mit einem Modulations- und Codierungsschema, MCS, assoziiert ist, einer Basismatrix des LDPC-Codes, einer Modulationsreihenfolge und/oder einer Größe des Transportblocks bestimmt wird.

11. Erster TRP nach Anspruch 10,

wobei, falls die DCI von dem zweiten TRP übertragen werden, ein Startwert des ersten RV-Musters von den DCI als einer von {0, 2, 3, 1} angezeigt wird, und

wobei, falls der Startwert des ersten RV-Musters 0 ist, ein Wert des zweiten RV-Musters als 3 bestimmt wird.

12. Endgerät in einem Kommunikationssystem, das mehrere Übertragungs- und Empfangspunkte, TRPs, unterstützt, wobei das Endgerät Folgendes umfasst:

einen Transceiver; und
eine Steuerung, die zu Folgendem konfiguriert ist:

Empfangen von Downlink-Steuerungsinformationen, DCI, die eine Vielzahl von Übertragungskonfigurationsindikator(TCI)-Zuständen anzeigen, über den Transceiver,
Empfangen eines ersten gemeinsam genutzten physikalischen Downlink-Kanals, PDSCH, der mit einem ersten TCI-Zustand assoziiert ist, basierend auf den DCI über den Transceiver von einem ersten TRP,
Empfangen eines zweiten PDSCH, der mit einem zweiten TCI-Zustand assoziiert ist, basierend auf den DCI über den Transceiver von einem zweiten TRP, und
Identifizieren eines Startwerts eines ersten Redundanzversions(RV)-Musters, das auf den ersten PDSCH angewendet wird, wobei das erste RV-Muster von den DCI angezeigt wird, und
Bestimmen eines Startwerts eines zweiten RV-Musters, das auf den zweiten PDSCH angewendet wird, unter Verwenden des Startwerts des ersten RV-Musters,
Ausführen einer Demodulation für den ersten PDSCH basierend auf dem ersten RV-Muster und für den zweiten PDSCH basierend auf dem zweiten RV-Muster,
wobei sich das zweite RV-Muster von dem ersten RV-Muster unterscheidet.

13. Endgerät nach Anspruch 12, wobei das zweite RV-Muster basierend auf einer Coderate, die mit einem Modulations- und Codierungsschema, MCS, assoziiert ist, einer Basismatrix eines Low-Density-Parity-Check(LDPC)-Codes, der mit dem zweiten TRP assoziiert ist, und/oder einer Modulationsreihenfolge bestimmt wird.

14. Endgerät nach Anspruch 12,

wobei ein Startwert des ersten RV-Musters von den DCI als einer von {0, 2, 3, 1} angezeigt wird, und
wobei, falls der Startwert des ersten RV-Musters 0 ist, ein Wert des zweiten RV-Musters als 3 bestimmt wird.

15. Endgerät nach Anspruch 12,

wobei der erste PDSCH und der zweite PDSCH gleich sind, und
wobei der erste PDSCH und der zweite PDSCH wiederholt in unterschiedlichen Slots empfangen werden.

## Revendications

1. Procédé de transmission exécuté par un premier point de transmission et de réception, TR-P, dans un système de communication supportant de multiples TRP, le procédé de transmission comprenant :

déterminer un bloc de transport ;
générer des bits codifiés pour le bloc de transport sur la base d'un code de contrôle de parité à faible densité

(LDPC) ;

appliquer une adaptation de débit aux bits codifiés sur la base d'un motif de version de redondance, RV ;

générer un premier symbole de modulation en exécutant la modulation sur les bits codifiés auxquels une adaptation de débit est appliquée ; et

transmettre, à un terminal, le premier symbole modulé sur un canal partagé de liaison descendante physique, PDSCH,

où dans le cas où le premier TRP transmet, au terminal, des informations de commande de liaison descendante, DCI, indiquant une pluralité d'états d'indicateur de configuration de transmission, TCI, associés à une pluralité de PDSCH, une valeur de départ d'un premier motif RV utilisé pour l'adaptation de débit est indiquée par les DCI,

où dans le cas où les DCI sont transmises par un deuxième TRP, une valeur de départ d'un deuxième motif RV utilisé pour l'adaptation de débit est déterminée selon la valeur de départ du premier motif RV indiquée par les DCI, et

où le premier motif RV est différent du deuxième motif RV appliqué aux bits codifiés générés par le deuxième TRP.

2. Procédé de transmission selon la revendication 1, où le premier motif RV est déterminé sur la base d'au moins l'un parmi un débit de code associé à un schéma de modulation et de codage, MCS, une matrice de base du code LDPC, un ordre de modulation, ou une taille du bloc de transport.

3. Procédé de transmission selon la revendication 1,
où le PDSCH portant le premier symbole modulé est transmis dans un créneau différent d'un créneau dans lequel un PDSCH est transmis par le deuxième TRP.

4. Procédé de transmission selon la revendication 1,

où dans le cas où les DCI sont transmises par le deuxième TRP, une valeur de départ du premier motif RV est indiquée par les DCI comme l'une parmi {0, 2, 3, 1}, et

où dans le cas où la valeur de départ du premier motif RV est 0, une valeur du deuxième motif RV est déterminée comme 3.

5. Procédé de réception exécuté par un terminal dans un système de communication supportant de multiples points de transmission et de réception, TRP, le procédé de réception comprenant :

recevoir des informations de commande de liaison descendante, DCI, indiquant une pluralité d'états d'indicateur de configuration de transmission, TCI ;

recevoir, d'un premier TRP, un premier canal partagé de liaison descendante physique, PDSCH, associé à un premier état TCI, sur la base des DCI ;

recevoir, d'un deuxième TRP, un deuxième PDSCH associé à un deuxième état TCI, sur la base des DCI ;

identifier une valeur de départ d'un premier motif de version de redondance, RV, appliqué au premier PDSCH, la valeur de départ étant indiquée par les DCI ;

déterminer une valeur de départ d'un deuxième motif RV appliqué au deuxième PDSCH en utilisant la valeur de départ du premier motif RV ; et

exécuter la démodulation pour le premier PDSCH sur la base du premier motif RV et pour le deuxième PDSCH sur la base du deuxième motif RV,

où le deuxième motif RV est différent du premier motif RV.

6. Procédé de réception selon la revendication 5, où le deuxième motif RV est déterminé sur la base d'au moins l'un parmi un débit de code associé à un schéma de modulation et de codage, MCS, une matrice de base d'un contrôle de parité à faible densité, LDPC, associé au deuxième TRP, ou un ordre de modulation.

7. Procédé de réception selon la revendication 5,

où le premier PDSCH et le deuxième PDSCH sont identiques, et

où le premier PDSCH et le deuxième PDSCH sont reçus de manière répétée dans des créneaux différents.

8. Procédé de réception selon la revendication 5,

où une valeur de départ du premier motif RV est indiquée par les DCI comme l'une parmi {0, 2, 3, 1}, et

où dans le cas où la valeur de départ du premier motif RV est 0, une valeur du deuxième motif RV est déterminée comme 3.

9. Premier point de transmission et de réception (TRP) dans un système de communication supportant de multiples TR-P, le premier TRP comprenant :

un émetteur-récepteur ; et
un contrôleur configuré pour :

déterminer un bloc de transport,
générer des bits codifiés pour le bloc de transport sur la base d'un code de contrôle de parité à faible densité, LDPC,
appliquer une adaptation de débit aux bits codifiés sur la base d'un motif de version de redondance, RV,
générer un premier symbole de modulation en exécutant la modulation sur les bits codifiés auxquels une adaptation de débit est appliquée, et
transmettre, via l'émetteur-récepteur à un terminal, le premier symbole modulé sur un canal partagé de liaison descendante physique, PDSCH,
où dans le cas où le premier TRP transmet, au terminal, des informations de commande de liaison descendante, DCI , indiquant une pluralité d'états d'indicateur de configuration de transmission, TCI, associés à une pluralité de PDSCH, une valeur de départ d'un premier motif RV utilisé pour l'adaptation de débit est indiquée par les DCI,
où dans le cas où les DCI sont transmises par un deuxième TRP, une valeur de départ d'un deuxième motif RV utilisé pour l'adaptation de débit est déterminée selon la valeur de départ du premier motif RV indiquée par les DCI, et
où le premier motif RV est différent du deuxième motif RV appliqué aux bits codifiés générés par le deuxième TRP.

10. Premier TRP selon la revendication 9, où le premier motif RV est déterminé sur la base d'au moins l'un parmi un débit de code associé à un schéma de modulation et de codage, MCS, une matrice de base du code LDPC, un ordre de modulation ou une taille du bloc de transport.

11. Premier TRP selon la revendication 10,

où dans le cas où les DCI sont transmises par le deuxième TRP, une valeur de départ du premier motif RV est indiquée par les DCI comme l'une parmi {0, 2, 3, 1}, et
où dans le cas où la valeur de départ du premier motif RV est 0, une valeur du deuxième motif RV est déterminée comme 3.

12. Terminal dans un système de communication supportant de multiples points de transmission et de réception, TRP, le terminal comprenant :

un émetteur-récepteur ; et
un contrôleur configuré pour :

recevoir, via l'émetteur-récepteur, des information de commande de liaison descendante, DCI, indiquant une pluralité d'états d'indicateur de configuration de transmission, TCI,
recevoir, via l'émetteur-récepteur d'un premier TRP, un premier canal partagé de liaison descendante physique, PDSCH, associé à un premier état TCI, sur la base des DCI,
recevoir, via l'émetteur-récepteur d'un deuxième TRP, un deuxième PDSCH associé à un deuxième état TCI, sur la base des DCI, et
identifier une valeur de départ d'un premier motif de version de redondance, RV, appliqué au premier PDSCH, la valeur de départ étant indiquée par les DCI, et
déterminer une valeur de départ d'un deuxième motif RV appliqué au deuxième PDSCH en utilisant la valeur de départ du premier motif RV,
exécuter la démodulation pour le premier PDSCH sur la base du premier motif RV et pour le deuxième PDSCH sur la base du deuxième motif RV,
où le deuxième motif RV est différent du premier motif RV.

13. Terminal selon la revendication 12, où le deuxième motif RV est déterminé sur la base d'au moins l'un parmi un débit de code associé à un schéma de modulation et de codage, MCS, une matrice de base d'un code de contrôle de parité à faible densité, LDPC, associé au deuxième TRP, ou un ordre de modulation.

**14.** Terminal selon la revendication 12,

où une valeur de départ du premier motif RV est indiquée par les DCI comme l'une parmi {0, 2, 3, 1}, et
où dans le cas où la valeur de départ du premier motif RV est 0, une valeur du deuxième motif RV est déterminée comme 3.

**15.** Terminal selon la revendication 12,

où le premier PDSCH et le deuxième PDSCH sont identiques, et
où le premier PDSCH et le deuxième PDSCH sont reçus de manière répétée dans des créneaux différents.

[Fig. 1]

One subframe 1-10

$N_{symb}^{subframe,\mu}$ OFDM symbols

1 OFDM symbols (1-02)

1 symbols 1-03

$k = N_{RB,x}^{max,\mu} N_{sc}^{RB} - 1$

Resource block $N_{sc}^{RB}$ subcarriers 1-04

$N_{RB}^{\mu} N_{sc}^{RB}$ subcarriers

Resource element $(k, 1)$ 1-01

Frequency

Time

$\bar{l} = 0$

$\bar{l} = 14 \cdot 2^{\mu} - 1$

$k = 0$

[Fig. 2]

EP 3 954 072 B1

[Fig. 3]

[Fig. 4]

[Fig. 5]

Duration
5-04

Frequency
resources 5-03

UE bandwidth
part 5-10

Slot 5-20

frequency

time

Control resource set#1 5-01

Control resource set#2 5-02

EP 3 954 072 B1

[Fig. 6]

6-00

6-15

RA type 0

| Bitmap |
|---|

6-05

6-20

6-25

RA type 1

| Starting VRB | Length |
|---|---|

6-10

6-30

6-35

Both RA type 0 & 1

| 1 bit for RA type indication | Max{payload for RA type 0, payload for RA type 1} |
|---|---|

[Fig. 7]

**S**
**7-00**

L **7-05**

| 0 | 1 | 2 | 3 | 4 | 5 | 6 | 7 | 8 | 9 | 10 | 11 | 12 | 13 |
|---|---|---|---|---|---|---|---|---|---|----|----|----|----|

OFDM symbol

$$\text{Slot}\left\lfloor n \cdot \frac{2^{\mu_{PDSCH}}}{2^{\mu_{PDCCH}}}\right\rfloor + K_0 \quad \textbf{7-10}$$

[Fig. 8]

EP 3 954 072 B1

**8-00**

$\mu_{PDCCH} = 1$ | PDCCH | Slot n | Slot n + 1 | ... | $t$

$\mu_{PDCCH} = 1$ | ... | PDSCH | Slot n + K$_0$ | $t$

**8-05**

$\mu_{PDCCH} = 1$ | PDCCH | Slot n | Slot n + 1 | ... | $t$

$\mu_{PDCCH} = 2$ | PDSCH | $t$

$$\text{Slot}\left\lfloor n \cdot \frac{2^{\mu_{PDSCH}}}{2^{\mu_{PDCCH}}} \right\rfloor$$

$$\text{Slot}\left\lfloor n \cdot \frac{2^{\mu_{PDSCH}}}{2^{\mu_{PDCCH}}} \right\rfloor + K_0$$

[Fig. 9]

```
        ┌──────────────────┐
        │      Start        │
        └──────────────────┘
                  │
                  ▼
910 ──┌──────────────────────┐
      │    Determine TBS      │
      └──────────────────────┘
                  │
                  ▼
920 ──◇ TBS > max CBS ? ◇───── Yes ──────────┐
                  │                            ▼     930
                  No                  ┌──────────────────────┐
                  │                   │    Segmentation       │
                  ▼                   └──────────────────────┘
940 ──┌──────────────────────┐                │
      │  Determine block size (Z) │◄───────────┘
      └──────────────────────┘
                  │
                  ▼
950 ──┌──────────────────────────┐
      │ Determine LDPC exponent matrix │
      └──────────────────────────┘
                  │
                  ▼
960 ──┌──────────────────────┐
      │     LDPC coding       │
      └──────────────────────┘
                  │
                  ▼
        ┌──────────────────┐
        │       End         │
        └──────────────────┘
```

[Fig. 10]

```
        ┌──────────────────┐
        │      Start        │
        └──────────────────┘
                  │
                  ▼
1010 ─┐ ┌──────────────────┐
      └─│   Determine TBS   │
        └──────────────────┘
                  │
                  ▼
1020 ─┐      ╱◇◇◇◇◇◇◇╲              Yes
      └──◇  TBS > max CBS ?  ◇──────────────┐
            ╲◇◇◇◇◇◇◇╱                       │
                  │ No                        │   1030
                  │                           ▼
                  │              ┌──────────────────────────┐
                  │              │ Determine segmented CBS size │
                  │              └──────────────────────────┘
                  │                           │
                  ▼                           │
1040 ─┐ ┌──────────────────┐                 │
      └─│ Determine block size (Z) │◄─────────┘
        └──────────────────┘
                  │
                  ▼
1050 ─┐ ┌──────────────────────────┐
      └─│ Determine LDPC exponent matrix │
        └──────────────────────────┘
                  │
                  ▼
1060 ─┐ ┌──────────────────┐
      └─│   LDPC decoding   │
        └──────────────────┘
                  │
                  ▼
        ┌──────────────────┐
        │       End         │
        └──────────────────┘
```

[Fig. 11]

[Fig. 12]

**1200**

[Fig. 13]

1300

RV = 0

RV = 3

RV = 1

circular
buffer

RV = 2

[Fig. 14]

[1405] K times repetition on K consecutive slots (K is set by higher layer)

DCI

1400

allocation

1st repetition (n = 1)  1410

2nd repetition (n = 2)  1415

[Fig. 15]

[Fig. 16]

[Fig. 17]

| | |
|---|---|
| Control Information for TRP #0 | DCI #0 |
| Control Information for TRP #1 | sDCI #0 |
| . . . | . . . |
| Control Information for TRP #[N-1] | sDCI #[N-2] |

Case #2 [1705]

| | |
|---|---|
| Control Information for TRP #0 | |
| Control Information for TRP #1 | Long DCI |
| . . . | . . . |
| Control Information for TRP #[N-1] | |

Case #4 [1715]

| | |
|---|---|
| Control Information for TRP #0 | DCI #0 |
| Control Information for TRP #1 | DCI #1 |
| . . . | . . . |
| Control Information for TRP #[N-1] | DCI #[N-1] |

Case #1 [1700]

| | |
|---|---|
| Control Information for TRP #0 | DCI |
| Control Information for TRP #1 | sDCI |
| . . . | |
| Control Information for TRP #[N-1] | |

Case #3 [1710]

[Fig. 18]

[Fig. 19]

(19-05)

(19-00)

Terminal processor

Terminal receiver

(19-10)

Terminal transmitter

[Fig. 20]

(20-05)

(20-00)

base station processor

Base station receiver

(20-10)

Base station transmitter

[Fig. 21]

Transmission device — 2100

2110 Segmentation unit → 2120 Zero padding unit → 2130 LDPC encoder → 2140 Rate matching unit → 2150 Modulator

Rate matching unit — 2140

2141 Interleaver → 2142 Puncturing/repetition unit/zero removal

[Fig. 22]

EP 3 954 072 B1

2200

**Reception device**

2210
**Demodulator**

2220
**Rate de-matching unit**

2230
**LDPC decoder**

2240
**Zero removal unit**

2250
**De-segmentation unit**

2220

**Rate de-matching unit**

2222
**LLR insertion unit**

2223
**LLR combiner**

2224
**De-interleaver**

[Fig. 23a]

[Fig. 23b]

[Fig. 24]

2400

[Fig. 25]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **FRANK R. KSCHISCHANG ; BRENDAN J. FREY ; HANS-ANDREA LOELIGER.** Factor Graphs and the Sum-Product Algorithm. *IEEE TRANSACTIONS ON INFORMATION THEORY,* February 2001, vol. 47 (2), 498-519